# EUROPEAN PATENT APPLICATION

(11) **EP 4 738 257 A1**
(43) Date of publication of application: **06.05.2026**
(21) Application number: 24831586.3
(22) Date of filing: 05.06.2024
(51) Int. Cl.: G06T 7/70, G01B 11/24, H01L 21/683

(54) **SUBSTRATE PROCESSING DEVICE AND INFORMATION PROCESSING METHOD FOR SUBSTRATE PROCESSING DEVICE**

(30) Priority: 27.06.2023 JP 2023105016
(71) Applicant: SCREEN Holdings Co., Ltd., Kyoto-shi, Kyoto 602-8585 (JP)
(72) Inventor: SHIMIZU, Shinji, Kyoto-shi, Kyoto 602-8585 (JP)
(74) Representative: Kilian Kilian & Partner mbB
(86) International application number: PCT/JP2024/020453
(87) International publication number: WO 2025/004716

(57) **Abstract**

In order to efficiently recognize a posture of a component of a substrate processing apparatus, reference shape information regarding a two-dimensional shape of a 3D model is acquired for each of a plurality of first virtual camera positions in a plurality of virtual surfaces along a virtual spherical surface surrounding the 3D model of a target component based on design information of the target component. For each of the first virtual camera positions, a matching degree between real shape information related to a two-dimensional shape of an object in a real image and the reference shape information is calculated. A virtual camera position with high matching degree having a highest matching degree is detected among the plurality of first virtual camera positions. A virtual surface in which the virtual camera position with high matching degree is set is divided to generate a plurality of virtual divided surfaces. Based on the design information of the target component, the reference shape information related to the two-dimensional shape of the 3D model is generated for each of a plurality of second virtual camera positions on the plurality of virtual divided surfaces. For each of the second virtual camera positions, a numerical value indicating a matching degree between the real shape information and the reference shape information is calculated.

## Description

### TECHNICAL FIELD

The present invention relates to a technique for recognizing a posture of a component in a substrate processing apparatus that processes a substrate. Substrates to be processed in the substrate processing apparatus include, for example, a semiconductor substrate, a substrate for a flat panel display (FPD) such as a liquid crystal display apparatus or an organic electroluminescence (EL) display apparatus, a glass substrate for a photomask, a substrate for an optical disk, a substrate for a magnetic disk, or a substrate for a solar cell.

### BACKGROUND ART

There is a substrate processing apparatus including a processing chamber, a substrate holding unit, a nozzle, a camera, an image processing unit, and a monitoring unit (see, for example, Patent Document 1).

In this substrate processing apparatus, the substrate holding unit, the nozzle, and the camera are arranged in the processing chamber. The substrate holding unit holds a substrate in a horizontal posture. The substrate holding unit rotates the substrate in a horizontal plane. The nozzle moves between a standby position deviated to a side of the substrate and a discharge position above the substrate by turning of a drive arm to which the nozzle is fixed. The nozzle is arranged at the standby position when the substrate is attached to and detached from the substrate holding unit, and is arranged at the discharge position when a processing liquid is discharged from the nozzle toward the substrate. The camera is attached to a predetermined position in the processing chamber and captures an image of a predetermined region including the nozzle moved to the discharge position. The image processing unit acquires second nozzle position information indicating a position of the nozzle based on the image from the camera and outputs the second nozzle position information to the monitoring unit. The monitoring unit determines whether or not there is an abnormality in the position of the nozzle based on correspondence between first nozzle position information as information directly or indirectly indicating the arrangement position of the nozzle from a control unit and the second nozzle position information from the image processing unit.

### PRIOR ART DOCUMENT

### PATENT DOCUMENT

Patent Document 1: WO 2019/146456 A

### SUMMARY

### PROBLEM TO BE SOLVED BY THE INVENTION

By the way, with respect to a substrate processing apparatus, there is room for improvement in terms of efficiently recognizing a posture of a component.

### MEANS TO SOLVE THE PROBLEM

A substrate processing apparatus according to a first aspect is a substrate processing apparatus that processes a substrate, the substrate processing apparatus including: a storage unit that stores three-dimensional design information regarding a target component; an imaging unit that obtains a real image capturing the target component by imaging; and a search processing unit that, based on reference shape information regarding a two-dimensional shape of a three-dimensional model in each of a plurality of virtual images that can be obtained by imaging the three-dimensional model of the target component from a plurality of virtual camera positions, and real shape information regarding a two-dimensional shape of an object in the real image, the reference shape information being generated based on the three-dimensional design information, searches for a virtual camera position having a highest matching degree between the reference shape information and the real shape information among the plurality of virtual camera positions, in which the search processing unit includes: a first shape information acquisition unit that acquires the reference shape information generated for each of a plurality of first virtual camera positions assuming a case where the three-dimensional model is imaged from each of the plurality of first virtual camera positions that is a plurality of virtual camera positions set by virtually setting a surface aggregation including a plurality of virtual surfaces located along a virtual spherical surface surrounding the three-dimensional model centered around a reference point of the three-dimensional model and virtually setting one virtual camera position for each of the plurality of virtual surfaces based on the three-dimensional design information; a first calculation unit that calculates a numerical value indicating a matching degree between the real shape information and the reference shape information for each of the plurality of first virtual camera positions; a first detection unit that detects a virtual camera position with high matching degree that is a first virtual camera position having a highest matching degree between the real shape information and the reference shape information among the plurality of first virtual camera positions based on a calculation result by the first calculation unit; a divided surface generation unit that generates a plurality of virtual divided surfaces by dividing a virtual surface with high matching degree that is a virtual surface in which the virtual camera position with high matching degree is virtually set among the plurality of virtual surfaces; a second shape information generation unit that generates the reference shape information for each of a plurality of second virtual camera positions assuming a case where the three-dimensional model is imaged from each of the plurality of second virtual camera positions that is a plurality of virtual camera positions set by virtually setting one virtual camera position for each of the plurality of virtual divided surfaces based on the three-dimensional design information; and a second calculation unit that calculates a numerical value indicating a matching degree between the real shape information and the reference shape information for each of the plurality of second virtual camera positions.

A substrate processing apparatus according to a second aspect is the substrate processing apparatus according to the first aspect, in which assuming a case where the three-dimensional model is imaged from each of M1×T1 first virtual camera positions that are M1×T1 virtual camera positions set by virtually setting T1 (T1 is a natural number equal to or greater than 2) surface aggregations having mutually different distances from the reference point and virtually setting one virtual camera position for each of M1 (M1 is a natural number equal to or greater than 2) virtual surfaces in each of the T1 surface aggregations based on the three-dimensional design information, the first shape information acquisition unit acquires the reference shape information generated for each of the M1×T1 first virtual camera positions, the first calculation unit calculates a numerical value indicating a matching degree between the real shape information and the reference shape information for each of the M1×T1 first virtual camera positions, the first detection unit detects the virtual camera position with high matching degree which is a virtual camera position having a highest matching degree between the real shape information and the reference shape information among the M1×T1 first virtual camera positions based on a calculation result by the first calculation unit, the divided surface generation unit divides, according to a same rule, each of T2 (T2 is a natural number equal to or greater than 2) virtual surfaces including the virtual surface with high matching degree, intersecting a line passing through the reference point and the virtual camera position with high matching degree on a side of the virtual camera position with high matching degree with respect to the reference point and having mutually different distances from the reference point among the M1 virtual surfaces in each of the T1 surface aggregations to generate M2 (M2 is a natural number equal to or greater than 2) virtual divided surfaces for each of the T2 virtual surfaces, thereby generating M2×T2 virtual divided surfaces, the second shape information generation unit generates, assuming a case where the three-dimensional model is imaged from each of M2×T2 second virtual camera positions that are M2×T2 virtual camera positions set by virtually setting one virtual camera position for each of the M2×T2 virtual divided surfaces, the reference shape information for each of M2×T2 second virtual camera positions based on the three-dimensional design information, and the second calculation unit calculates a numerical value indicating a matching degree between the real shape information and the reference shape information for each of the M2×T2 second virtual camera positions.

A substrate processing apparatus according to a third aspect is the substrate processing apparatus according to the second aspect, in which the search processing unit includes a second detection unit that detects a virtual camera position having a highest matching degree between the real shape information and the reference shape information among the virtual camera position with high matching degree and the M2×T2 second virtual camera positions.

A substrate processing apparatus according to a fourth aspect is the substrate processing apparatus according to the third aspect, in which the search processing unit executes one or more times of n-th unit processing (n is a natural number equal to or greater than 2) after executing first unit processing for the target component, the search processing unit sequentially performs first A processing, first B processing, first C processing, and first D processing in the first unit processing, the first A processing is processing in which the divided surface generation unit divides, according to a same rule, each of first T3 virtual divided surfaces which are a plurality of virtual divided surfaces generated by dividing each of the T2 virtual surfaces and which are T3 (T3 is a natural number equal to or greater than 2) virtual divided surfaces including a virtual divided surface including a first reference virtual camera position which is a virtual camera position detected first by the second detection unit, intersecting a line passing through the reference point and the first reference virtual camera position on a side of the first reference virtual camera position with respect to the reference point and having mutually different distances from the reference point to generate first M3 virtual divided surfaces which are M3 (M3 is a natural number equal to or greater than 2) virtual divided surfaces for each of the first T3 virtual divided surfaces, thereby generating first M3×T3 virtual divided surfaces which are M3×T3 virtual divided surfaces, the first B processing is processing in which the second shape information generation unit generates, assuming a case where the three-dimensional model is imaged from each of first M3×T3 third virtual camera positions that are M3×T3 virtual camera positions set by virtually setting one virtual camera position for each of the first M3×T3 virtual divided surfaces, the reference shape information for each of the first M3×T3 third virtual camera positions based on the three-dimensional design information, the first C processing is processing in which the second calculation unit calculates a numerical value indicating a matching degree between the real shape information and the reference shape information for each of the first M3×T3 third virtual camera positions, the first D processing is processing in which the second detection unit detects a second reference virtual camera position that is a virtual camera position having a highest matching degree between the real shape information and the reference shape information among the first reference virtual camera position and the first M3×T3 third virtual camera positions, the search processing unit sequentially performs n-th A processing, n-th B processing, n-th C processing, and n-th D processing in each of the one or more times of n-th unit processing, the n-th A processing is processing in which the divided surface generation unit divides, according to a same rule, each of n-th T3 virtual divided surfaces which are a plurality of virtual divided surfaces generated by dividing each of (n-1)-th T3 virtual divided surfaces and which are T3 virtual divided surfaces including a virtual divided surface including an n-th reference virtual camera position that is a virtual camera position detected n-th by the second detection unit, intersecting a line passing through the reference point and the n-th reference virtual camera position on a side of the n-th reference virtual camera position with respect to the reference point, and having mutually different distances from the reference point to generate n-th M3 virtual divided surfaces that are M3 virtual divided surfaces for each of the n-th T3 virtual divided surfaces, thereby generating n-th M3×T3 virtual divided surfaces that are M3×T3 virtual divided surfaces, the n-th B processing is processing in which the second shape information generation unit generates, assuming a case where the three-dimensional model is imaged from each of n-th M3×T3 third virtual camera positions that are M3×T3 virtual camera positions set by virtually setting one virtual camera position for each of the n-th M3×T3 virtual divided surfaces, the reference shape information for each of the n-th M3×T3 virtual camera positions based on the three-dimensional design information, the n-th C processing is processing in which the second calculation unit calculates a numerical value indicating a matching degree between the real shape information and the reference shape information for each of the n-th M3×T3 third virtual camera positions, and the n-th D processing is processing in which the second detection unit detects a virtual camera position having a highest matching degree between the real shape information and the reference shape information among the n-th reference virtual camera position and the n-th M3×T3 third virtual camera positions.

A substrate processing apparatus according to a fifth aspect is the substrate processing apparatus according to the fourth aspect, in which the search processing unit ends execution of the one or more times of n-th unit processing in response to one reference virtual camera position among from the first reference virtual camera position to the n-th reference virtual camera position being continuously detected by the second detection unit as a virtual camera position having a highest matching degree between the real shape information and the reference shape information a first predetermined number of times set in advance.

A substrate processing apparatus according to a sixth aspect is the substrate processing apparatus according to the fourth aspect, in which the search processing unit ends execution of the one or more times of n-th unit processing in response to the n-th unit processing in the one or more times of n-th unit processing being executed a second predetermined number of times set in advance.

A substrate processing apparatus according to a seventh aspect is the substrate processing apparatus according to any one of the fourth to sixth aspects, further including an abnormality detection unit that detects an abnormality of the target component by comparing reality information regarding a posture of the target component recognized based on a virtual camera position having a highest matching degree between the real shape information and the reference shape information detected (n+1)-th by the second detection unit in the last n-th D processing in the one or more times of n-th unit processing, with normal information related to a posture of the target component based on the three-dimensional design information in a case where a state of the target component is normal.

A substrate processing apparatus according to an eighth aspect is the substrate processing apparatus according to any one of the second to seventh aspects, in which the same rule includes a rule of dividing a division target surface to be divided into a plurality of surfaces by a plurality of line segments respectively connecting a center point of the division target surface and all vertices of the division target surface.

A substrate processing apparatus according to a ninth aspect is the substrate processing apparatus according to any one of the first to eighth aspects, in which each of the plurality of virtual surfaces is a triangular surface, and the surface aggregation is a polyhedron constituted with a large number of triangular surfaces.

A substrate processing apparatus according to a tenth aspect is the substrate processing apparatus according to the ninth aspect, in which the divided surface generation unit divides the virtual surface with high matching degree into three virtual divided surfaces as the plurality of virtual divided surfaces by three line segments connecting each of three vertices of the virtual surface with high matching degree and the virtual camera position with high matching degree.

An information processing method in a substrate processing apparatus according to an eleventh aspect is an information processing method in a substrate processing apparatus that processes a substrate, the information processing method including: a real image acquisition step of acquiring, by an arithmetic unit, a real image capturing a target component obtained by imaging by an imaging unit; and a search step of searching for, by the arithmetic unit, based on reference shape information regarding a two-dimensional shape of a three-dimensional model in each of a plurality of virtual images that can be acquired by imaging the three-dimensional model of the target component from a plurality of virtual camera positions, and real shape information regarding a two-dimensional shape of an object in the real image, the reference shape information being generated based on three-dimensional design information regarding the target component stored in a storage unit, a virtual camera position having a highest matching degree between the reference shape information and the real shape information among a plurality of virtual camera positions, in which the search step includes: a first shape information acquisition step of acquiring, assuming a case where the three-dimensional model is imaged from each of a plurality of first virtual camera positions that is a plurality of virtual camera positions set by virtually setting a surface aggregation including a plurality of virtual surfaces located along a virtual spherical surface surrounding the three-dimensional model centered around a reference point of the three-dimensional model and virtually setting one virtual camera position for each of the plurality of virtual surfaces based on the three-dimensional design information, the reference shape information generated for each of the plurality of first virtual camera positions; a first calculation step of calculating a numerical value indicating a matching degree between the real shape information and the reference shape information for each of the plurality of first virtual camera positions; a first detection step of detecting a virtual camera position with high matching degree that is a first virtual camera position having a highest matching degree between the real shape information and the reference shape information among the plurality of first virtual camera positions based on a calculation result in the first calculation step; a divided surface generation step of generating a plurality of virtual divided surfaces by dividing a virtual surface with high matching degree that is a virtual surface in which the virtual camera position with high matching degree is virtually set among the plurality of virtual surfaces; a second shape information generation step of generating the reference shape information for each of a plurality of second virtual camera positions, assuming a case where the three-dimensional model is imaged from each of the plurality of second virtual camera positions that is a plurality of virtual camera positions set by virtually setting one virtual camera position for each of the plurality of virtual divided surfaces based on the three-dimensional design information,; and a second calculation step of calculating a numerical value indicating a matching degree between the real shape information and the reference shape information for each of the plurality of second virtual camera positions.

### EFFECTS OF THE INVENTION

According to the substrate processing apparatus according to the first aspect, the second virtual camera position is set for each of the plurality of virtual divided surfaces generated by dividing the virtual surface with high matching degree, which is the virtual surface in which the virtual camera position with high matching degree detected by the first detection unit is set among the plurality of virtual surfaces, and a numerical value indicating a matching degree between the real shape information and the reference shape information is calculated for each second virtual camera position. Thus, the virtual surface with high matching degree is not irrelevant to the plurality of virtual divided surfaces, and increase in at least one of the number or an area can be reduced for the plurality of virtual divided surfaces. As a result, an amount of calculation for recognizing the posture of the target component captured in the real image can be reduced. As a result, in the substrate processing apparatus, the posture of the component can be efficiently recognized.

According to the substrate processing apparatus according to the second aspect, in a case where a distance between the imaging unit and the target component changes, the posture of the component can be efficiently recognized.

According to the substrate processing apparatus according to the third aspect, it is possible to efficiently detect the virtual camera position with a higher matching degree between the real shape information and the reference shape information.

According to the substrate processing apparatus according to the fourth aspect, when the unit processing is repeatedly executed, each of the plurality of virtual divided surfaces including the virtual divided surface including the virtual camera position having the highest matching degree between the real shape information and the reference shape information and having mutually different distances from the target component is divided to generate a plurality of virtual divided surfaces in which a next virtual camera position is to be set As a result, the virtual divided surfaces before the division and the virtual divided surfaces after the division are not irrelevant, and increase in at least one of the number or the area can be reduced for the virtual divided surfaces after the division. As a result, an amount of calculation for recognizing the posture of the target component captured in the real image can be reduced. As a result, in the substrate processing apparatus, the posture of the component can be efficiently recognized.

According to the substrate processing apparatus according to the fifth aspect, the posture of the component can be efficiently recognized by the amount of calculation being reduced.

According to the substrate processing apparatus according to the sixth aspect, the posture of the component can be efficiently recognized by the amount of calculation being reduced.

According to the substrate processing apparatus according to the seventh aspect, the reality information related to the posture of the component in the substrate processing apparatus can be efficiently recognized, so that an abnormality of the component can be efficiently detected.

According to the substrate processing apparatus according to the eighth aspect, the surface can be easily divided.

According to the substrate processing apparatus according to the ninth aspect, it is possible to easily set the surface aggregation including the plurality of virtual surfaces.

According to the substrate processing apparatus according to the tenth aspect, the virtual surface can be easily divided.

According to the information processing method in the substrate processing apparatus according to the eleventh aspect, the second virtual camera position is set for each of the plurality of virtual divided surfaces generated by dividing the virtual surface with high matching degree, which is the virtual surface in which the virtual camera position with high matching degree detected in the first detection step is set among the plurality of virtual surfaces, and a numerical value indicating a matching degree between the real shape information and the reference shape information is calculated for each second virtual camera position. Thus, the virtual surface with high matching degree is not irrelevant to the plurality of virtual divided surfaces, and increase in at least one of the number or an area can be reduced for the plurality of virtual divided surfaces. As a result, an amount of calculation for recognizing the posture of the target component captured in the real image can be reduced. As a result, in the substrate processing apparatus, the posture of the component can be efficiently recognized.

### BRIEF DESCRIPTION OF DRAWINGS

[FIG. 1] FIG. 1 is a side view schematically illustrating an example of a schematic configuration of a substrate processing apparatus according to a first embodiment.
[FIG. 2] FIG. 2 is a plan view schematically illustrating an example of a schematic configuration of the substrate processing apparatus according to the first embodiment.
[FIG. 3] FIG. 3 is a block diagram illustrating an example of a functional configuration of the substrate processing apparatus according to the first embodiment.
[FIG. 4] FIG. 4 is a block diagram illustrating a specific example of a functional configuration related to search processing in a control unit.
[FIG. 5] FIG. 5 is a view illustrating a specific example of a real image obtained by imaging by a camera.
[FIG. 6] FIG. 6 is a view illustrating a specific example of a processing target region in the real image.
[FIG. 7] FIG. 7 is a view illustrating a specific example of a processing target real image.
[FIG. 8] FIG. 8 is a view illustrating a specific example of an edge image.
[FIG. 9] FIG. 9 is a view for describing basic concept of search processing.
[FIG. 10] FIG. 10 is a view for describing basic concept of the search processing.
[FIG. 11] FIG. 11 is a view for describing basic concept of the search processing.
[FIG. 12] FIG. 12 is a view for describing basic concept of the search processing.
[FIG. 13] FIG. 13 is a view for describing basic concept of the search processing.
[FIG. 14] FIG. 14 is a view for describing basic concept of the search processing.
[FIG. 15] FIG. 15 is a view for describing basic concept of the search processing.
[FIG. 16] FIG. 16 is a view for describing basic concept of the search processing.
[FIG. 17] FIG. 17 is a view illustrating an example of a setting mode of a plurality of first virtual camera positions.
[FIG. 18] FIG. 18 is a view illustrating an example of a setting mode of a first virtual camera position on a virtual surface.
[FIG. 19] FIG. 19 is a view for describing an example of a mode in which T1 surface aggregations having mutually different distances from a reference point of a 3D model of a target component are virtually set.
[FIG. 20] FIG. 20 is a view for describing a specific example of calculation processing of a numerical value indicating a matching degree between real shape information and reference shape information for one first virtual camera position.
[FIG. 21] FIG. 21 is a view for describing a specific example of calculation processing of a numerical value indicating a matching degree between the real shape information and the reference shape information for one first virtual camera position.
[FIG. 22] FIG. 22 is a view for describing a specific example of calculation processing of a numerical value indicating a matching degree between the real shape information and the reference shape information for one first virtual camera position.
[FIG. 23] FIG. 23 is a view for describing a specific example of calculation processing of a numerical value indicating a matching degree between the real shape information and the reference shape information for one first virtual camera position.
[FIG. 24] FIG. 24 is a view for describing a specific example of calculation processing of a numerical value indicating a matching degree between the real shape information and the reference shape information for one first virtual camera position.
[FIG. 25] FIG. 25 is a view illustrating a specific example in which a collation target region is set in an edge image as the real shape information.
[FIG. 26] FIG. 26 is a view schematically illustrating a specific example in which a virtual surface with high matching degree is divided into a plurality of virtual divided surfaces.
[FIG. 27] FIG. 27 is an image diagram schematically illustrating an example of T2 virtual surfaces.
[FIG. 28] FIG. 28 is an image diagram schematically illustrating an example of first T3 virtual divided surfaces.
[FIG. 29] FIG. 29 is a view for describing a first specific example in which the first M3×T3 virtual divided surfaces are generated by the divided surface generation unit.
[FIG. 30] FIG. 30 is a view for describing a second specific example in which the first M3×T3 virtual divided surfaces are generated by the divided surface generation unit.
[FIG. 31] FIG. 31 is a view for describing a second specific example in which the first M3×T3 virtual divided surfaces are generated by the divided surface generation unit.
[FIG. 32] FIG. 32 is an image diagram schematically illustrating an example of second T3 virtual divided surfaces which is a specific example of n-th T3 virtual divided surfaces.
[FIG. 33] FIG. 33 is a view for describing a first specific example in which the second M3×T3 virtual divided surfaces are generated by the divided surface generation unit.
[FIG. 34] FIG. 34 is a view for describing a second specific example in which the second M3×T3 virtual divided surfaces are generated by the divided surface generation unit.
[FIG. 35] FIG. 35 is a view for describing a second specific example in which the second M3×T3 virtual divided surfaces are generated by the divided surface generation unit.
[FIG. 36] FIG. 36 is a flowchart indicating a specific example of schematic flow of processing in the substrate processing apparatus.
[FIG. 37] FIG. 37 is a flowchart indicating a specific example of flow of image processing in step S3 and step S10 in FIG. 36.
[FIG. 38] FIG. 38 is a flowchart indicating a specific example of processing flow in search processing in step S4 and step S11 in FIG. 36.
[FIG. 39] FIG. 39 is a flowchart indicating a specific example of processing flow in primary search processing in step Sb1 in FIG. 38.
[FIG. 40] FIG. 40 is a flowchart indicating a specific example of processing flow in secondary search processing in step Sb2 in FIG. 38.
[FIG. 41] FIG. 41 is a flowchart indicating a specific example of processing flow in the secondary search processing in step Sb2 in FIG. 38.
[FIG. 42] FIG. 42 is a flowchart indicating a specific example of processing flow in the secondary search processing in step Sb2 in FIG. 38.
[FIG. 43] FIG. 43 is a view schematically illustrating an example of a state in which the target component is moved to an origin position.
[FIG. 44] FIG. 44 is a view for describing detection of an abnormality of a chuck.
[FIG. 45] FIG. 45 is a view for describing detection of an abnormality of the chuck.
[FIG. 46] FIG. 46 is a view for describing detection of an abnormality of a nozzle and a guard.
[FIG. 47] FIG. 47 is a view schematically illustrating an example of a schematic configuration of a substrate processing system.

### DESCRIPTION OF EMBODIMENTS

There is a substrate processing apparatus including a processing chamber, a substrate holding unit, a nozzle, a camera, an image processing unit, and a monitoring unit.

In this substrate processing apparatus, the substrate holding unit, the nozzle, and the camera are arranged in the processing chamber. The substrate holding unit rotates a substrate in a horizontal plane while holding the substrate in a horizontal posture. The nozzle moves between a standby position deviated to a side of the substrate and a discharge position above the substrate by turning of a drive arm to which the nozzle is fixed. The nozzle is arranged at the standby position when the substrate is attached to and detached from the substrate holding unit, and is arranged at the discharge position when a processing liquid is discharged from the nozzle toward the substrate. The camera is arranged at a predetermined position in the processing chamber and captures an image of a predetermined region including the nozzle that has moved to the discharge position. The image processing unit acquires second nozzle position information indicating a position of the nozzle based on the image from the camera, and outputs the second nozzle position information to the monitoring unit. The monitoring unit determines whether or not there is an abnormality in the position of the nozzle based on correspondence between first nozzle position information as information directly or indirectly indicating the position of the nozzle from the control unit and the second nozzle position information from the image processing unit.

By the way, in the substrate processing apparatus, for example, there is a case where it is desired to recognize a posture of one or more components among various components such as a nozzle, a chuck that holds a peripheral edge of a substrate in a substrate holding unit, and a guard that moves up and down in a region surrounding a side of the substrate holding unit in order to detect an abnormality, an operation state, and the like of the component.

In this case, it is conceivable to cause the substrate processing apparatus to recognize the posture of the component by, for example, a method of sequentially performing the following [processing A] to [processing E].

### [Processing A]

A virtual polyhedron constituted with a plurality of virtual surfaces along a spherical surface centered around a three-dimensional design shape (also referred to as a three-dimensional component model) of a component represented by three-dimensional computer aided design (CAD) data of the component, or the like, is set. Each virtual surface is constituted with, for example, a triangular surface.

### [Processing B]

A camera (also referred to as a virtual camera) is virtually installed at a predetermined position (also referred to as a virtual camera position) on each virtual surface constituting the virtual polyhedron set in the processing A. As a result, a plurality of virtual cameras is virtually installed so as to surround the three-dimensional component model.

### [Processing C]

A plurality of images (also referred to as virtual images) acquired by virtual imaging of the three-dimensional component model by the plurality of virtual cameras installed at the plurality of virtual camera positions in the processing B is generated. The virtual image can be generated, for example, by projecting the three-dimensional component model on a virtual plane by processing such as rendering.

### [Processing D]

Matching (collation) processing using template matching, or the like, is performed between each of the plurality of virtual images generated in the processing C and an image (also referred to as a real image) obtained by actually imaging the component with a camera (also referred to as a real camera). As a result, the virtual camera position at which a degree of matching (also referred to as a matching degree) between the real image and the virtual image is the highest with respect to a shape, a direction, a size, and the like, of the captured component among the plurality of virtual camera positions is detected. The degree of matching (matching degree) is also referred to as a degree of similarity (similarity).

### [Processing E]

The posture of the component is recognized based on the detection result in the processing D. Here, for example, the posture of the component captured in the real image is recognized by recognizing the posture of the component relative to a position of the real camera based on the detection result in the processing D.

In the above method, for example, in a case where a distance between the real camera and the component changes, a plurality of virtual polyhedrons having mutually different distances from the center of the three-dimensional component model is set in the processing A.

Here, for example, a method is conceivable in which accuracy of recognizing the posture of the component is improved by making a plurality of virtual surfaces constituting the virtual polyhedron in the processing A into a very fine large number of virtual surfaces and increasing the number of virtual camera positions virtually installed in the processing B. However, according to this method, time required for calculation increases due to increase in the amount of calculation.

Thus, for example, a method in which the processing E is executed after the processing A to the processing D are sequentially repeatedly executed a predetermined number of times can be considered. In this method, in the first time of the processing A, a virtual polyhedron is constituted with a plurality of relatively large virtual surfaces, in the second and subsequent times of the processing A, a virtual polyhedron is constituted with a large number of virtual surfaces relatively finer than the previous processing A, and in the second and subsequent times of the processing B, a virtual camera is virtually installed at a predetermined virtual camera position on each of some of a plurality of virtual surfaces close to the virtual camera position detected in the most recent time of the processing D in the polyhedron set in the previous processing A. With this method, time required for calculation can be shortened by reducing the amount of calculation while improving the accuracy of recognizing the posture of the component.

However, in this method, it is necessary to set a fine virtual polyhedron stepwise in a plurality of times of the processing A, and the virtual polyhedron set in the second and subsequent times of the processing A is irrelevant to the virtual polyhedron set in the previous processing A. Thus, in order to maintain the accuracy of recognizing the posture of the component, some of the plurality of virtual surfaces in which the virtual camera position is virtually set in the second and subsequent times of the processing B cover a somewhat wide area located near a position of the virtual camera detected in the most recent processing D. As a result, at least one of the number or the area of some of the plurality of virtual surfaces in which the virtual camera position is set in the second and subsequent times of the processing B increases to some extent, and the number of virtual camera positions set in the second and subsequent times of processing B may increase, so that it is not easy to sufficiently reduce the amount of calculation.

Thus, there is room for improvement in the substrate processing apparatus to efficiently recognize the posture of the component.

Hereinafter, embodiments will be described with reference to the accompanying drawings. Note that the drawings are schematically illustrated, and omission of components or simplification of a configuration is appropriately made for convenience of description. In addition, the mutual relationship between the sizes and positions of the components illustrated in the drawings is not necessarily accurately described, and can be appropriately changed.

Furthermore, in the following description, similar components are denoted by the same reference numerals, and the names and functions thereof are also similar. Thus, detailed description thereof may be omitted to avoid duplication.

In addition, in the following description, even if ordinal numbers such as "first" or "second" are used, these terms are used for convenience to facilitate understanding of the content of the embodiments, and are not limited to the order that can occur by these ordinal numbers.

In a case where expressions indicating a relative or absolute positional relationship (such as, for example, "in one direction", "along one direction", "parallel", "orthogonal", "center", "concentric", and "coaxial") are used, the expressions shall not only strictly represent the positional relationship, but also represent a state of being displaced relative to an angle or distance to the extent that a tolerance or comparable function is obtained, unless otherwise specified. In a case where expressions indicating equal states (such as, for example, "identical", "equal", and "homogeneous") are used, they shall not only represent quantitatively strictly equal states, but also represent states in which there are differences that result in tolerances or comparable functionality, unless otherwise specified. In a case where an expression indicating a shape (such as, for example, "quadrangular" or "cylindrical") is used, unless otherwise specified, the expression not only represents the shape geometrically and strictly, but also represents a shape having, for example, any one of unevenness and chamfering within a range in which a similar effect can be obtained. In a case where an expression "comprising", "comprising", "comprising", "including" or "having" one component is used, the expression is not an exclusive expression excluding the presence of other components. In a case where an expression "at least one of A, B or C" is used, it includes A only, B only, C only, any two of A, B and C, and all of A, B and C.

### <1. Overall Configuration of Substrate Processing Apparatus>

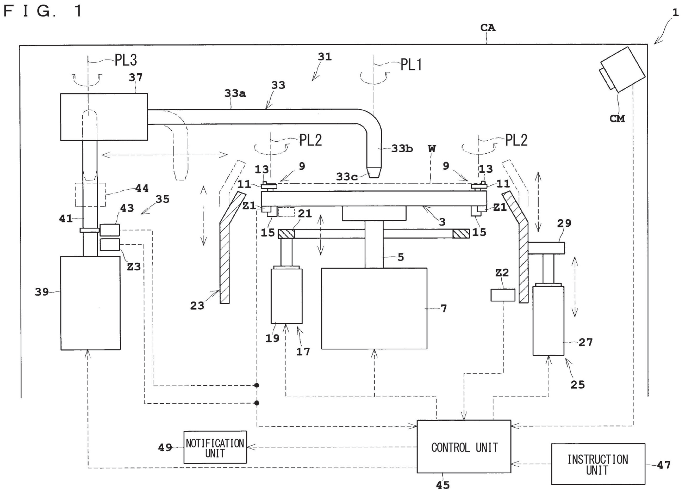

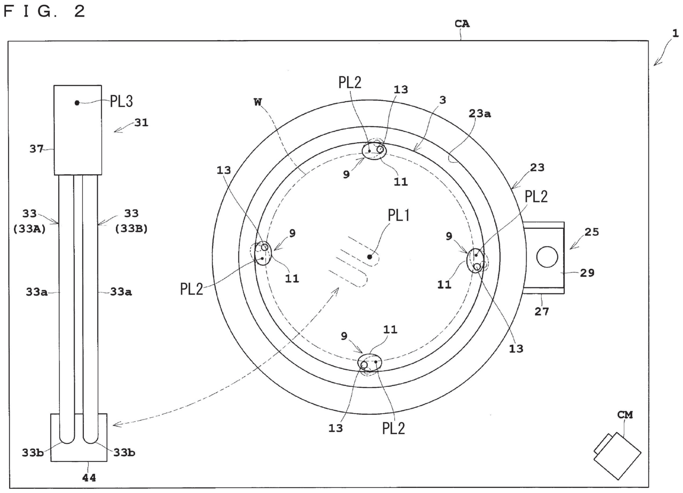

FIG. 1 is a side view schematically illustrating an example of a schematic configuration of a substrate processing apparatus 1 according to a first embodiment. FIG. 2 is a plan view schematically illustrating an example of the schematic configuration of the substrate processing apparatus 1 according to the first embodiment.

The substrate processing apparatus 1 is an apparatus that processes a substrate (for example, a semiconductor wafer) W. In the first embodiment, the substrate processing apparatus 1 is a single wafer type apparatus that processes the substrates W one by one. A substantially disk-shaped thin flat plate is adopted as the substrate W. In other words, the substrate W has a circular shape in plan view. The plan view means a plan view in which each part is viewed from an upper side to a lower side when no condition is particularly described. The substrate processing apparatus 1 supplies a processing liquid to the substrate W while rotating the substrate W to perform predetermined processing on the substrate W. As the substrate processing apparatus 1, for example, a substrate cleaning apparatus that cleans the substrate W using the processing liquid is adopted.

The substrate processing apparatus 1 includes a casing CA. The casing CA shields the inside of the casing CA from the atmosphere around the casing CA.

The substrate processing apparatus 1 includes a spin chuck 3. The spin chuck 3 has a circular structure having a diameter larger than that of the substrate W in plan view. An upper end of a rotating shaft 5 is connected to a lower surface of the spin chuck 3. A lower end of the rotating shaft 5 is connected to a motor 7. The spin chuck 3 rotates about a rotation center PL1 by being driven by the motor 7. The rotation center PL1 extends in a vertical direction.

The spin chuck 3 includes a plurality of chucks 9. More specifically, the spin chuck 3 includes the plurality of chucks 9 at a peripheral edge portion of an upper surface of the spin chuck 3. In the first embodiment, the spin chuck 3 includes four chucks 9. The number of chucks 9 included in the spin chuck 3 is not limited to four as long as the spin chuck 3 can stably rotate about the rotation center PL1 while supporting the substrate W in a horizontal posture.

The chuck 9 includes, for example, a lower surface support portion 11, a peripheral edge support portion 13, and a rotating magnet 15. The lower surface support portion 11 is a portion for supporting the substrate W by abutting on the lower surface of the substrate W from below. For example, if a contact area of the lower surface support portion 11 with the lower surface of the substrate W is configured to be small, a degree of mutual contamination between the substrate W and the chuck 9 can be reduced. The lower surface support portion 11 is rotatably attached to an upper surface side of the main body portion of the spin chuck 3 at the rotation center PL2. The rotation center PL2 extends in the vertical direction. The peripheral edge support portion 13 is erected on the upper surface of the lower surface support portion 11. For example, if a height of the peripheral edge support portion 13 from the upper surface of the lower surface support portion 11 is higher than a thickness of the substrate W, the peripheral edge support portion 13 can stably hold the peripheral edge of the substrate W. The peripheral edge support portion 13 is provided at a position away from the rotation center PL2 toward an outer edge of the lower surface support portion 11 in plan view. In other words, the peripheral edge support portion 13 is eccentric from the rotation center PL2. The rotating magnet 15 is attached at a position corresponding to the rotation center PL2 on the lower surface side of the spin chuck 3. The rotating magnet 15 is connected to the lower surface support portion 11. The rotating magnet 15 is provided so as to be rotatable about the rotation center PL2.

The substrate processing apparatus 1 includes a chuck driving mechanism 17 arranged below the rotating magnet 15. The chuck driving mechanism 17 is arranged closer to the rotating shaft 5 than the chuck 9. The chuck driving mechanism 17 includes, for example, an air cylinder 19 and a driving magnet 21. The driving magnet 21 has an annular shape in plan view. The air cylinder 19 includes a piston rod (also referred to as a rod or an operation shaft) located along the vertical direction. The driving magnet 21 is attached to an upper end of the rod of the air cylinder 19. The chuck driving mechanism 17 is operated in response to a chuck operation command from the control unit 45. The chuck driving mechanism 17 can bring the driving magnet 21 close to the chuck 9 by raising the driving magnet 21 by the air cylinder 19, and can move the driving magnet 21 in a direction away from the chuck 9 by lowering the driving magnet 21 by the air cylinder 19. The chuck driving mechanism 17 can move the driving magnet 21 between a position that is raised (also referred to as a raised position) and a position that is lowered (also referred to as a lowered position).

The chuck 9 includes a biasing mechanism (not illustrated). If the driving magnet 21 descends and moves from the raised position to the lowered position, the chuck 9 moves from the open position to the closed position. If the driving magnet 21 ascends and moves upward from the lowered position to the raised position, the chuck 9 moves from the closed position to the open position. If the chuck 9 moves from the open position to the closed position, the peripheral edge support portion 13 rotates about the rotation center PL2, and the peripheral edge support portion 13 moves in a direction approaching the rotation center PL1 and abuts on the peripheral edge of the substrate W. As a result, the plurality of chucks 9 can clamp the substrate W at the closed position. When the chuck 9 moves from the closed position to the open position, the peripheral edge support portion 13 rotates about the rotation center PL2, and the peripheral edge support portion 13 moves in a direction away from the rotation center PL1. As a result, the plurality of chucks 9 is in a state of not holding the substrate W at the open position. In this state, the substrate W can be carried onto the spin chuck 3 from the outside of the casing CA, and the substrate W can be carried out from the spin chuck 3 to the outside of the casing CA. In addition, in a state where the substrate W is not placed on the lower surface support portion 11, if the driving magnet 21 descends and moves from the raised position to the lowered position, the chuck 9 is located at a position where the peripheral edge support portion 13 slightly moves to an inner side of the substrate W (also referred to as an origin position or a chuck origin position) than a position of an outer edge of the substrate W assumed in a case where the substrate W is placed on the lower surface support portion 11. In other words, in a case where the chuck 9 is located at the origin position, the peripheral edge support portion 13 is located closer to the rotation center PL1 than the position in a case where the chuck 9 is located at the closed position.

The substrate processing apparatus 1 includes an origin sensor Z1 arranged near the rotating magnet 15 of the chuck 9. If the chuck 9 moves to the closed position or the origin position, the origin sensor Z1 changes a signal (also referred to as an output signal) to be output from the origin sensor Z1. For example, the origin sensor Z1 turns on the output signal if the chuck 9 moves to the closed position or the origin position.

The substrate processing apparatus 1 includes a guard 23 arranged around the spin chuck 3. The guard 23 surrounds the side of the spin chuck 3. The guard 23 is a portion for preventing scattering of the processing liquid from the substrate W supported and rotated by the spin chuck 3 to the surroundings. The guard 23 has a tubular form. The guard 23 includes an opening 23a formed in an upper portion. An inner diameter of the opening 23a is larger than an outer diameter of the spin chuck 3.

The substrate processing apparatus 1 includes a guard moving mechanism 25 capable of raising and lowering the guard 23. The guard moving mechanism 25 includes, for example, an air cylinder 27 and a locking piece 29. The guard moving mechanism 25 is arranged, for example, on an outer peripheral side of the guard 23. The guard moving mechanism 25 may be arranged on an inner peripheral side of the guard 23 as long as the guard 23 can be raised and lowered. The air cylinder 27 includes a piston rod (also referred to as a rod or an operation shaft) located along the vertical direction. The locking piece 29 is attached to an upper end of the rod of the air cylinder 27. The locking piece 29 is fixed to an outer peripheral surface of the guard 23. The guard moving mechanism 25 is not limited to the above configuration as long as the guard 23 can be raised and lowered.

The guard moving mechanism 25 moves the guard 23 between an origin position and a processing position in response to a guard operation command from the control unit 45. The origin position of the guard 23 is the position of the guard 23 when the guard 23 is lowered by the guard moving mechanism 25. In other words, the origin position is a position where an upper end of the guard 23 is low. The processing position of the guard 23 is the position of the guard 23 when the guard 23 is raised by the guard moving mechanism 25. In other words, the origin position is a position lower than the processing position, and the processing position is a position higher than the origin position. In a state where the guard 23 is located at the origin position, the position of the upper edge of the guard 23 is lower than the position of the substrate W supported by the spin chuck 3. In a state where the guard 23 is located at the processing position, the position of the upper edge of the guard 23 is higher than the position of the substrate W supported by the spin chuck 3. Thus, in a state where the guard 23 is located at the processing position, the guard 23 can receive the processing liquid scattered from the substrate W supported and rotated by the spin chuck 3 to the surroundings by the inner peripheral surface of the guard 23. The substrate processing apparatus 1 includes, for example, an origin sensor Z2 arranged on the inner peripheral side of the guard 23. When the guard 23 moves to the origin position, the origin sensor Z2 changes a signal (output signal) to be output from the origin sensor Z2. For example, the origin sensor Z2 turns on the output signal if the guard 23 moves to the origin position.

The substrate processing apparatus 1 includes a waste liquid port (not illustrated) located on the inner peripheral side of the guard 23. The waste liquid port is a portion for collecting the processing liquid which is scattered to the periphery from the substrate W supported and rotated by the spin chuck 3, and received on the inner peripheral surface of the guard 23. The number of the guards 23 is not limited to one, and a plurality of the guards 23 may be provided. The number of the waste liquid ports is not limited to one, and a plurality of waste liquid ports may be provided. In a case where a plurality of the guards 23 is provided, the waste liquid port may be arranged for each of the guards 23. In this case, the plurality of the guards 23 and the plurality of waste liquid ports may be configured such that a combination of the guard 23 that is raised and lowered by the guard moving mechanism 25 and receives the processing liquid scattered from the substrate W and the waste liquid port that collects the processing liquid received on the inner peripheral surface of the guard 23 is switched. For example, it is conceivable that the combination of the guard 23 that receives the processing liquid scattered from the substrate W and the waste liquid port that collects the processing liquid received on the inner peripheral surface of the guard 23 is switched by raising and lowering each guard 23 by the guard moving mechanism 25 according to a type of the processing liquid.

The substrate processing apparatus 1 includes a processing liquid supply mechanism 31. The processing liquid supply mechanism 31 may be arranged on the outer peripheral side of the guard 23. The processing liquid supply mechanism 31 includes, for example, a nozzle 33, a base portion 37, and a nozzle moving mechanism 35. In the first embodiment, the processing liquid supply mechanism 31 includes, for example, two nozzles 33. In the following description, in a case where it is necessary to distinguish the two nozzles 33, the nozzle 33 on the left side in FIG. 2 will be referred to as a nozzle 33A, and the nozzle 33 on the right side will be referred to as a nozzle 33B as appropriate. The number of the nozzles 33 in the processing liquid supply mechanism 31 may be one or three or more. In the first embodiment, the two nozzles 33 have the same configuration.

The nozzle 33 includes, for example, an extending portion 33a, a hanging portion 33b, and a distal end portion 33c. One end of the extending portion 33a of the nozzle 33 is attached to the base portion 37. The extending portion 33a extends in the horizontal direction from the base portion 37. The other end of the extending portion 33a is connected to the hanging portion 33b. The hanging portion 33b extends downward in the vertical direction from the extending portion 33a. The distal end portion 33c is located on a lower end side of the hanging portion 33b. The distal end portion 33c discharges the processing liquid from a lower surface side. Examples of the processing liquid include a photoresist liquid, a spin-on-glass (SOG) liquid, a developer, a rinse liquid, pure water, a cleaning liquid, and the like.

The nozzle moving mechanism 35 includes, for example, a motor 39, a rotation shaft 41, and a position detection unit 43. The motor 39 is arranged in a vertical posture. The rotation shaft 41 is rotated about the rotation center PL3 by the motor 39. The rotation shaft 41 is connected to the base portion 37. The base portion 37 is rotated by being driven by the motor 39. The nozzle 33 is swung about the rotation center PL3 together with the base portion 37 by the nozzle moving mechanism 35. The position detection unit 43 detects a position (also referred to as a rotation position) of the rotation shaft 41 in a rotation direction around the rotation center PL3 of the rotation shaft 41. The position detection unit 43 detects an angle of the rotation shaft 41 about the rotation center PL3 in plan view. The position detection unit 43 outputs, for example, a pulse signal according to the rotational position of the rotation shaft 41.

The substrate processing apparatus 1 includes a standby cup 44 arranged at a position laterally away from the guard 23 in plan view. The standby cup 44 is arranged such that the distal end portion 33c of the nozzle 33 can be located above the standby cup 44 in plan view. From another point of view, the standby cup 44 is located below the origin position of the nozzle 33. The standby cup 44 is a portion for preventing the distal end portion 33c of the nozzle 33 from being dried. The standby cup 44 is used for idle discharge of the processing liquid from the nozzle 33. The nozzle moving mechanism 35 drives the motor 39 to swing the nozzle 33. The nozzle moving mechanism 35 moves the distal end portion 33c of the nozzle 33 between the origin position and the discharge position on the rotation center PL1 of the spin chuck 3 in response to the nozzle operation command from the control unit 45. The discharge position of the nozzle 33 is a position where the nozzle 33 is arranged when the processing liquid is discharged from the distal end portion 33c of the nozzle 33 toward the substrate W.

The substrate processing apparatus 1 includes, for example, an origin sensor Z3 arranged on the outer peripheral side of the rotation shaft 41. If the nozzle 33 is located at the origin position, the origin sensor Z3 changes a signal (output signal) to be output from the origin sensor Z3. For example, the origin sensor Z3 turns on the output signal if the nozzle 33 moves to the origin position. Note that the origin sensor Z3 may be omitted to simplify the configuration. In this case, a projection (also referred to as a rotation-side projection) may be provided on a portion of the rotation shaft 41, and a projection (also referred to as a fixed-side projection) that is arranged on the outer peripheral side of the rotation shaft 41 and fixed to the casing CA may be provided. For example, the position detection unit 43 may detect that the nozzle 33 is located at the origin position by detecting that rotation of the rotation shaft 41 about the rotation center PL3 becomes impossible by a rotation-side projection of the rotation shaft 41 abutting on a fixed-side projection due to rotation of the rotation shaft 41 about the rotation center PL3. Here, a position of the nozzle 33 at the time when the pulse signal of the position detection unit 43 becomes unchanged may be treated as the origin position.

The substrate processing apparatus 1 includes a camera CM as an imaging unit. The camera CM obtains an image (also referred to as a real image) capturing one or more target components to be described later by imaging. The camera CM is attached to a portion of the casing CA, for example. The position of the camera CM may be any position as long as a target component to be described later falls within a field of view. The camera CM has, for example, a viewing angle (angle of view) at which all of one or more target components to be described later fall within the field of view. The camera CM has, for example, a viewing angle (angle of view) at which all of origin positions of one or more target components to be described later fall within the field of view.

The substrate processing apparatus 1 includes a control unit 45, an instruction unit 47, and a notification unit 49. Details of the control unit 45 will be described later. The instruction unit 47 is operated by an operator of the substrate processing apparatus 1. The instruction unit 47 is, for example, a keyboard or a touch panel. For example, the instruction unit 47 outputs a signal corresponding to operation of the operator to the control unit 45. The instruction unit 47 gives an instruction of a target component, a confirmation required timing, an allowable range, a recipe, start of processing, and the like, to be described later. In a case where the control unit 45 detects an abnormality, the notification unit 49 notifies the operator of the abnormality. Examples of the notification unit 49 include a display, a lamp, a speaker, and the like. For example, the notification unit 49 operates in response to a signal from the control unit 45.

### <2. Configuration of Control System in Substrate Processing Apparatus>

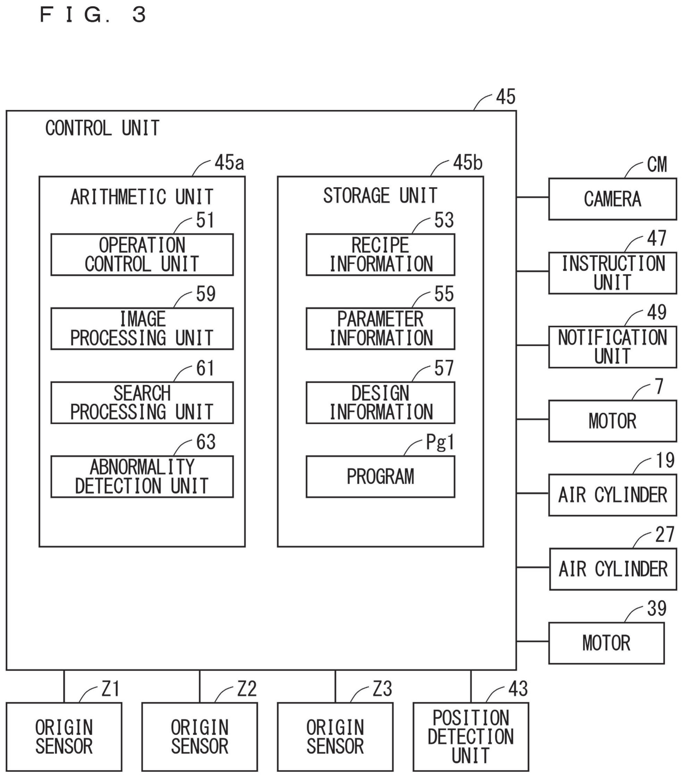

FIG. 3 is a block diagram illustrating an example of a functional configuration of the substrate processing apparatus 1 according to the first embodiment.

The control unit 45 includes, for example, an arithmetic unit 45a, a storage unit 45b, and the like. The arithmetic unit 45a includes, for example, an electronic circuit that functions as a processor such as a central processing unit (CPU) and an electronic circuit that functions as a memory such as a random access memory (RAM) that temporarily stores data for the processor to execute processing. The storage unit 45b includes a portion that functions as a non-volatile storage medium such as a hard disk or a flash memory. For example, the storage unit 45b may have a portion that functions as one non-volatile storage medium, or may have a portion that functions as two or more non-volatile storage media.

The arithmetic unit 45a includes, for example, an operation control unit 51, an image processing unit 59, a search processing unit 61, and an abnormality detection unit 63 as a plurality of functional components. The storage unit 45b stores, for example, recipe information 53, parameter information 55, design information 57, a program Pg1, and the like. In the arithmetic unit 45a, for example, the operation control unit 51, the image processing unit 59, the search processing unit 61, and the abnormality detection unit 63 may be functional processing units (also referred to as functional processing units) implemented by the CPU reading and executing the program Pg1, and the like, in the storage unit 45b.

The operation control unit 51 controls the operation of the motors 7, 39, the air cylinders 19, 27, and the camera CM described above. Signals from the origin sensors Z1, Z2, Z3 and the position detection unit 43 are given to the operation control unit 51. The operation of each unit such as the motors 7, 39, the air cylinders 19, 27, and the camera CM by the operation control unit 51 is controlled according to, for example, the recipe in the recipe information 53 stored in the storage unit 45b. For example, after start of the operation of each unit based on the recipe is instructed by the operator, the operation control unit 51 outputs various operation commands to each unit based on the recipe to operate each unit such as the motor 7 at a predetermined timing.

The recipe information 53 is information indicating various recipes stored in advance in the storage unit 45b. The recipe defines various kinds of procedure for processing the substrate W. The operator can give an instruction to execute a desired recipe by operating the instruction unit 47.

The parameter information 55 is information such as a confirmation required timing and an allowable range for each target component stored in advance in the storage unit 45b. The target component is a component to be subjected to specific processing among the components constituting the substrate processing apparatus 1. In the first embodiment, the specific processing includes abnormality detection. The confirmation required timing is a timing for confirming an operation state of the target component. The confirmation required timing may overlap with a timing at which the operation control unit 51 outputs the operation command, or may overlap with a timing at which the target component completes movement according to the operation command. The target component, the confirmation required timing, the allowable range, and the like, can be arbitrarily set by the operator operating the instruction unit 47. The operator can give an instruction, from the instruction unit 47, as to a component to be set as the target component, a timing to be set as the confirmation required timing, a range (allowable range) in which an error in the position of the target component is to be allowed, and the like.

The target components may include, for example, the chuck 9, the guard 23, the nozzle 33, and the like. The confirmation required timing can include, for example, a timing at which the chuck driving mechanism 17 moves the chuck 9 in response to the chuck operation command and the movement of the chuck 9 is completed, a timing at which the nozzle moving mechanism 35 moves the nozzle 33 in response to the nozzle operation command and the movement of the nozzle 33 is completed, a timing at which the guard moving mechanism 25 moves the guard 23 up and down in response to the guard operation command and the movement of the guard 23 is completed, a timing at which the chuck 9 is set to be located at the closing position by the chuck operation command, a timing at which the nozzle 33 is set to be located at the discharge position by the nozzle operation command, a timing at which the guard 23 is set to be located at the processing position by the guard operation command, and the like.

The allowable range indicates an allowable degree with respect to a position where the target component should originally exist at the confirmation required timing in a case where the target component normally operates. The allowable range is, for example, a degree representing how much deviation from a designed position and angle is allowed for the target component. Based on the processing on the substrate W, the allowable range indicates a range of deviation of the target component that can be allowed as the processing on the substrate W even if the target component deviates from the designed position and angle at the confirmation required timing.

If the nozzle 33 as the target component is at the confirmation required timing, based on the pulse signal from the position detection unit 43 and the parameter information 55 in the storage unit 45b, the operation control unit 51 described above notifies the search processing unit 61 of the information indicating the nozzle 33 as the target component at the confirmation required timing and the information indicating the position (such as, for example, a discharge position) where the nozzle 33 as the target component at the confirmation required timing should originally be located at the confirmation required timing. If the target component is located at the origin position based on the signals from the origin sensors Z1, Z2, Z3, the operation control unit 51 notifies the search processing unit 61 of information specifying the target component located at the origin position. Here, if there is only one target component, the operation control unit 51 does not have to notify the search processing unit 61 of information specifying the target component located at the origin position. If the target component is at the confirmation required timing, in accordance with the control of the operation of the air cylinders 19, 27 and the motor 39, for each target component, the operation control unit 51 notifies the search processing unit 61 of information on the target component at the confirmation required timing and information indicating the position (such as, for example, a closed position of the chuck 9, a discharge position of the nozzle 33 or a processing position of the guard 23) at which the target component should originally be located at the confirmation required timing. Here, if there is only one target component, the operation control unit 51 does not have to notify the search processing unit 61 of information on the target component at the confirmation required timing. The operation control unit 51 may notify the search processing unit 61 that the operation command has been output to each unit according to the recipe.

The design information 57 includes design information related to components constituting the substrate processing apparatus 1 stored in the storage unit 45b. The design information 57 may include design information related to the substrate W as a processing target in the substrate processing apparatus 1. The design information 57 includes, for example, three-dimensional computer aided design (3D-CAD) data. The design information 57 may include physical property information regarding the processing liquid and various materials to be used for processing.

The 3D-CAD data is expressed by, for example, three axes whose coordinate axes are orthogonal to each other, and in a case where a component is arranged in a three-dimensional space, the 3D-CAD data is expressed by position and angle information (also collectively referred to as position information) related to the component. The storage unit 45b stores in advance design information related to at least a target component transferred from a host computer (not illustrated). In other words, the storage unit 45b stores three-dimensional design information on the target component. A host computer (not illustrated) may store 3D-CAD data on all components and materials of the substrate processing apparatus 1 as the three-dimensional design information. Here, if the design information 57 stored in the storage unit 45b is limited to the design information on the target component instead of the design information on all the components of the substrate processing apparatus 1, the storage capacity of the storage unit 45b can be saved.

The image processing unit 59 processes a real image obtained by imaging by the camera CM. The image processing unit 59 performs image processing on the real image and extracts information (also referred to as real shape information) related to a two-dimensional shape of the object captured in the real image. For example, the image processing unit 59 extracts real shape information by performing processing of extracting contour, for example, for all components captured in all regions or some preset regions in the real image. The contour here may include not only the contour of the outer shape of the component but also an edge portion located inside the outer shape of the component. The real shape information extracted by the image processing unit 59 is given to the search processing unit 61.

The search processing unit 61 performs processing (also referred to as search processing) of searching for a virtual camera position having the highest matching degree between the reference shape information and the real shape information among the plurality of virtual camera positions (also referred to as virtual camera positions) based on the plurality of pieces of reference shape information and the real shape information. Here, the plurality of pieces of reference shape information is information generated based on the three-dimensional design information regarding the target component stored in the storage unit 45b. More specifically, the plurality of pieces of reference shape information is information related to a two-dimensional shape of the 3D model of the target component in each of a plurality of virtual images (also referred to as virtual images) that can be acquired by imaging the three-dimensional model (also referred to as a 3D model) of the target component from a plurality of virtual camera positions. For example, one piece of reference shape information is information generated based on the three-dimensional design information regarding one target component, and is information regarding a two-dimensional shape of a 3D model of the target component in a virtual image that can be acquired by imaging the 3D model of the target component from one virtual camera position. The 3D model of the target component is a three-dimensional model of the target component virtually generated based on the three-dimensional design information related to the target component. The virtual image can be generated, for example, by projecting the 3D model on a virtual plane by processing such as rendering. The matching degree between the reference shape information and the real shape information refers to, for example, a degree to which the reference shape information is approximate to the real shape information. The reference shape information is closer to the real shape information as the matching degree is larger, and the reference shape information is more different from the real shape information as the matching degree is smaller. The matching degree between the reference shape information and the real shape information is represented by, for example, a numerical value indicating the matching degree between the reference shape information and the real shape information. The matching degree and a numerical value indicating the matching degree will be further described later. The information related to the two-dimensional shape of the 3D model may be, for example, a figure.

According to the search processing of the search processing unit 61, it is possible to search among the plurality of virtual camera positions, for a virtual camera position that, by imaging from that position, can yield a virtual image in which the two-dimensional shape of the 3D model of the target component has the highest matching degree with the target component captured in the real image obtained by imaging by the camera CM. The search processing unit 61 can recognize the posture of the target component based on the search result.

The search processing unit 61 performs search processing for at least the target component for which the confirmation required timing has occurred. As a result, the substrate processing apparatus 1 can recognize the posture of the target component for which the confirmation required timing has occurred. The search processing unit 61 outputs information (also referred to as reality information) regarding the posture of the target component recognized using the real image to the abnormality detection unit 63. In other words, the reality information is, for example, information related to the posture of the target component based on the virtual camera position having the highest matching degree detected by the search processing unit 61. This reality information is based on the real image, and is information indicating a state in which the target component is actually located in the substrate processing apparatus 1 at the confirmation required timing.

In accordance with an instruction from the operation control unit 51, the search processing unit 61 may perform search processing for the target component even at a timing that is not the confirmation required timing. For example, in response to the instruction from the operation control unit 51 based on the output signals from the origin sensors Z1, Z2, Z3, the search processing unit 61 may perform search processing (also referred to as origin search processing) for the target component located at the origin position. The origin search processing may be performed only once for each target component, for example, when the substrate processing apparatus 1 is activated and processing on the substrate W is started. Furthermore, the search processing unit 61 may perform search processing for the target component at any timing including the confirmation required timing.

The abnormality detection unit 63 detects an abnormality of the target component according to the information output from the search processing unit 61. Specifically, the abnormality detection unit 63 detects the abnormality of the target component by comparing information (reality information) related to the posture of the target component based on the virtual camera position having the highest matching degree between the real shape information and the reference shape information detected by the search processing unit 61 with information (also referred to as normal information) related to the posture of the target component based on the three-dimensional design information in a case where a state of the target component is normal. More specifically, the abnormality detection unit 63 detects the abnormality of the target component in a case where the reality information does not match the normal information as a result of comparison between the reality information and the normal information for the target component. Here, the normal information on the target component may include information related to the posture of the target component in a case where the posture is within the allowable range. In this case, the fact that the reality information matches the normal information includes that the information related to any posture of the target component within the allowable range of the normal information matches the information related to the posture of the target component in the reality information.

The abnormality detection unit 63 causes the notification unit 49 to perform notification operation according to the detection result. Specifically, the abnormality detection unit 63 causes the notification unit 49 to perform notification operation in response to detection of the abnormality of the target component. The notification operation may be, for example, operation of making a notification of occurrence of the abnormality. Along with the occurrence of the abnormality, for example, the notification unit 49 may also make a notification of information specifying the target component in which the abnormality has been detected, or may also make a notification of position information of the target component in which the abnormality has been detected. Here, examples of the information for specifying the target component in which the abnormality has been detected include a character string or a speech indicating a name or a symbol for specifying each of the plurality of chucks 9, a name or a symbol for specifying each of the one or more guards 23, a name or a symbol for specifying each of the one or more nozzles 33, and the like. Examples of the information indicating the position information of the target component in which the abnormality has been detected include various kinds of information such as a character string or a speech indicating the closed position and the open position of the chuck 9, the origin position and the processing position of the guard 23, and the origin position and the discharge position of the nozzle 33.

### <3. Specific Example of Functional Configurations Related to Search Processing>

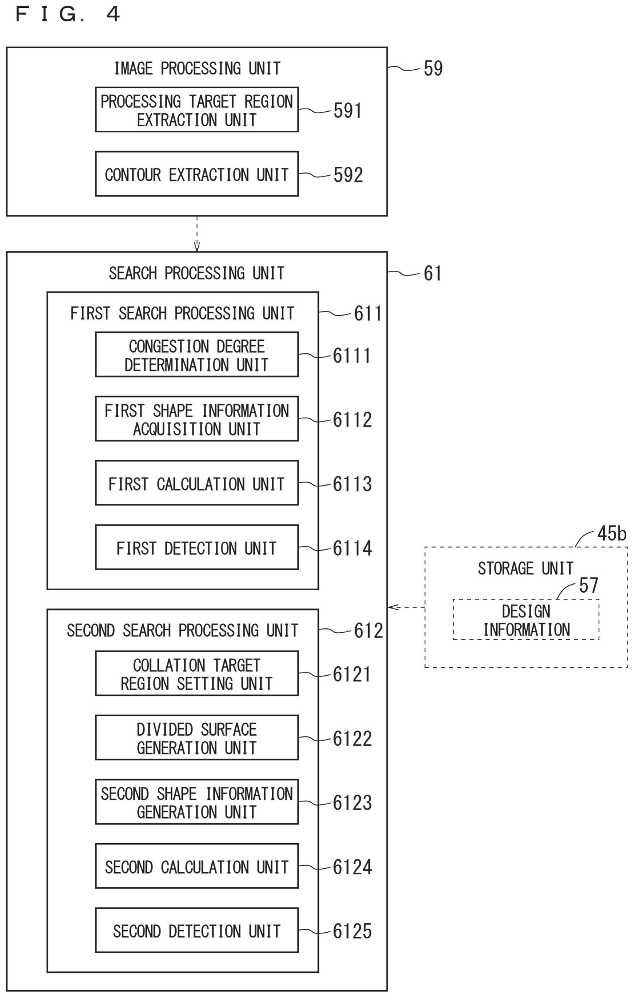

FIG. 4 is a block diagram illustrating a specific example of a functional configuration related to the search processing in the control unit 45. FIG. 4 illustrates functional configurations of the storage unit 45b, the image processing unit 59, and the search processing unit 61 among a plurality of functional configurations in the control unit 45.

### <3-1. Image Processing Unit>

The image processing unit 59 includes, for example, a processing target region extraction unit 591 and a contour extraction unit 592 as a plurality of functional processing units. The processing target region extraction unit 591 and the contour extraction unit 592 are implemented, for example, by the CPU reading and executing the program Pg1 stored in the storage unit 45b in the control unit 45 (more specifically, the arithmetic unit 45a).

The processing target region extraction unit 591 acquires a real image capturing a target component obtained by imaging by the camera CM, and extracts a portion related to a region to be processed (also referred to as a processing target region) from the real image as an image (also referred to as a processing target real image). As a result, for example, a processing amount of calculation can be reduced in the processing in the contour extraction unit 592 and the processing in the search processing unit 61. As a result, the posture of the target component can be efficiently recognized.

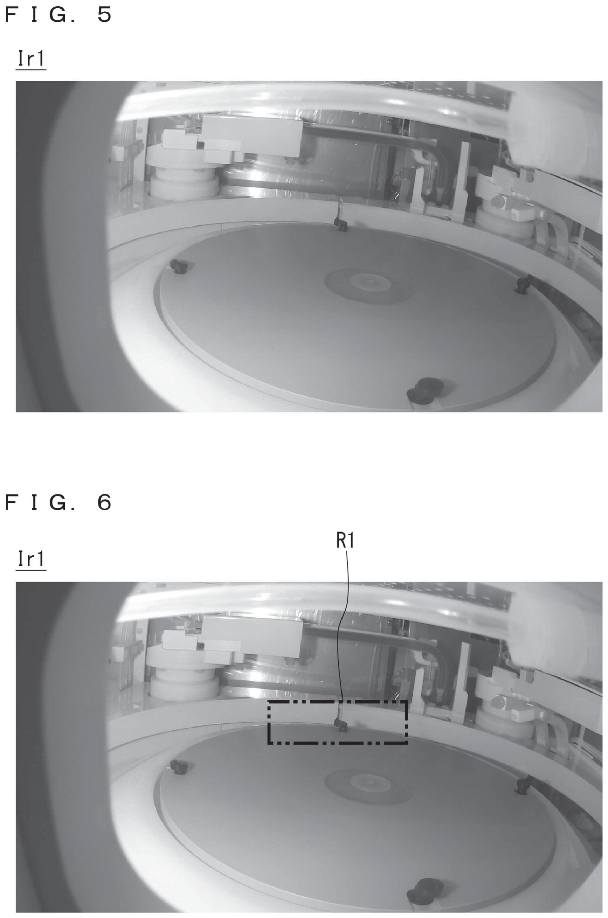

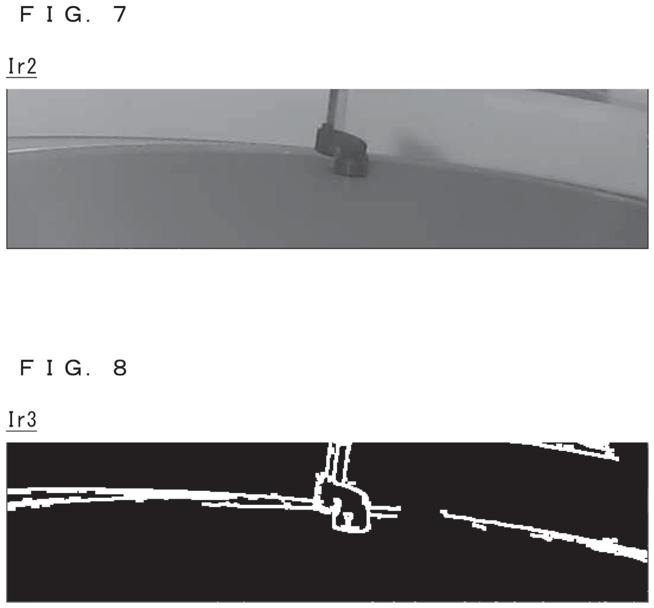

FIGS. 5 to 7 are views for describing processing of extracting a portion related to a processing target region from the real image. FIG. 5 illustrates a specific example of a real image Ir1 obtained by imaging by the camera CM. FIG. 6 illustrates a specific example of a processing target region R1 in the real image Ir1. FIG. 7 illustrates a specific example of a processing target real image Ir2 extracted from the real image Ir1.

For example, in a case where the real image Ir1 illustrated in FIG. 5 is acquired, the processing target region extraction unit 591 extracts a portion related to the processing target region R1 surrounded by a thick two-dot chain line in the real image Ir1 as illustrated in FIG. 6, thereby obtaining the processing target real image Ir2 as illustrated in FIG. 7.

For example, the processing target region R1 may be set in advance for each target component so as to include a region in which the target component can exist at the confirmation required timing on the real image. For example, the processing target region R1 may be set by referring to a real image obtained by imaging by the camera CM in advance, or may be set based on design information of components constituting the substrate processing apparatus 1 and an imaging direction and an angle of view of the camera CM.

For example, the contour extraction unit 592 extracts information (real shape information) related to a two-dimensional shape of the object captured in the real image by performing processing of extracting the contour for all the components captured in the processing target real image Ir2 obtained by the processing target region extraction unit 591. As a result, the image processing unit 59 can acquire real shape information related to the two-dimensional shape of the object captured in the real image. The real shape information acquired by the image processing unit 59 is given to the search processing unit 61.

Here, the processing target real image Ir2 obtained by the processing target region extraction unit 591 may be regarded as the real image capturing the target component. As described above, the contour may include not only the contour of an outer shape of the component, but also an edge portion located inside the outer shape of the component. The processing of extracting the contour can be implemented using, for example, a method of detecting an edge such as a Canny method. Here, the contour may be extracted for all the components captured in the processing target real image Ir2 by further performing processing of expanding a line such as morphology transformations on the detected edge. The real shape information may be, for example, an edge image indicating contour of the object captured in the real image. As the edge image, for example, a binary image in which the contour of the object and the other portion can be distinguished is adopted. Here, it can be said that the edge image as the real shape information is information indicating the two-dimensional shape of the object in the real image. In other words, the real shape information may be, for example, information indicating the two-dimensional shape of the object in the real image. FIG. 8 is a view illustrating a specific example of an edge image Ir3 as real shape information acquired by the contour extraction unit 592. The edge image Ir3 illustrated in FIG. 8 is an example of an edge image obtained by performing processing of extracting contour for all components captured in the processing target real image Ir2 illustrated in FIG. 7. The edge image Ir3 illustrated in FIG. 8 is a binary image in which the contour of the component extracted by the contour extraction unit 592 is indicated in white and the other portions are indicated in black.

### <3-2. Search Processing Unit>

### <3-2-1. Example of Basic Concept of Search Processing>

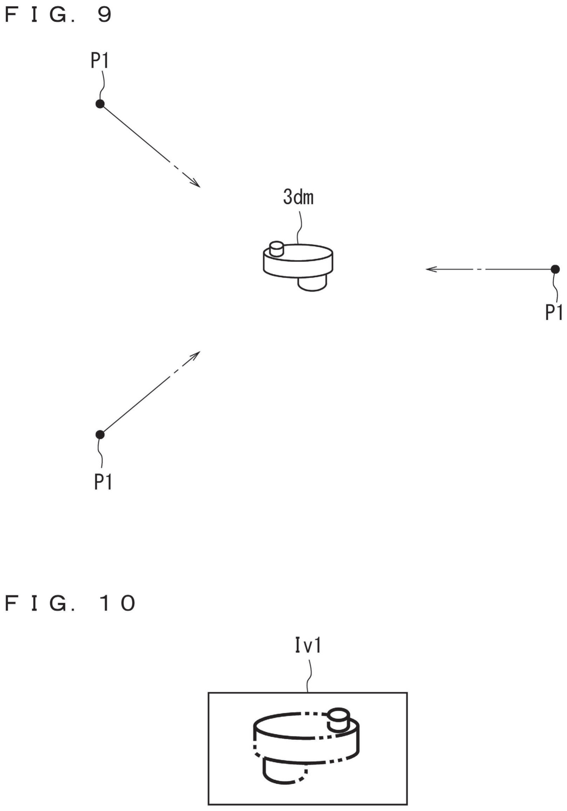

FIGS. 9 to 16 are views for describing an example of basic concept of the search processing.

For example, as illustrated in FIG. 9, information (reference shape information) regarding the two-dimensional shape of the 3D model 3dm of the target component in a virtual image (virtual image) that can be acquired by imaging the 3D model 3dm of the target component from each virtual camera position P1 is generated while positions (virtual camera positions) P1 of the plurality of virtual cameras are appropriately set centered around the 3D model 3dm of the target component that is a three-dimensional model of the target component virtually generated based on the three-dimensional design information regarding the target component (for example, the chuck 9). In other words, the reference shape information is generated for each virtual camera position P1. As illustrated in FIG. 10, for example, an image (also referred to as a reference image) Iv1 indicating contour as a two-dimensional shape of the 3D model 3dm of the target component in the virtual image that can be acquired by imaging the 3D model 3dm of the target component from each virtual camera position P1 can be adopted as the reference shape information. Here, it can be said that the reference image is information indicating the two-dimensional shape of the 3D model 3dm in the virtual image as the reference shape information. In other words, the reference shape information may be, for example, information indicating the two-dimensional shape of the 3D model 3dm in the virtual image. FIG. 10 illustrates an example of the reference image Iv1 in which the contour of the 3D model 3dm of the target component is indicated by a thick two-dot chain line for convenience. The reference image Iv1 illustrated in FIG. 10 is a binary image in which the contour as the two-dimensional shape of the 3D model 3dm of the target component is indicated in black and the other portion is indicated in white.

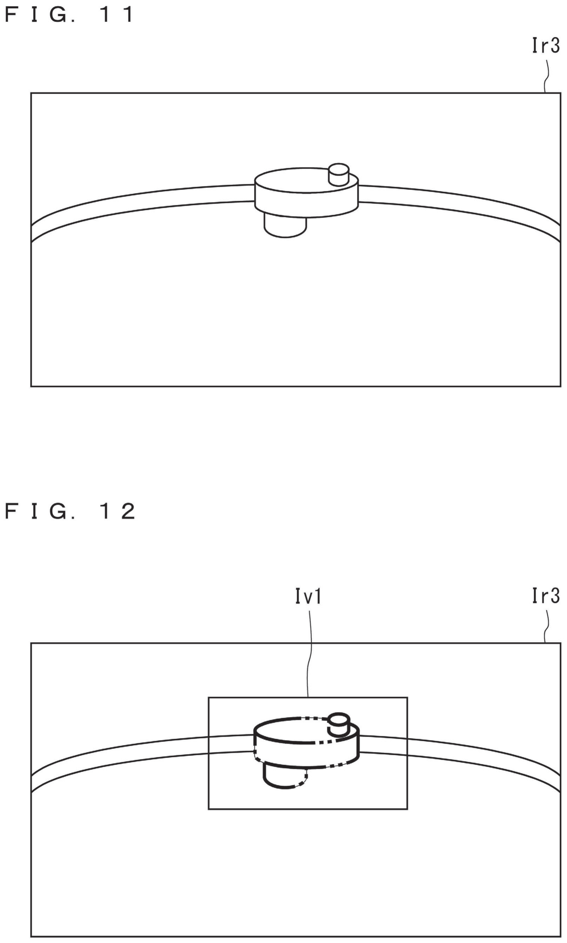

Then, for example, a numerical value indicating a matching degree is calculated between each of the plurality of reference images Iv1 as the plurality of pieces of reference shape information obtained for the plurality of virtual camera positions P1 and the edge image Ir3 as the real shape information related to the two-dimensional shape of the object captured in the real image as illustrated in FIG. 11. The edge image Ir3 illustrated in FIG. 11 is a binary image in which the contour of the object is indicated in black and the other portion is indicated in white. Here, for example, relative rotational movement and parallel movement of the reference image Iv1 as the reference shape information are performed on the edge image Ir3 as the real shape information. In this event, a numerical value indicating the matching degree in a case where the matching degree of the reference image Iv1 as the reference shape information with respect to the edge image Ir3 as the real shape information becomes maximum can be calculated as a numerical value indicating the matching degree between the edge image Ir3 as the real shape information and the reference image Iv1 as the reference shape information. In other words, for each virtual camera position P1, a numerical value indicating the matching degree in a case where the matching degree between the reference image Iv1 as the reference shape information and the edge image Ir3 as the real shape information becomes maximum can be calculated as a numerical value indicating the matching degree between the edge image Ir3 as the real shape information and the reference image Iv1 as the reference shape information. In other words, for each virtual camera position P1, the matching degree in a case where the matching degree between the reference image Iv1 as the reference shape information and the edge image Ir3 as the real shape information becomes maximum is set as the matching degree between the edge image Ir3 as the real shape information and the reference image Iv1 as the reference shape information.

Furthermore, for example, as illustrated in FIG. 12, among the plurality of virtual camera positions P1, the virtual camera position P1 having a highest matching degree between the edge image Ir3 as the real shape information and the reference image Iv1 as the reference shape information is detected. As a result, for the target component, it is possible to search among the plurality of virtual camera positions, for a virtual camera position that, by imaging from that position, can yield a virtual image in which the two-dimensional shape of the 3D model 3dm of the target component has the highest matching degree with the target component captured in the real image obtained by imaging by the camera CM.

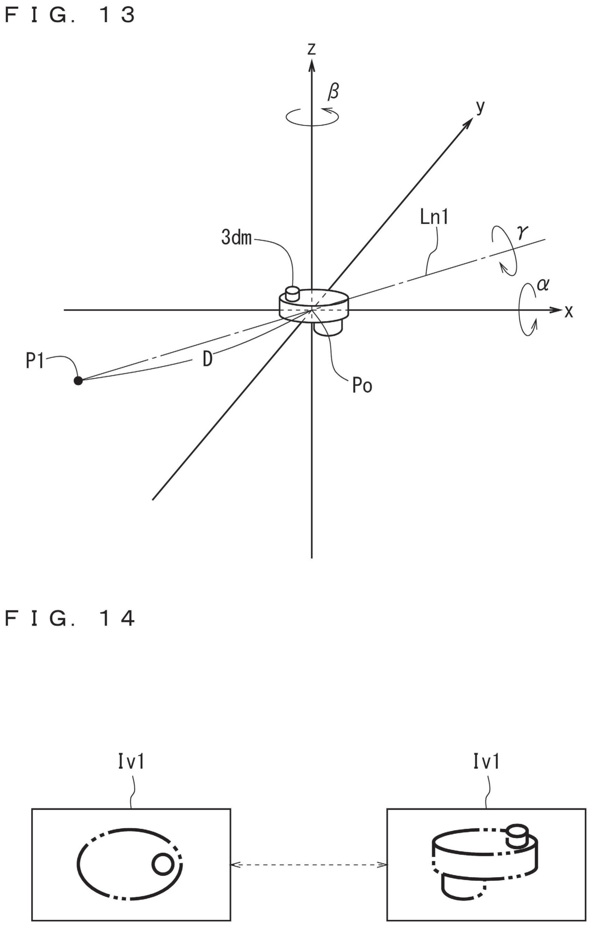

As illustrated in FIG. 13, a case is assumed where a xyz coordinate of a right-handed coordinate system in which the center of the 3D model 3dm of the target component is set as an origin as the reference point Po is set. For example, the center of gravity of the 3D model 3dm is adopted as the center of the 3D model 3dm. In this case, the plurality of virtual camera positions P1 about the 3D model 3dm can be defined by an angle (also referred to as a latitude) α in the rotation direction about the x axis, an angle (also referred to as a longitude) β in the rotation direction about the z axis, and a distance D from the origin. Furthermore, the posture of the virtual camera that images the 3D model 3dm of the target component from the virtual camera position P1 can be defined by an angle (also referred to as a roll angle) γ in a rotation direction around a line Ln1 indicated by a thin one-dot chain line passing through the reference point Po and the virtual camera position P1.

Here, if the latitude α and the longitude β defining the virtual camera position P1 change, a direction of imaging the 3D model 3dm of the target component from the virtual camera position P1 changes. Thus, if the latitude α and the longitude β defining the virtual camera position P1 change, for example, as illustrated in FIG. 14, a shape of the two-dimensional shape of the contour of the 3D model 3dm of the target component indicated by the thick two-dot chain line in the reference image Iv1 as the reference shape information may change.

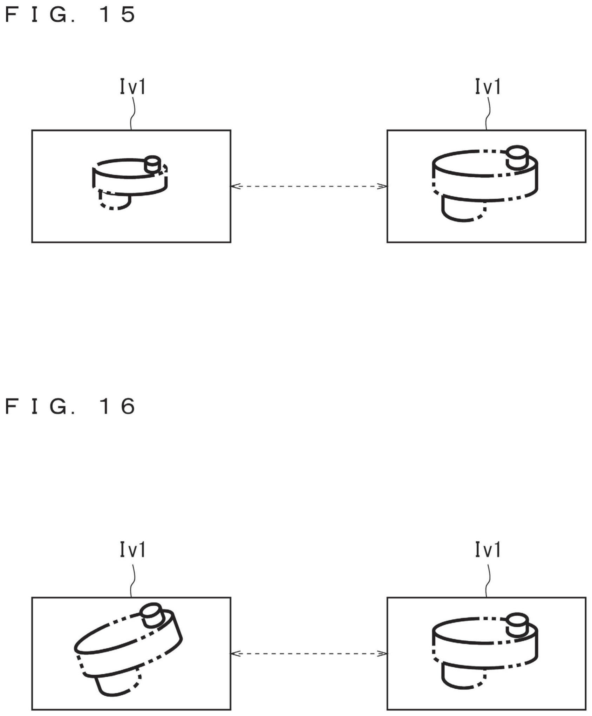

Furthermore, here, even if a distance D defining the virtual camera position P1 changes, the direction of imaging the 3D model 3dm of the target component from the virtual camera position P1 does not change. Thus, if the distance D defining the virtual camera position P1 changes, for example, as illustrated in FIG. 15, the two-dimensional shape of the contour of the 3D model 3dm of the target component indicated by a thick two-dot chain line in the reference image Iv1 as the reference shape information may change in size without changing in shape.

Furthermore, here, if the roll angle γ that defines the posture of the virtual camera at the virtual camera position P1 changes, for example, as illustrated in FIG. 16, the two-dimensional shape of the contour of the 3D model 3dm of the target component indicated by a thick two-dot chain line in the reference image Iv1 as the reference shape information may change in direction without changing in shape and size.

In the first embodiment, in order to efficiently advance the search processing, the search processing unit 61 performs the primary search processing and then performs the secondary search processing using the result of the primary search processing. In other words, the search processing includes the primary search processing and the secondary search processing which are sequentially performed. The primary search processing is processing of calculating the numerical value indicating the matching degree between the reference shape information and the real shape information for a limited number of virtual camera positions P1 by making the latitude α and the longitude β coarsely different to some extent, and detecting the virtual camera position P1 at which the matching degree between the reference shape information and the real shape information becomes the highest. The secondary search processing is processing of more finely searching for the virtual camera position P1 at which the matching degree between the reference shape information and the real shape information becomes higher based on the virtual camera position P1 detected in the primary search processing. When the numerical value indicating the matching degree between the reference shape information and the real shape information is calculated in the primary search processing and the secondary search processing, for example, the roll angle γ at which the matching degree becomes higher is also obtained, and the numerical value indicating the matching degree is calculated in consideration of the roll angle γ. As a result, the latitude α, the longitude β, the distance D, and the roll angle γ for the virtual camera position P1 at which the matching degree between the reference shape information and the real shape information becomes the highest can be acquired as a result of the search processing. From the latitude α, the longitude β, the distance D, and the roll angle γ, the posture of the 3D model 3dm based on the virtual camera position P1 at which the matching degree between the reference shape information and the real shape information becomes the highest can be recognized. Thus, according to the result of the search processing, the posture of the target component based on the position of the camera CM that has acquired the real image capturing the target component can be recognized. In other words, according to the result of the search processing, the posture of the target component captured in the real image can be recognized. Here, for example, the posture of the target component may be recognized in the form of latitude α, longitude β, distance D, and roll angle γ.

### <3-2-2. Functional Configuration of Search Processing Unit>

The search processing unit 61 includes, for example, a first search processing unit 611 and a second search processing unit 612 as a plurality of functional processing units. The first search processing unit 611 and the second search processing unit 612 are implemented, for example, by the CPU reading and executing the program Pg1 stored in the storage unit 45b in the control unit 45 (more specifically, the arithmetic unit 45a). The first search processing unit 611 is a unit that performs processing related to the primary search processing, and the second search processing unit 612 performs processing related to the secondary search processing.

### <3-2-2-1. First Search Processing Unit>

The first search processing unit 611 includes, for example, a congestion degree determination unit 6111, a first shape information acquisition unit 6112, a first calculation unit 6113, and a first detection unit 6114 as a plurality of functional processing units. The congestion degree determination unit 6111, the first shape information acquisition unit 6112, the first calculation unit 6113, and the first detection unit 6114 are implemented, for example, by the CPU reading and executing the program Pg1 stored in the storage unit 45b in the control unit 45 (more specifically, the arithmetic unit 45a). In the first search processing unit 611, for example, the primary search processing can be implemented by the first shape information acquisition unit 6112, the first calculation unit 6113, and the first detection unit 6114.

### <<Congestion DEGREE Determination Unit 6111>>

For example, the congestion degree determination unit 6111 determines a region (also referred to as a low congestion degree region) in which the congestion degree of the contour of the component is low for the edge image as the real shape information acquired by the contour extraction unit 592. In the congestion degree determination unit 6111, for example, in the edge image as the real shape information, the proportion occupied by the contour of the component is calculated as the congestion degree of the contour of the component for each region of a predetermined size (also referred to as a unit determination region), and the unit determination region in which the congestion degree is equal to or less than a predetermined value can be determined as a low congestion degree region. The predetermined size in the unit determination region can be set, for example, according to the size of the reference image as the reference shape information described above. The predetermined value can be set to a numerical value such as zero, for example.

For example, in a case where zero is adopted as the predetermined value, the unit determination region that does not include the contour of the component at all in the edge image as the real shape information is determined as the low congestion degree region. The determination result in the congestion degree determination unit 6111 is given to the first calculation unit 6113 and the second search processing unit 612. Here, it is estimated that a low congestion degree region does not include the contour of the target component. Thus, for example, in the first calculation unit 6113 and the second calculation unit 6124 to be described later, the low congestion degree region of the edge image as the real shape information is excluded from the calculation target for calculating the numerical value indicating the matching degree between the real shape information and the reference shape information, so that the amount of calculation required for the search processing can be reduced.

### <<First Shape Information Acquisition Unit 6112>>

For example, the first shape information acquisition unit 6112 acquires reference shape information generated for each of a plurality of first virtual camera positions assuming a case where the 3D model of the target component is imaged from each of a plurality of virtual camera positions (also referred to as first virtual camera positions) based on the three-dimensional design information regarding the target component stored in the storage unit 45b. The plurality of first virtual camera positions is a plurality of virtual camera positions set by virtually setting one virtual camera position for each of a plurality of virtual surfaces in a case where an aggregate of surfaces (also referred to as a surface aggregation) including the plurality of virtual surfaces located along a virtual spherical surface surrounding the 3D model of the target component centered around the reference point of the 3D model of the target component is virtually set. Here, the reference shape information is information generated based on the three-dimensional design information regarding the target component, and is information regarding the two-dimensional shape of the 3D model of the target component in the virtual image that can be acquired by imaging from the virtual camera position. The reference point of the 3D model of the target component may be set to, for example, a center point such as a center of gravity of the 3D model of the target component. Here, by the number of the plurality of virtual surfaces constituting the surface aggregation being set to M1 (M1 is a natural number equal to or greater than 2), the plurality of first virtual camera positions is limited to M1 first virtual camera positions. In each virtual surface, for example, the first virtual camera position is virtually set at a predetermined position of the virtual surface. For example, the position of the center of the virtual surface is adopted as the predetermined position. For example, the center of gravity of the virtual surface is adopted as the center of the virtual surface.

In the first embodiment, for example, a triangular surface is adopted as each of the plurality of virtual surfaces constituting the surface aggregation, and a polyhedron constituted with a large number of triangular surfaces is adopted as the surface aggregation. In other words, a spherical polyhedron constituted with a large number of triangles is adopted as the surface aggregation. As a result, the surface aggregation including the plurality of virtual surfaces can be easily set. Here, an equilateral triangle may be adopted as the triangle. If the virtual surface is a triangular surface, the center of the virtual surface may be, for example, the center of gravity of the triangle or the incenter of the triangle.

For example, the first shape information acquisition unit 6112 can acquire the reference shape information generated for each of the plurality of first virtual camera positions by setting the plurality of first virtual camera positions and generating the reference shape information for each of the plurality of first virtual camera positions, based on the three-dimensional design information regarding the target component stored in the storage unit 45b.

Here, for example, as illustrated in FIG. 13, the positions and postures of the plurality of virtual surfaces can be defined by setting the xyz coordinates of the right-handed coordinate system with the reference point Po of the 3D model 3dm of the target component defined by the three-dimensional design information regarding the target component as the origin. Furthermore, the position of each of the plurality of first virtual camera positions can be defined by an angle (latitude) α in the rotation direction around the x axis, an angle (longitude) β in the rotation direction around the z axis, and the distance D from the origin.

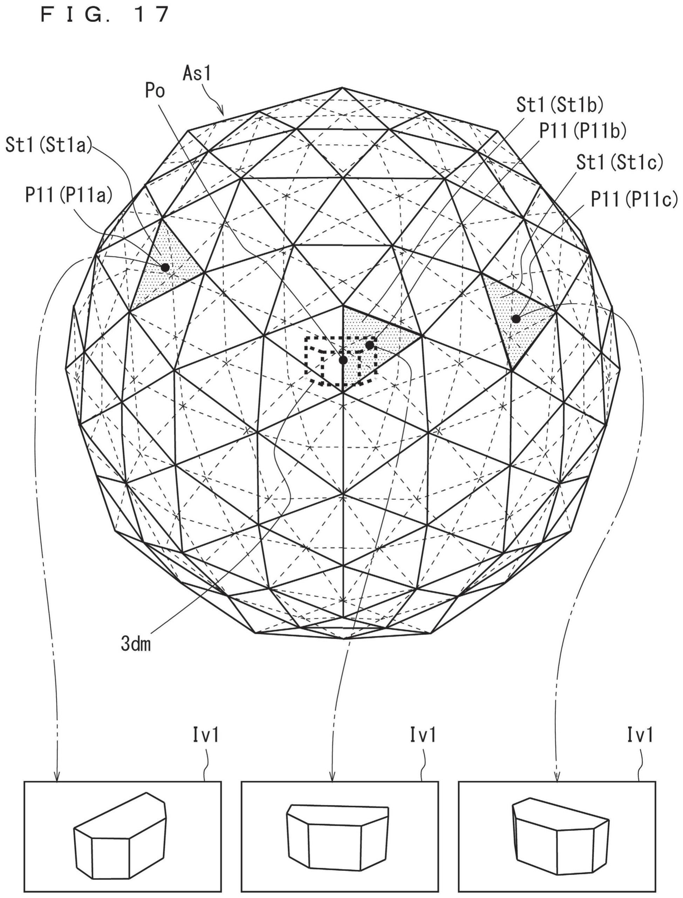

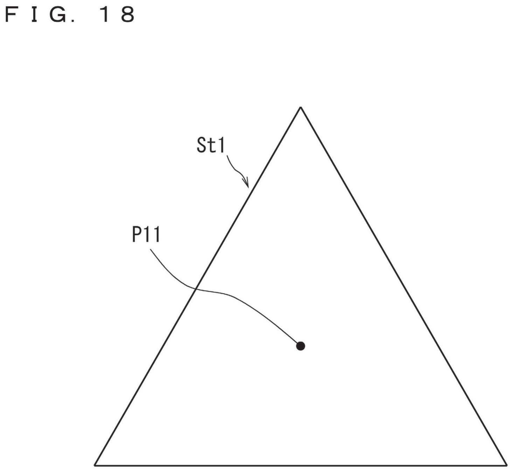

FIG. 17 is a view illustrating an example of a mode in which a plurality of first virtual camera positions P11 is set. FIG. 18 is a view illustrating an example of a setting mode of the first virtual camera position P11 in the virtual surface St1. In FIG. 17, for the purpose of avoiding complication of the drawing, only the origin as the reference point Po among the xyz coordinates of the right-handed coordinate system is illustrated, and description of three axes of xyz is omitted, and description of the angle (latitude) α and the angle (longitude) β is also omitted. In addition, in FIG. 17, the description of the angle (roll angle) γ in the rotation direction about the line passing through the origin as the reference point Po and the first virtual camera position P11, which defines the posture of the virtual camera that images the 3D model 3dm of the target component from the first virtual camera position P11, is also omitted. In addition, in FIG. 17, the contour of the portion on the front side of the polyhedron is indicated by a solid line, and the contour of the portion on the back side of the polyhedron is indicated by a thin broken line. In FIG. 17, for the sake of convenience, a component having hexagonal upper and lower planes is illustrated as an example of the 3D model 3dm of the target component, and the contour of the component is indicated by a thick broken line.

In the first shape information acquisition unit 6112, for example, as illustrated in FIG. 17, a surface aggregation As1 including a plurality of triangular virtual surfaces St1 located along a virtual spherical surface surrounding the 3D model 3dm of the target component centered around the reference point Po of the 3D model 3dm of the target component is virtually set. Then, a plurality of first virtual camera positions P11 as a plurality of virtual camera positions P1 is virtually set for the plurality of triangular virtual surfaces St1, respectively.

FIG. 17 illustrates a spherical polyhedron constituted with about 200 triangular virtual surfaces St1 as an example of the surface aggregation As1. In FIG. 17, for convenience, reference signs "St1" are attached to three triangular virtual surfaces St1 among the plurality of virtual surfaces St1. Each of a virtual surface St1a, a virtual surface St1b, and a virtual surface St1c, which are the three triangular virtual surfaces St1, is hatched using pearskin finish for convenience. In FIG. 17, the first virtual camera position P11 set for each of three virtual surfaces St1 among the plurality of triangular virtual surfaces St1 is illustrated by black circles. More specifically, a reference sign "P11a" is attached to the first virtual camera position P11 set with respect to the virtual surface St1a, a reference sign "P11b" is attached to the first virtual camera position P11 set with respect to the virtual surface St1b, and a reference sign "P11c" is attached to the first virtual camera position P11 set with respect to the virtual surface St1c. Here, for example, as illustrated in FIG. 18, one first virtual camera position P11 is set at the center of one triangular virtual surface St1 as a predetermined position of one triangular virtual surface St1. In other words, for example, the first virtual camera position P11 is set at the center of each virtual surface St1 of the triangle as a predetermined position of each virtual surface St1 of the triangle.

Furthermore, for example, the first shape information acquisition unit 6112 generates reference shape information regarding the two-dimensional shape of the 3D model 3dm of the target component in the virtual image that can be acquired by imaging from the first virtual camera position P11 for each of the plurality of first virtual camera positions P11 illustrated in FIG. 17. In this event, the imaging direction by the virtual camera that images the 3D model 3dm of the target component from the first virtual camera position P11 is set to a direction from the first virtual camera position P11 toward the reference point Po of the 3D model 3dm of the target component. Furthermore, the roll angle γ that defines the posture of the virtual camera that images the 3D model 3dm of the target component from the first virtual camera position P11 is set to, for example, zero (0) degrees.

In a lower portion of FIG. 17, an image (reference image) Iv1 indicating the contour as a two-dimensional shape of the 3D model 3dm of the target component in the virtual image that can be acquired by imaging the 3D model 3dm of the target component from each first virtual camera position P11 is illustrated as the reference shape information generated for each of the three first virtual camera positions P11.

By the way, it is assumed that the distance between the camera CM and the target component changes due to movement of the target component or an error in the position where the target component is attached in the substrate processing apparatus 1. In this case, the size of the target component may change in the real image obtained by imaging by the camera CM. On the other hand, as described above, if the distance D defining the virtual camera position P1 is changed, the size of the two-dimensional shape of the contour of the 3D model 3dm of the target component in the reference image Iv1 as the reference shape information changes. Thus, assuming a case where the distance between the camera CM and the target component changes, the first shape information acquisition unit 6112 needs to virtually set the plurality of first virtual camera positions P11 with different distances D and obtain the reference shape information generated for each of the first virtual camera positions P11.

Thus, the first shape information acquisition unit 6112 acquires the reference shape information generated for each of M1 xT1 first virtual camera positions P11 assuming a case where the 3D model of the target component is imaged from each of the M1×T1 (both M1 and T1 are natural numbers equal to or greater than 2) first virtual camera positions P11 based on the three-dimensional design information regarding the target component stored in the storage unit 45b, for example. The M1×T1 first virtual camera positions P11 are a plurality of virtual camera positions set by the first shape information acquisition unit 6112 by virtually setting T1 surface aggregations having mutually different distances from the reference point of the 3D model of the target component and virtually setting one virtual camera position for each of the M1 virtual surfaces in each of the T1 surface aggregations. Here, the reference shape information is information generated based on the three-dimensional design information regarding the target component, and is information regarding the two-dimensional shape of the 3D model of the target component in the virtual image that can be acquired by imaging from the first virtual camera position P11. M1 is appropriately set in a range of, for example, about 100 to 300. T1 is appropriately set in a range of, for example, about 3 to 30.

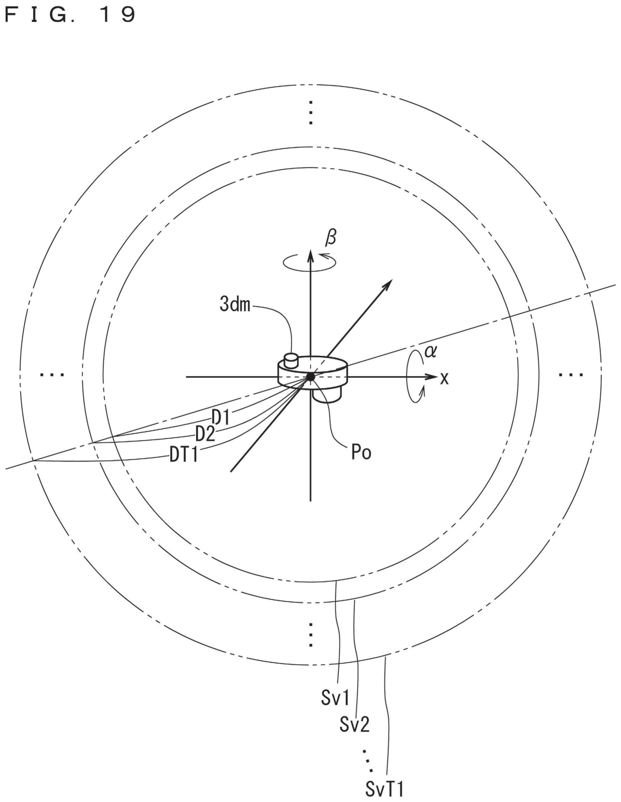

FIG. 19 is a view for describing an example of a mode in which T1 surface aggregations having mutually different distances from the reference point Po of the 3D model 3dm of the target component are virtually set. In FIG. 19, the outer edge of T1 virtual spherical surfaces (also referred to as virtual spherical surfaces) is indicated by a thin two-dot chain line. The T1 virtual spherical surfaces are virtually generated based on the three-dimensional design information regarding the target component. The T1 virtual spherical surfaces have mutually different distances from the reference point Po of the 3D model 3dm of the target component. Further, each of the T1 virtual spherical surfaces surrounds the 3D model 3dm of the target component centered around the reference point Po of the 3D model 3dm of the target component. In FIG. 19, out of the outer edges of the T1 virtual spherical surfaces Sv1, Sv2, ..., SvT1, illustration of portions other than the outer edges of the three virtual spherical surfaces Sv1, Sv2, SvT1 is omitted. The virtual spherical surface Sv1 is a first virtual spherical surface having a distance D1 from the reference point Po among the T1 virtual spherical surfaces. The virtual spherical surface Sv2 is the second virtual spherical surface having a distance D2 from the reference point Po among the T1 virtual spherical surfaces. The virtual spherical surface SvT1 is a T1-th virtual spherical surface having a distance DT1 from the reference point Po among the T1 virtual spherical surfaces.

In the first shape information acquisition unit 6112, for example, the surface aggregation As1 as illustrated in FIG. 17 is virtually set along each of the T1 virtual spherical surfaces Sv1, Sv2, ..., SvT1 illustrated in FIG. 19. As a result, T1 surface aggregations As1 are virtually set. The T1 surface aggregations As1 have a mutually similar shape enlarged and reduced centered around the reference point Po of the 3D model 3dm of the target component. In other words, the T1 surface aggregations As1 are different in size from each other, but have the same shape and have the same posture with respect to the 3D model 3dm. In addition, in the first shape information acquisition unit 6112, in each of the T1 surface aggregations As1, the first virtual camera position P11 is virtually set for each of the M1 virtual surfaces St1. As a result, M1 first virtual camera positions P11 are virtually set in each of the T1 surface aggregations As1. In other words, M1×T1 first virtual camera positions P11 are virtually set. Then, the first shape information acquisition unit 6112 generates the reference shape information for each of the M1×T1first virtual camera positions P11 assuming a case where the 3D model 3dm of the target component is imaged from each of the M1×T1 first virtual camera positions P11.

### <<First Calculation Unit 6113>>

The first calculation unit 6113 calculates, for each of the plurality of first virtual camera positions P11, a numerical value indicating a matching degree between information (real shape information) related to the two-dimensional shape of the object captured in the real image and the reference shape information.

Here, as described above, for example, a case is assumed where the reference shape information generated for each of the M1×T1 first virtual camera positions P11 is acquired by the first shape information acquisition unit 6112. In this case, the first calculation unit 6113 calculates, for each of the M1×T1 first virtual camera positions P11 described above, a numerical value indicating a matching degree between the information (real shape information) related to the two-dimensional shape of the object captured in the real image and the reference shape information.

Here, calculation processing of the numerical value indicating the matching degree between the real shape information and the reference shape information for one first virtual camera position P11 in the first calculation unit 6113 will be described with one specific example.

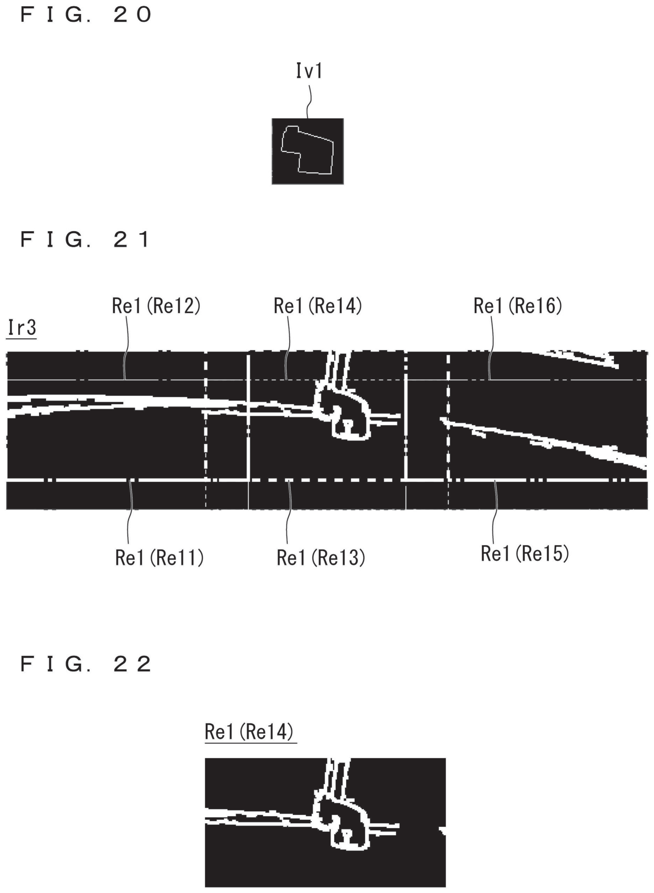

FIGS. 20 to 24 are views for describing a specific example of calculation processing of the numerical value indicating the matching degree between the real shape information and the reference shape information for one first virtual camera position P11.

FIG. 20 illustrates an example of the reference image Iv1 as the reference shape information for one first virtual camera position P11. For example, the first calculation unit 6113 calculates a numerical value indicating a matching degree of the two-dimensional shape of the contour between the reference image Iv1 as the reference shape information acquired by the first shape information acquisition unit 6112 and the edge image Ir3 (FIG. 8) as the real shape information acquired by the image processing unit 59.

When the numerical value indicating the matching degree between the edge image as the real shape information and the reference image as the reference shape information is calculated for each first virtual camera position P11, the first calculation unit 6113 performs, for example, [processing 1a] processing of detecting a deviation amount of the direction of the two-dimensional shape of the contour corresponding to the deviation of the roll angle γ between the edge image and the reference image, [processing 1b] processing of rotating the edge image according to the deviation of the roll angle γ, and [processing 1c] processing of detecting a position of a region having a maximum matching degree with the reference image for the rotated edge image, in this order.

In the processing 1a, for example, the first calculation unit 6113 detects a deviation amount in the direction of the two-dimensional shape of the contour between the edge image as the real shape information and the reference image as the reference shape information using a rotation-invariant phase-only correlation (RIPOC) method. The deviation amount in the direction of the two-dimensional shape of the contour is the deviation amount in the rotation direction of the contour on the image. Here, for example, as illustrated in FIG. 21, the first calculation unit 6113 divides the edge image Ir3 as the real shape information input from the image processing unit 59 into a plurality of comparison target regions Re1, and calculates, for each of the comparison target regions Re1, a deviation amount γ1 in the rotation direction in which the matching degree of the contour can become the highest with the reference image as the reference shape information using the RIPOC method. The deviation amount γ1 corresponds to the roll angle γ at which the matching degree between the reference image as the reference shape information and the edge image as the real shape information can be further increased.

The size of each comparison target region Re1 is set to, for example, one time or more and several times or less (for example, three times) in each of the longitudinal direction and the lateral direction based on the size of the reference image as the reference shape information. In addition, the plurality of comparison target regions Re1 is set so as to partially overlap each other in the adjacent comparison target regions Re1. In the example of FIG. 21, six comparison target regions Re1 are set in the edge image Ir3. In

FIG. 21, the outer edge of the first comparison target region Re11, which is the first comparison target region Re1, is indicated by a thick one-dot chain line. The outer edge of the second comparison target region Re12, which is the second comparison target region Re1, is indicated by a thin one-dot chain line. The outer edge of the third comparison target region Re13, which is the third comparison target region Re1, is indicated by a thick broken line. The outer edge of the fourth comparison target region Re14, which is the fourth comparison target region Re1, is indicated by a thin broken line. The outer edge of the fifth comparison target region Re15, which is the fifth comparison target region Re1, is indicated by a thick two-dot chain line. The outer edge of the sixth comparison target region Re16, which is the sixth comparison target region Re1, is indicated by a thin two-dot chain line. Here, the first calculation unit 6113 detects, among the plurality of comparison target regions Re1, one comparison target region Re1 in which the matching degree of the contour can be the highest with the reference image as the reference shape information, and the deviation amount γ1 in the rotation direction in which the matching degree of the contour can be the highest between the one comparison target region Re1 and the reference image as the reference shape information.

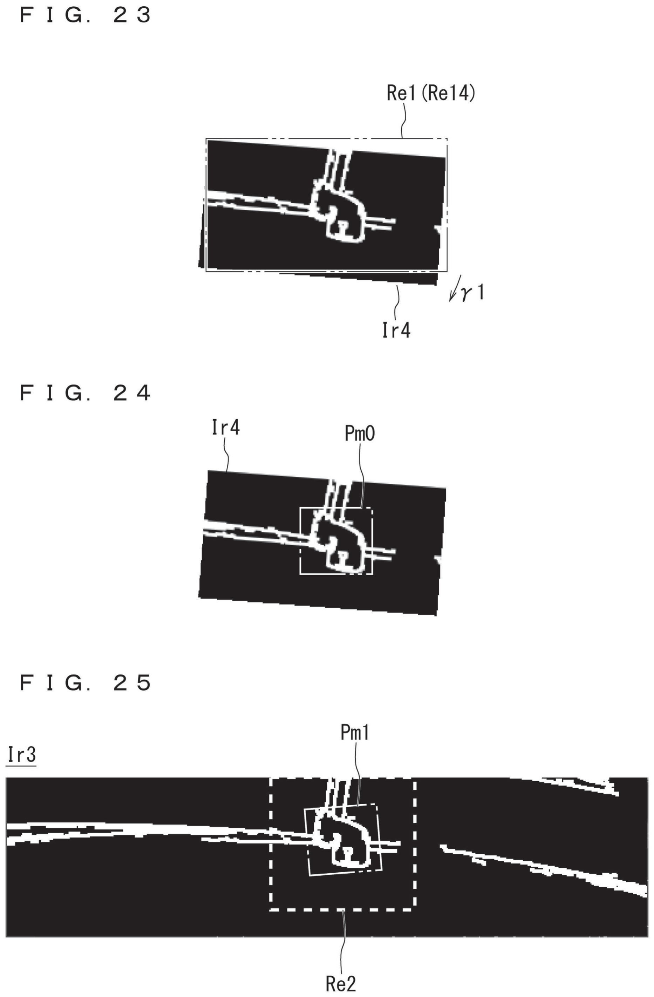

In the processing 1b, for example, the first calculation unit 6113 rotates the edge image as the real shape information so as to correct the deviation amount γ1 detected in the processing 1a. As a result, the rotated edge image is generated, and the orientation is matched between the two-dimensional shape of the contour in the edge image as the real shape information and the two-dimensional shape of the contour in the reference image as the reference shape information. Here, for example, the first calculation unit 6113 rotates the edge image of the comparison target region Re1 detected in the processing 1a so as to correct the deviation amount γ1 detected in the processing 1a. As a result, the rotated edge image is generated, and the orientation is matched between the two-dimensional shape of the contour in the comparison target region Re1 constituting the real shape information and the two-dimensional shape of the contour in the reference image as the reference shape information. FIGS. 22 and 23 illustrate, for example, a state in which the edge image of the fourth comparison target region Re14, which is the fourth comparison target region Re1 illustrated in FIG. 22, is rotated by the deviation amount γ1 to generate the rotated edge image Ir4 illustrated in FIG. 23. In FIG. 23, the outer edge of the edge image of the fourth comparison target region Re14 before rotation is schematically illustrated by a thin two-dot chain line.

In the processing 1c, for example, the first calculation unit 6113 performs template matching using the reference image as the reference shape information on the rotated edge image related to the real shape information generated in the processing 1b. Here, for example, the first calculation unit 6113 scans the reference image in the rotated edge image, and detects the position of a region where the matching degree (similarity) between each partial region in the rotated edge image and the reference image becomes maximum. As a result, in the edge image as the real shape information, a position (also referred to as a matching candidate position) of a region where the matching degree with the two-dimensional shape of the contour of the 3D model 3dm of the target component in the reference image as the reference shape information becomes maximum can be detected. Here, although the matching degree (similarity) described here is not particularly limited, for example, the matching degree of the reference image with respect to a partial region of the rotated edge image in a case where each partial region of the rotated edge image and the reference image are superimposed is adopted as the matching degree. This matching degree (similarity) may be expressed using, for example, a known score (also referred to as a matching score) indicating the matching degree (similarity) such as a sum of squared differences of pixel values, a sum of absolute differences of pixel values, normalized cross-correlation, or zero mean normalized cross-correlation. Furthermore, here, when the template matching is performed, a numerical value indicating the matching degree (similarity) in a case where the matching degree (similarity) between the partial region in the rotated edge image and the reference image becomes maximum is calculated as a numerical value indicating the matching degree between the edge image as the real shape information and the reference image as the reference shape information for the first virtual camera position P11. In other words, for each first virtual camera position P11, the matching degree in a case where the matching degree of the reference image with respect to the partial region in the rotated edge image becomes maximum is set as the matching degree between the edge image as the real shape information and the reference image as the reference shape information. Here, the numerical value indicating the matching degree may be, for example, a matching score indicating the matching degree. For example, as the matching degree between the edge image as the real shape information and the reference image as the reference shape information increases, the matching score indicating the matching degree may increase, or the matching score indicating the matching degree may decrease. In other words, there are a case where it can be evaluated that the matching degree between the edge image as the real shape information and the reference image as the reference shape information is higher as the matching score indicating the matching degree is larger, and a case where it can be evaluated that the matching degree between the edge image as the real shape information and the reference image as the reference shape information is higher as the matching score indicating the matching degree is smaller. Hereinafter, in a case where no particular condition is described, it is assumed that the matching score indicating the matching degree increases as the matching degree between the edge image as the real shape information and the reference image as the reference shape information increases. In FIG. 24, an outer edge of an example of the matching candidate position Pm0 in the edge image Ir4 is indicated by a thin two-dot chain line.

### <<First Detection Unit 6114>>

Based on the calculation result by the first calculation unit 6113, the first detection unit 6114 detects, among the plurality of first virtual camera positions P11, a virtual camera position with high matching degree which is the first virtual camera position P11 having the highest matching degree between the information (real shape information) related to the two-dimensional shape of the object captured in the real image capturing the target component and the reference shape information. Here, for example, among the plurality of first virtual camera positions P11, the first virtual camera position P11 having the highest matching score between the information (real shape information) related to the two-dimensional shape of the object captured in the real image and the reference shape information, calculated by the first calculation unit 6113, may be detected as the virtual camera position with high matching degree.

Here, as described above, for example, a case is assumed where the reference shape information generated for each of the M1xT1 first virtual camera positions P11 is acquired by the first shape information acquisition unit 6112. In this case, the first detection unit 6114 detects the virtual camera position with high matching degree, which is a virtual camera position having the highest matching degree between the real shape information and the reference shape information, among the M1xT1 first virtual camera positions P11, based on the calculation result by the first calculation unit 6113. Here, for example, among the M1xT1 first virtual camera positions P11, the first virtual camera position P11 having the highest matching score between the information (real shape information) related to the two-dimensional shape of the object captured in the real image and the reference shape information, calculated by the first calculation unit 6113, may be detected as the virtual camera position with high matching degree.

In addition, for example, when the virtual camera position with high matching degree is detected, the first detection unit 6114 also detects the matching candidate position detected for the virtual camera position with high matching degree by the first calculation unit 6113 as a target component candidate position.

### <3-2-2-2. Second Search Processing Unit>

The second search processing unit 612 includes, for example, a collation target region setting unit 6121, a divided surface generation unit 6122, a second shape information generation unit 6123, a second calculation unit 6124, and a second detection unit 6125 as a plurality of functional processing units. The collation target region setting unit 6121, the divided surface generation unit 6122, the second shape information generation unit 6123, the second calculation unit 6124, and the second detection unit 6125 are implemented, for example, by the CPU reading and executing the program Pg1 stored in the storage unit 45b in the control unit 45 (more specifically, the arithmetic unit 45a). In the second search processing unit 612, for example, the secondary search processing can be implemented by the divided surface generation unit 6122, the second shape information generation unit 6123, the second calculation unit 6124, and the second detection unit 6125.

### <<Collation Target Region Setting Unit 6121>>

The collation target region setting unit 6121 sets a region (also referred to as a collation target region) to be used for matching (collation) processing in the second calculation unit 6124 in the edge image as the real shape information acquired by the contour extraction unit 592 based on the target component candidate position detected by the first detection unit 6114. As a result, the amount of calculation of the processing of the second calculation unit 6124 is reduced, and efficiency of the processing in the second calculation unit 6124 can be improved.

FIG. 25 is a view illustrating a specific example in which a collation target region Re2 is set in the edge image Ir3 as the real shape information acquired by the contour extraction unit 592. As illustrated in FIG. 25, with respect to the edge image Ir3, a region including a target component candidate position Pm1 detected by the first detection unit 6114 and having a size larger than the target component candidate position Pm1 is set as the collation target region Re2. In FIG. 25, the outer edge of the target component candidate position Pm1 is indicated by a thin two-dot chain line, and the outer edge of the collation target region Re2 is indicated by a thick broken line. The size of the collation target region Re2 is set to, for example, more than one time and several times or less (for example, double) in each of the longitudinal direction and the lateral direction based on the size of the target component candidate position Pm1.

### <<Divided Surface Generation Unit 6122>>

The divided surface generation unit 6122 generates a plurality of virtual surfaces (also referred to as virtual divided surfaces) after division by dividing a virtual surface with high matching degree which is a virtual surface in which the virtual camera position with high matching degree detected by the first detection unit 6114 is virtually set among the plurality of virtual surfaces St1. The plurality of virtual surfaces St1 constitutes the surface aggregation As1 and is located along a virtual spherical surface surrounding the 3D model 3dm of the target component centered around the reference point Po of the 3D model 3dm of the target component.

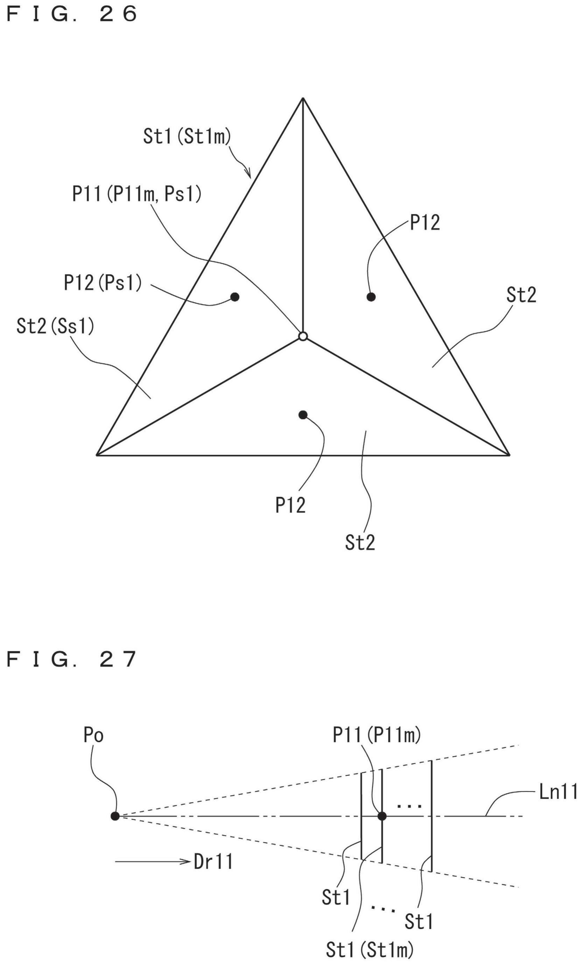

FIG. 26 is a view schematically illustrating a specific example in which the virtual surface with high matching degree St1m is divided into a plurality of virtual divided surfaces St2. FIG. 26 illustrates a specific example of a case where each of the plurality of virtual surfaces St1 constituting the surface aggregation As1 is a triangular surface as illustrated in FIG. 17. In FIG. 26, the virtual camera position with high matching degree P11m is indicated by a white circle. As illustrated in FIG. 26, the divided surface generation unit 6122 divides the virtual surface with high matching degree St1m into three virtual divided surfaces St2 as a plurality of virtual divided surfaces St2 by, for example, three line segments connecting each of three vertices of the virtual surface with high matching degree St1m and the virtual camera position with high matching degree P11m. As a result, the virtual surface can be easily divided.

Here, as described above, for example, a case is assumed where the reference shape information generated for each of the M1×T1 first virtual camera positions P11 is acquired by the first shape information acquisition unit 6112. In this case, the divided surface generation unit 6122 divides, according to the same rule, each of T2 (T2 is a natural number equal to or greater than 2) virtual surfaces St1 including the virtual surface with high matching degree St1m and having mutually different distances from the reference point Po of the 3D model 3dm of the target component among the M1 virtual surfaces St1 in each of the T1 surface aggregations As1. As a result, the divided surface generation unit 6122 generates M2 (M2 is a natural number equal to or greater than 2) virtual divided surfaces St2 for each of the T2 virtual surfaces St1, thereby generating M2×T2 virtual divided surfaces St2. Here, the T2 virtual surfaces St1 are a plurality of virtual surfaces St1 that intersects a line passing through the reference point Po and the virtual camera position with high matching degree P11m on a side of the virtual camera position with high matching degree P11m with respect to the reference point Po of the 3D model 3dm of the target component and has mutually different distances from the reference point Po. T2 is, for example, equal to T1. T2 may be, for example, less than T1.

FIG. 27 is an image diagram schematically illustrating an example of the T2 virtual surfaces St1. In FIG. 27, a direction (also referred to as a first direction) Dr11 from the reference point Po of the 3D model 3dm of the target component toward the virtual camera position with high matching degree P11m is indicated by an arrow indicated by a thin line, and a line Ln11 passing through the reference point Po and the virtual camera position with high matching degree P11m is indicated by a thin two-dot chain line. In FIG. 27, a line passing through the reference point Po and passing through the outer edge of each of the T2 virtual surfaces St1 is indicated by a thin broken line. In FIG. 27, three virtual surfaces St1 among the T2 virtual surfaces St1 are illustrated for convenience, and illustration of the other virtual surfaces St1 is omitted. As illustrated in FIG. 27, each of the T2 virtual surfaces St1 intersects with a portion of the line Ln11 located closer to the virtual camera position with high matching degree P11m than the reference point Po.

Here, the T2 virtual surfaces St1 have similar shapes enlarged and reduced in the radial direction with respect to the reference point Po of the 3D model 3dm of the target component. When viewed from the reference point Po of the 3D model 3dm of the target component, each of the T2 virtual surfaces St1 is divided by lines having similar shapes enlarged and reduced in the radial direction around the reference point Po, thereby generating M2×T2 virtual divided surfaces St2. As a result, in the T2 virtual surfaces St1, for each of the M2 virtual divided surfaces St2, there are T2 virtual divided surfaces St2 having similar shapes enlarged and reduced in the radial direction around the reference point Po of the 3D model 3dm of the target component.

The same rule related to the division of the T2 virtual surfaces St1 described above may be a rule of dividing each of the T2 virtual surfaces St1 in the same shape as viewed from the reference point Po of the 3D model 3dm of the target component. In other words, the same rule related to the division of the T2 virtual surfaces St1 may be a rule of dividing each of the T2 virtual surfaces St1 by a line having a similar shape enlarged and reduced in the radial direction around the reference point Po as viewed from the reference point Po of the 3D model 3dm of the target component. In other words, the same rule related to the division of the T2 virtual surfaces St1 may be a rule of dividing the T2 virtual surfaces St1 such that T2 virtual surfaces having the same shape are generated for each of the M2 virtual divided surfaces between the T2 virtual surfaces St1 as viewed from the reference point Po of the 3D model 3dm of the target component. The same rule related to the division of the T2 virtual surfaces St1 described above may be, for example, a rule of dividing a surface to be divided (also referred to as a division target surface) into a plurality of surfaces by a plurality of line segments respectively connecting the center point of the division target surface and all vertices of the division target surface. As a result, the division target surface can be easily divided. As illustrated in FIG. 17, if each of the plurality of virtual surfaces St1 constituting the surface aggregation As1 is a triangular surface, M2 may be 3. In this case, each of the T2 virtual surfaces St1 may be divided into three virtual divided surfaces St2 by three line segments connecting each of three vertices and the first virtual camera position P11, similarly to the virtual surface with high matching degree St1m illustrated in FIG. 26. As a result, each of the T2 virtual surfaces St1 can be divided into three triangular virtual divided surfaces St2.

### <<Second Shape Information Generation Unit 6123>>

Based on the three-dimensional design information regarding the target component stored in the storage unit 45b, the second shape information generation unit 6123 generates reference shape information for each of the plurality of second virtual camera positions P12 assuming a case where the 3D model 3dm of the target component is imaged from each of the plurality of virtual camera positions (second virtual camera positions) P12 set to the plurality of virtual divided surfaces St2 generated by the divided surface generation unit 6122. The plurality of second virtual camera positions P12 is a plurality of virtual camera positions set by virtually setting one virtual camera position for each of the plurality of virtual divided surfaces St2 generated by the divided surface generation unit 6122. Here, the reference shape information is information generated based on the three-dimensional design information regarding the target component, and is information regarding the two-dimensional shape of the 3D model 3dm of the target component in the virtual image that can be acquired by imaging from the virtual camera position (more specifically, the second virtual camera position P12). The virtual image can be generated, for example, by projecting the 3D model 3dm onto a virtual plane by processing such as rendering.

In each virtual divided surface St2, for example, the second virtual camera position P12 is virtually set at a predetermined position of the virtual divided surface St2. For example, the position of the center of the virtual divided surface St2 is adopted as the predetermined position. For example, the center of gravity of the virtual divided surface St2 is adopted as the center of the virtual divided surface St2. For example, as illustrated in FIG. 26, the second virtual camera position P12 is set on each virtual divided surface St2. If each of the plurality of virtual divided surfaces St2 is a triangular surface, the center of the virtual divided surface St2 may be, for example, the center of gravity of the triangle or the incenter of the triangle.

For example, for each of the plurality of second virtual camera positions P12 illustrated in FIG. 26, the second shape information generation unit 6123 generates reference shape information related to the two-dimensional shape of the 3D model 3dm of the target component in the virtual image that can be acquired by imaging from the second virtual camera position P12. In this event, the imaging direction by the virtual camera capturing the 3D model 3dm of the target component from the second virtual camera position P12 is set to a direction from the second virtual camera position P12 toward the reference point Po of the 3D model 3dm of the target component. The roll angle γ that defines the posture of the virtual camera that images the 3D model 3dm of the target component from the second virtual camera position P12 is set to, for example, zero (0) degrees.

Here, as described above, for example, a case is assumed where the reference shape information generated for each of the M1×T1 first virtual camera positions P11 is acquired by the first shape information acquisition unit 6112. In this case, for example, the second shape information generation unit 6123 generates the reference shape information for each of the M2×T2 second virtual camera positions P12 assuming a case where the 3D model 3dm of the target component is imaged from each of the M2×T2 second virtual camera positions P12 based on the three-dimensional design information regarding the target component stored in the storage unit 45b. The M2×T2 second virtual camera positions P12 are M2×T2 virtual camera positions set by virtually setting one virtual camera position for each of the M2×T2 virtual divided surfaces St2 described above. Here, the reference shape information is information generated based on the three-dimensional design information regarding the target component, and is information regarding the two-dimensional shape of the 3D model 3dm of the target component in the virtual image that can be acquired by imaging from the second virtual camera position P12. The virtual image can be generated, for example, by projecting the 3D model 3dm onto a virtual plane by processing such as rendering.

Here, the M2×T2 second virtual camera positions P12 are constituted with, for example, the second virtual camera positions P12 respectively set to the plurality of virtual divided surfaces St2 as illustrated in FIG. 26 in each of the T2 virtual surfaces St1.

### <<Second Calculation Unit 6124>>

The second calculation unit 6124 calculates, for each of the plurality of second virtual camera positions P12, a numerical value indicating a matching degree between the information (real shape information) related to the two-dimensional shape of the object captured in the real image and the reference shape information.

As described above, in the first embodiment, the second virtual camera position P12 is set to each of the plurality of virtual surfaces (virtual divided surfaces) St2 generated by dividing the virtual surface (virtual surface with high matching degree) St1m in which the virtual camera position with high matching degree P11m detected by the first detection unit 6114 among the plurality of virtual surfaces St1 is set, and the numerical value indicating the matching degree between the real shape information and the reference shape information is calculated for each second virtual camera position P12. Thus, the virtual surface with high matching degree St1m in the primary search processing is not irrelevant to the plurality of virtual divided surfaces St2 in the secondary search processing, and increase in at least one of the number or the area of the plurality of virtual divided surfaces St2 can be reduced. As a result, an amount of calculation for recognizing the posture of the target component captured in the real image can be reduced. As a result, the substrate processing apparatus 1 can efficiently recognize the posture of the target component.

As described above, for example, a case is assumed where the reference shape information generated for each of the M1×T1 first virtual camera positions P11 is acquired by the first shape information acquisition unit 6112. In this case, the second calculation unit 6124 calculates, for each of the M2×T2 second virtual camera positions P12, a numerical value indicating a matching degree between the information (real shape information) related to the two-dimensional shape of the object captured in the real image and the reference shape information. As a result, for example, in a case where a distance between the camera CM and the target component changes due to movement of the target component or an error in the position where the target component is attached in the substrate processing apparatus 1, the posture of the target component can be efficiently recognized.

Here, calculation processing of the numerical value indicating the matching degree between the real shape information and the reference shape information for one second virtual camera position P12 in the second calculation unit 6124 will be described with one specific example.

A specific example of the calculation processing of the numerical value indicating the matching degree between the real shape information and the reference shape information for one second virtual camera position P12 in the second calculation unit 6124 can be similar to the specific example of the calculation processing of the numerical value indicating the matching degree between the real shape information and the reference shape information for one first virtual camera position P11 in the first calculation unit 6113 described above.

However, for example, the second calculation unit 6124 calculates the numerical value indicating the matching degree of the two-dimensional shape of the contour between the reference image as the reference shape information acquired by the second shape information generation unit 6123 and the collation target region Re2 (FIG. 25) set in the edge image as the real shape information by the collation target region setting unit 6121.

When the numerical value indicating the matching degree between the edge image as the real shape information and the reference image as the reference shape information is calculated for each of the second virtual camera positions P12, the second calculation unit 6124 performs, for example, [processing 2a] processing of detecting a deviation amount of the direction of the two-dimensional shape of the contour corresponding to the deviation of the roll angle γ between the edge image and the reference image, [processing 2b] processing of rotating the edge image according to the deviation of the roll angle γ, and [processing 2c] processing of detecting a position of a region having the maximum matching degree with the reference image for the rotated edge image in this order.

In the processing 2a, similarly to the processing 1a, for example, the second calculation unit 6124 detects the deviation amount in the direction of the two-dimensional shape of the contour using the RIPOC method between the edge image as the real shape information and the reference image as the reference shape information. The deviation amount in the direction of the two-dimensional shape of the contour is the deviation amount in the rotation direction of the contour on the image. Here, the second calculation unit 6124 detects a deviation amount γ2 in the rotation direction in which the matching degree of the contour can become the highest between the collation target region Re2 (FIG. 25) set in the edge image as the real shape information by the collation target region setting unit 6121 and the reference image as the reference shape information using, for example, the RIPOC method. The deviation amount γ2 corresponds to the roll angle γ at which the matching degree between the reference image as the reference shape information and the edge image as the real shape information can be further increased.

In the processing 2b, similarly to the processing 1b, for example, the second calculation unit 6124 rotates the edge image as the real shape information so as to correct the deviation amount γ2 detected in the processing 2a. As a result, the rotated edge image is generated, and the orientation is matched between the two-dimensional shape of the contour in the edge image as the real shape information and the two-dimensional shape of the contour in the reference image as the reference shape information. Here, for example, the second calculation unit 6124 rotates the edge image of the collation target region Re2 so as to correct the deviation amount γ2 detected in the processing 2a. As a result, the rotated edge image is generated, and the orientation is matched between the two-dimensional shape of the contour in the collation target region Re2 constituting the real shape information and the two-dimensional shape of the contour in the reference image as the reference shape information.

In the processing 2c, similarly to the processing 1c, for example, the second calculation unit 6124 performs template matching using the reference image as the reference shape information for the rotated edge image related to the real shape information generated in the processing 2b. Here, for example, the second calculation unit 6124 scans the reference image in the rotated edge image, and detects a position of a region where the matching degree (similarity) between each partial region in the rotated edge image and the reference image becomes maximum. As a result, in the edge image as the real shape information, the position (matching candidate position) of the region having the maximum matching degree with the two-dimensional shape of the contour of the 3D model 3dm of the target component in the reference image as the reference shape information can be detected. Here, although the matching degree (similarity) described here is not particularly limited, for example, the matching degree of the reference image with respect to a partial region of the rotated edge image in a case where each partial region of the rotated edge image and the reference image are superimposed is adopted as the matching degree. For example, as described above, the matching degree (similarity) may be expressed using a known score (matching score) indicating the matching degree (similarity) such as a sum of squares of differences of pixel values, a sum of absolute values of differences of pixel values, normalized cross-correlation, or zero-mean normalized cross-correlation. Furthermore, here, when the template matching is performed, a numerical value indicating the matching degree (similarity) in a case where the matching degree (similarity) between the partial region in the rotated edge image and the reference image becomes maximum is calculated as a numerical value indicating the matching degree between the edge image as the real shape information and the reference image as the reference shape information for the second virtual camera position P12. In other words, for each second virtual camera position P12, the matching degree in a case where the matching degree of the reference image with respect to the partial region in the rotated edge image becomes maximum is set as the matching degree between the edge image as the real shape information and the reference image as the reference shape information. Here, the numerical value indicating the matching degree may be, for example, a matching score indicating the matching degree.

### <<Second Detection Unit 6125>>

The second detection unit 6125 detects a virtual camera position having the highest matching degree between the information (real shape information) related to the two-dimensional shape of the object captured in the real image capturing the target component and the reference shape information, among the virtual camera position with high matching degree P11m detected by the first detection unit 6114 and the M2×T2 second virtual camera positions P12 described above. As a result, the virtual camera position with a higher matching degree between the real shape information and the reference shape information can be efficiently detected.

Here, for example, the matching score calculated for the virtual camera position with high matching degree P11m by the first calculation unit 6113 and the matching score calculated for each of the M2×T2 second virtual camera positions P12 by the second calculation unit 6124 are compared. Then, for example, among the virtual camera position with high matching degree P11m and the M2×T2 second virtual camera positions P12, the virtual camera position at which the matching score calculated between the information (real shape information) related to the two-dimensional shape of the object captured in the real image capturing the target component and the reference shape information becomes the highest is detected.

Here, the virtual camera position detected by the second detection unit 6125 is the virtual camera position detected first by the second detection unit 6125 in the search processing for the target component. The virtual camera position detected first by the second detection unit 6125 is, for example, a first reference virtual camera position to be described later. In the present specification, the X-th (X is a natural number) means the X-th when the search processing is performed for one target component.

### <3-2-2-3. Repetition of Unit Processing>

For example, the search processing unit 61 executes one or more times of n-th unit processing (n is a natural number equal to or greater than 2) after executing the first unit processing for the target component by the second search processing unit 612.

The unit processing means specific processing in a case where the same or similar specific processing is repeated two or more times. In the first embodiment, the first unit processing and the n-th unit processing are similar processing, and the n-th unit processing of each time is substantially the same processing. Here, the first unit processing means the first time of the unit processing in two or more times of the unit processing. A variable n which is a natural number equal to or greater than 2 in the n-th unit processing indicates the number of times the unit processing is being performed. In other words, the n-th unit processing means the n-th time of the unit processing in two or more times of the unit processing. For example, if the variable n is 2, the n-th unit processing means the second unit processing that is the second time of the unit processing. From another point of view, when one or more times of the n-th unit processing are executed, the variable n which is a natural number equal to or greater than 2 is set to 2 as an initial value, and each time the n-th unit processing is executed, 1 is added to the variable n to perform the next n-th unit processing. Then, that the search processing unit 61 executes one or more times of the n-th unit processing after executing the first unit processing means that, for example, the search processing unit 61 sequentially executes the first unit processing, the second unit processing, and .... For example, in a case where the search processing unit 61 executes one time of the n-th unit processing after executing the first unit processing, the search processing unit 61 sequentially executes the first unit processing and the second unit processing. In a case where the search processing unit 61 executes two times of the n-th unit processing after executing the first unit processing, the search processing unit 61 sequentially executes the first unit processing, the second unit processing, and the third unit processing.

For example, when the secondary search processing for the target component is performed in the search processing unit 61, the first unit processing is started in response to the first detection of the virtual camera position by the second detection unit 6125.

Here, the search processing unit 61 sequentially performs the following first A processing, the following first B processing, the following first C processing, and the following first D processing in the first unit processing by the second search processing unit 612. In addition, in the n-th unit processing, the search processing unit 61 sequentially performs the following n-th A processing, the following n-th B processing, the following n-th C processing, and the following n-th D processing by the second search processing unit 612. In other words, the search processing unit 61 sequentially performs the following n-th A processing, the following n-th B processing, the following n-th C processing, and the following n-th D processing by the second search processing unit 612 in each of the one or more times of the n-th unit processing.

### <<First A Processing>>

The first A processing is processing in which the divided surface generation unit 6122 generates first M3×T3 (M3 and T3 are each a natural number equal to or greater than 2) virtual divided surfaces. In this processing, the divided surface generation unit 6122 divides each of T3 virtual divided surfaces (also referred to as first T3 virtual divided surfaces), which are a plurality of virtual divided surfaces generated by dividing each of the T2 virtual surfaces St1, according to the same rule. As a result, the divided surface generation unit 6122 generates M3 virtual divided surfaces (also referred to as first M3 virtual divided surfaces) for each of the first T3 virtual divided surfaces, thereby generating the first M3×T3 virtual divided surfaces. Here, the first T3 virtual divided surfaces include a virtual divided surface (also referred to as a first reference virtual divided surface) including the first reference virtual camera position that is a virtual camera position detected first by the second detection unit 6125 and having mutually different distances from the reference point Po of the 3D model 3dm of the target component. Furthermore, the first T3 virtual divided surfaces are a plurality of virtual divided surfaces intersecting a line passing through the reference point Po and the first reference virtual camera position on a side of the first reference virtual camera position with respect to the reference point Po of the 3D model 3dm of the target component. T3 is, for example, equal to T2. T3 may be, for example, less than T2.

Here, the same rule related to the division of the first T3 virtual divided surfaces may be a rule of dividing each of the first T3 virtual divided surfaces in the same shape as viewed from the reference point Po of the 3D model 3dm of the target component. In other words, the same rule related to the division of the first T3 virtual divided surfaces may be a rule of dividing each of the first T3 virtual divided surfaces by a line having a similar shape enlarged and reduced in a radial direction around the reference point Po as viewed from the reference point Po of the 3D model 3dm of the target component. In other words, the same rule related to the division of the first T3 virtual divided surfaces may be a rule of dividing the first T3 virtual divided surfaces such that T3 virtual divided surfaces having the same shape are generated for each of the M3 virtual divided surfaces between the first T3 virtual divided surfaces as viewed from the reference point Po of the 3D model 3dm of the target component. As a result, in the first T3 virtual divided surfaces St2, for each of the M3 virtual divided surfaces, there are T3 virtual divided surfaces having similar shapes enlarged and reduced in the radial direction around the reference point Po of the 3D model 3dm of the target component. The same rule related to the division of the first T3 virtual divided surfaces may be, for example, a rule of dividing the division target surface to be divided into a plurality of surfaces by a plurality of line segments respectively connecting a center point of the division target surface and all vertices of the division target surface. As a result, the division target surface can be easily divided. M3 may be, for example, equal to M2. If each of the first T3 virtual divided surfaces St2 is a triangular surface, M3 may be three.

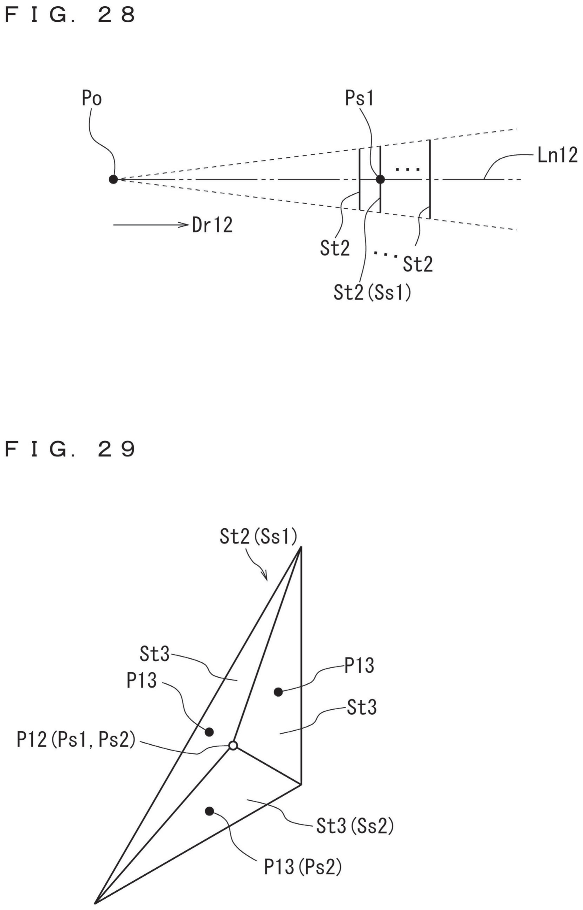

FIG. 28 is an image diagram schematically illustrating an example of the first T3 virtual divided surfaces St2. In FIG. 28, a direction (also referred to as a second direction) Dr12 from the reference point Po of the 3D model 3dm of the target component toward the first reference virtual camera position Ps1 is indicated by a thin arrow, and a line Ln12 passing through the reference point Po and the first reference virtual camera position Ps1 is indicated by a thin two-dot chain line. In FIG. 28, a line passing through the reference point Po and passing through the outer edge of each of the first T3 virtual divided surfaces St2 is indicated by a thin broken line. In FIG. 28, for convenience, three virtual divided surfaces St2 among the first T3 virtual divided surfaces St2 are illustrated, and illustration of the other virtual divided surfaces St2 is omitted. As illustrated in FIG. 28, each of the first T3 virtual divided surfaces St2 intersects with a portion of the line Ln12 located closer to the first reference virtual camera position Ps1 than the reference point Po. Here, the first T3 virtual divided surfaces St2 have similar shapes enlarged and reduced in the radial direction with respect to the reference point Po of the 3D model 3dm of the target component.

In the first A processing, the method of generating the first M3×T3 virtual divided surfaces is different according to the virtual camera position (first reference virtual camera position) Ps1 detected first by the second detection unit 6125. More specifically, the first M3×T3 virtual divided surfaces are generated using different methods between a case where the first reference virtual camera position Ps1 is the second virtual camera position P12 of any one of the above-described M2×T2 second virtual camera positions P12 (also referred to as a first first case) and a case where the first reference virtual camera position Ps1 is the virtual camera position with high matching degree P11m detected by the first detection unit 6114 (also referred to as a first second case).

### <<<First First Case>>>

In a case where the second detection unit 6125 detects any one of the above-described M2×T2 second virtual camera positions P12 as the first reference virtual camera position Ps1, the matching degree between the information (real shape information) related to the two-dimensional shape of the object captured in the real image capturing the target component and the reference shape information is higher for any one of the above-described M2×T2 second virtual camera positions P12 than the virtual camera position with high matching degree P11m.

In other words, the matching degree between the real shape information and the reference shape information for any one of the M2×T2 second virtual camera positions P12 calculated by the second calculation unit 6124 in the first unit processing of the secondary search processing is higher than the matching degree between the real shape information and the reference shape information for the virtual camera position with high matching degree P11m calculated by the first calculation unit 6113 in the primary search processing. More specifically, for example, the matching score indicating the matching degree between the real shape information and the reference shape information for any one of the M2×T2 second virtual camera positions P12 calculated by the second calculation unit 6124 in the first unit processing of the secondary search processing is higher than the matching score indicating the matching degree between the real shape information and the reference shape information for the virtual camera position with high matching degree P11m calculated by the first calculation unit 6113 in the primary search processing.

Thus, the divided surface generation unit 6122 generates the first M3×T3 virtual divided surfaces while setting the second virtual camera position P12 at which the matching degree between the information (real shape information) related to the two-dimensional shape of the object captured in the real image capturing the target component and the reference shape information becomes the highest as the first reference virtual camera position Ps1 which is a reference for next dividing the virtual surface among the M2×T2 second virtual camera positions P12 described above. As a result, for example, in the secondary search processing, a virtual camera position at which the matching degree between the reference shape information and the real shape information becomes higher can be searched for.

Here, the divided surface generation unit 6122 divides each of the first T3 virtual divided surfaces St2 including the virtual divided surface (first reference virtual divided surface) including the first reference virtual camera position Ps1 and having mutually different distances from the reference point Po of the 3D model 3dm of the target component among the M2×T2 virtual divided surfaces St2 described above according to the same rule. As a result, the divided surface generation unit 6122 generates the first M3×T3 virtual divided surfaces by generating the first M3 virtual divided surfaces, which are the M3 virtual divided surfaces, for each of the first T3 virtual divided surfaces St2. The first T3 virtual divided surfaces St2 are a plurality of virtual divided surfaces St2 intersecting a line Ln12 passing through the reference point Po and the first reference virtual camera position Ps1 on a side of the first reference virtual camera position Ps1 with respect to the reference point Po of the 3D model 3dm of the target component.

Here, the same rule related to the division of the first T3 virtual divided surfaces St2 may be, as described above, a rule of dividing the division target surface to be divided into a plurality of surfaces by a plurality of line segments respectively connecting a center point of the division target surface and all vertices of the division target surface. For example, if each of the first T3 virtual divided surfaces St2 is a triangle, each of the first T3 virtual divided surfaces St2 may be divided into three virtual divided surfaces which are M3 virtual divided surfaces by three line segments connecting each of three vertices and the second virtual camera position P12. By this means, each of the first T3 virtual divided surfaces St2 can be divided into three triangular virtual divided surfaces. As a result, the first M3×T3 virtual divided surfaces as M3×T3 virtual divided surfaces are generated.

Here, for example, a case is assumed where one second virtual camera position P12 on the upper left among the three second virtual camera positions P12 in FIG. 26 is detected as the first reference virtual camera position Ps1. In this case, as illustrated in FIG. 26, the virtual divided surface St2 including the first reference virtual camera position Ps1 among the three virtual divided surfaces St2 generated by dividing the virtual surface St1 is the first reference virtual divided surface Ss1.

FIG. 29 is a view for describing a first specific example in which the first M3×T3 virtual divided surfaces St3 are generated by the divided surface generation unit 6122. FIG. 29 illustrates the division of the first reference virtual divided surface Ss1 among the first T3 virtual divided surfaces St2. The first T3 virtual divided surfaces St2 are T3 virtual divided surfaces St2 among the M2×T2 virtual divided surfaces St2 generated by the divided surface generation unit 6122. The first T3 virtual divided surfaces St2 have similar shapes enlarged and reduced in the radial direction around the reference point Po of the 3D model 3dm of the target component. FIG. 29 illustrates a specific example of a case where each of the plurality of virtual surfaces St1 constituting the surface aggregation As1 is a triangular surface as illustrated in FIG. 17. In FIG. 29, the first reference virtual camera position Ps1 is indicated by a white circle. As illustrated in FIG. 29, for example, the divided surface generation unit 6122 divides the first reference virtual divided surface Ss1 into three virtual divided surfaces St3 as the first M3 virtual divided surfaces by three line segments connecting three vertices of the first reference virtual divided surface Ss1 and the first reference virtual camera position Ps1.

Here, when viewed from the reference point Po of the 3D model 3dm of the target component, each of the first T3 virtual divided surfaces St2 is divided by lines having similar shapes enlarged and reduced in the radial direction around the reference point Po, whereby the first M3×T3 virtual divided surfaces St3 are generated. As a result, in the first T3 virtual divided surfaces St2, for each of the M3 virtual divided surfaces St3, there are T3 virtual divided surfaces St3 having similar shapes enlarged and reduced in the radial direction around the reference point Po of the 3D model 3dm of the target component. M3 may be, for example, equal to M2.

As illustrated in FIG. 17, if each of the plurality of virtual surfaces St1 constituting the surface aggregation As1 is a triangular surface, M3 may be 3 as with M2. In this case, each of the first T3 virtual divided surfaces St2 may be divided into three virtual divided surfaces St3 by three line segments connecting each of three vertices and the second virtual camera position P12, similarly to the first reference virtual divided surface Ss1 illustrated in FIG. 29. As a result, each of the T3 virtual divided surfaces St2 can be divided into three triangular virtual divided surfaces St3. As a result, the first M3×T3 virtual divided surfaces St3 as the M3×T3 virtual divided surfaces are generated.

### <<<First Second Case>>>

In a case where the virtual camera position with high matching degree P11m is detected as the first reference virtual camera position Ps1 by the second detection unit 6125, the matching degree between the information (real shape information) related to the two-dimensional shape of the object captured in the real image capturing the target component and the reference shape information is higher for the virtual camera position with high matching degree P11m than any of the above-described M2×T2 second virtual camera positions P12.

In other words, the matching degree between the real shape information and the reference shape information for all of the M2×T2 second virtual camera positions P12 calculated by the second calculation unit 6124 in the secondary search processing is lower than the matching degree between the real shape information and the reference shape information for the virtual camera position with high matching degree P11m calculated by the first calculation unit 6113 in the primary search processing. More specifically, for example, the matching score indicating the matching degree between the real shape information and the reference shape information for all of the M2×T2 second virtual camera positions P12 calculated by the second calculation unit 6124 in the secondary search processing is lower than the matching score indicating the matching degree between the real shape information and the reference shape information for the virtual camera position with high matching degree P11m calculated by the first calculation unit 6113 in the primary search processing.

Thus, the divided surface generation unit 6122 generates the first M3×T3 virtual divided surfaces St3 using the virtual camera position with high matching degree P11m as the first reference virtual camera position Ps1 that is a reference for next division of the virtual surface. As a result, for example, in the secondary search processing, a virtual camera position at which the matching degree between the reference shape information and the real shape information becomes higher can be searched for.

Here, the divided surface generation unit 6122 divides each of the first T3 virtual divided surfaces including the virtual divided surface (first reference virtual divided surface) including the first reference virtual camera position Ps1 that is the same as the virtual camera position with high matching degree P11m and having mutually different distances from the reference point Po of the 3D model 3dm of the target component according to the same rule. As a result, the divided surface generation unit 6122 generates the first M3×T3 virtual divided surfaces by generating the first M3 virtual divided surfaces as M3 virtual divided surfaces for each of the first T3 virtual divided surfaces. The first T3 virtual divided surfaces are a plurality of virtual divided surfaces intersecting a line Ln12 passing through the reference point Po and the first reference virtual camera position Ps1 on a side of the first reference virtual camera position Ps1 with respect to the reference point Po of the 3D model 3dm of the target component.

Here, the first reference virtual divided surface is set according to a predetermined rule. For example, if each of the plurality of virtual surfaces St1 constituting the surface aggregation As1 is a triangular surface, one virtual divided surface including the virtual camera position with high matching degree P11m among the four triangular virtual divided surfaces generated by dividing the virtual surface with high matching degree St1m among the plurality of virtual surfaces St1 by lines connecting the midpoints of the respective sides may be set as the first reference virtual divided surface Ss1. Here, the midpoint of each side may be, for example, a point slightly shifted from the midpoint of each side.

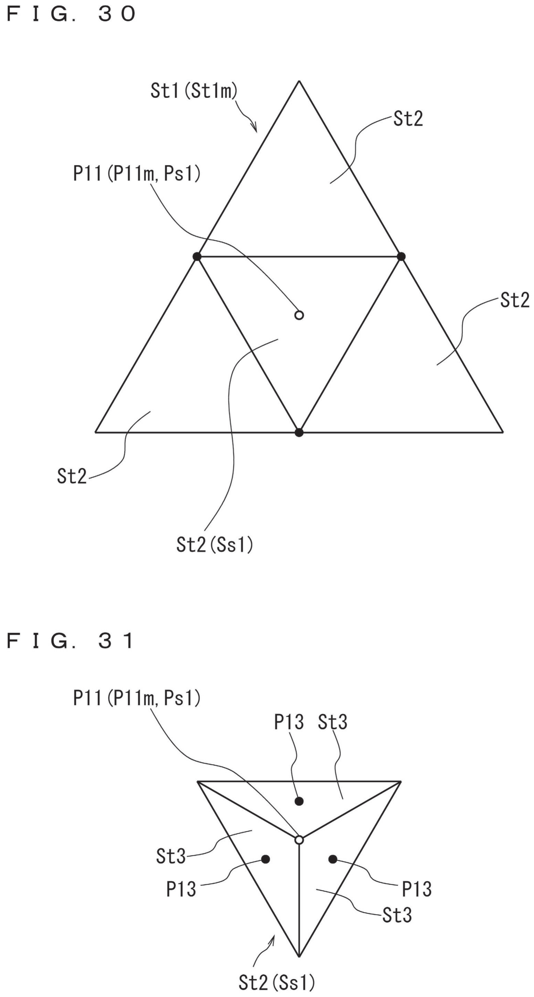

FIGS. 30 and 31 are views for describing a second specific example in which the first M3×T3 virtual divided surfaces St3 are generated by the divided surface generation unit 6122. FIGS. 30 and 31 illustrate a specific example of a case where each of the plurality of virtual surfaces St1 constituting the surface aggregation As1 is a triangular surface as illustrated in FIG. 17. In FIGS. 30 and 31, the virtual camera position with high matching degree P11m as the first reference virtual camera position Ps1 is indicated by a white circle.

Here, among M4 (M4 is a natural number equal to or greater than 2) virtual divided surfaces generated by dividing the virtual surface with high matching degree St1m, a virtual divided surface including the virtual camera position with high matching degree P11m as the first reference virtual camera position Ps1 is the first reference virtual divided surface Ss1. Here, each of the M4 virtual divided surfaces is a surface generated by dividing the virtual surface St1, and thus, each of the M4 virtual divided surfaces is a reset virtual divided surface St2. For example, as illustrated in FIG. 30, the virtual surface with high matching degree St1m is divided by three line segments respectively connecting midpoints of respective sides of the virtual surface with high matching degree St1m, so that four triangular virtual divided surfaces St2 as M4 triangular virtual divided surfaces St2 are generated. Among the four triangular virtual divided surfaces St2, the virtual divided surface St2 including the virtual camera position with high matching degree P11m as the first reference virtual camera position Ps1 is the first reference virtual divided surface Ss1. Here, the midpoint of each side may be, for example, a point slightly shifted from the midpoint of each side.

Here, each of the T3 virtual surfaces St1 among the T2 virtual surfaces St1 is divided according to the same rule as the virtual surface with high matching degree St1m, so that each of the T3 virtual surfaces St1 is divided into M4 virtual divided surfaces St2. From another point of view, when viewed from the reference point Po of the 3D model 3dm of the target component, each of the T3 virtual surfaces St1 is divided by lines having similar shapes enlarged and reduced in the radial direction around the reference point Po, so that M4×T3 virtual divided surfaces St2 are generated. The first T3 virtual divided surfaces St2 including the first reference virtual divided surface Ss1 are a portion of the M4×T3 virtual divided surfaces St2, and have similar shapes enlarged and reduced in the radial direction around the reference point Po of the 3D model 3dm of the target component.

For example, each of the T3 virtual surfaces St1 among the T2 virtual surfaces St1 may be divided by lines respectively connecting the midpoints of the respective sides, similarly to the virtual surface with high matching degree St1m illustrated in FIG. 30. As a result, each of the T3 virtual surfaces St1 can be divided into four triangular virtual divided surfaces St2. From another point of view, when viewed from the reference point Po of the 3D model 3dm of the target component, each of the T3 virtual surfaces St1 is divided by lines having similar shapes enlarged and reduced in the radial direction around the reference point Po, so that 4×T3 virtual divided surfaces St2 are generated. The first T3 virtual divided surfaces St2 including the first reference virtual divided surface Ss1 are a portion of the 4×T3 virtual divided surfaces St2, and have similar shapes enlarged and reduced in the radial direction around the reference point Po of the 3D model 3dm of the target component.

Here, the same rule related to the division of the first T3 virtual divided surfaces may be, for example, a rule of dividing the division target surface to be divided into a plurality of surfaces by a plurality of line segments respectively connecting a center point of the division target surface and all vertices of the division target surface as described above. For example, if each of the first T3 virtual divided surfaces St2 is a triangle, each of the first T3 virtual divided surfaces St2 may be divided into three virtual divided surfaces which are M3 virtual divided surfaces by three line segments connecting each of three vertices and the first virtual camera position P11. By this means, each of the first T3 virtual divided surfaces St2 can be divided into three triangular virtual divided surfaces. As a result, the first M3×T3 virtual divided surfaces as the M3×T3 virtual divided surfaces are generated.

FIG. 31 illustrates the division of the first reference virtual divided surface Ss1 among the first T3 virtual divided surfaces St2. The first T3 virtual divided surfaces St2 have similar shapes enlarged and reduced in the radial direction around the reference point Po of the 3D model 3dm of the target component. As illustrated in FIG. 31, for example, the divided surface generation unit 6122 divides the first reference virtual divided surface Ss1 into three virtual divided surfaces St3 as the first M3 virtual divided surfaces by three line segments connecting each of three vertices of the first reference virtual divided surface Ss1 and the virtual camera position with high matching degree P11m as the first reference virtual camera position Ps1.

Here, when viewed from the reference point Po of the 3D model 3dm of the target component, each of the first T3 virtual divided surfaces St2 is divided by lines having similar shapes enlarged and reduced in the radial direction around the reference point Po, whereby the first M3×T3 virtual divided surfaces St3 are generated. As a result, in the first T3 virtual divided surfaces St2, for each of the M3 virtual divided surfaces St3, there are T3 virtual divided surfaces St3 having similar shapes enlarged and reduced in the radial direction around the reference point Po of the 3D model 3dm of the target component.

As illustrated in FIG. 17, if each of the plurality of virtual surfaces St1 constituting the surface aggregation As1 is a triangular surface, M3 may be 3. In this case, each of the first T3 virtual divided surfaces St2 may be divided into three virtual divided surfaces St3 by three line segments connecting each of the three vertices and the first virtual camera position P11, similarly to the first reference virtual divided surface Ss1 illustrated in FIG. 31. As a result, each of the T3 virtual divided surfaces St2 can be divided into three triangular virtual divided surfaces St3. As a result, the first M3×T3 virtual divided surfaces St3 as the M3×T3 virtual divided surfaces are generated.

### <<First B Processing>>

The first B processing is processing in which the second shape information generation unit 6123 generates reference shape information for each of first M3×T3 third virtual camera positions assuming a case where the 3D model 3dm of the target component is imaged from each of the first M3×T3 third virtual camera positions based on the three-dimensional design information regarding the target component stored in the storage unit 45b. The first M3×T3 third virtual camera positions are M3×T3 virtual camera positions set by virtually setting one virtual camera position for each of the first M3×T3 virtual divided surfaces St3 generated in the first A processing. Here, the reference shape information is information generated based on the three-dimensional design information regarding the target component, and is information regarding the two-dimensional shape of the 3D model 3dm of the target component in the virtual image that can be acquired by imaging the 3D model 3dm of the target component from the virtual camera position. The virtual image can be generated, for example, by projecting the 3D model 3dm onto a virtual plane by processing such as rendering.

In each of the first M3×T3 virtual divided surfaces St3, for example, the third virtual camera position P13 is virtually set at a predetermined position of the virtual divided surface St3. For example, the position of the center of the virtual divided surface St3 is adopted as the predetermined position. For example, the center of gravity of the virtual divided surface St3 is adopted as the center of the virtual divided surface St3. For example, as illustrated in FIG. 29 or 31, the third virtual camera position P13 is set on each virtual divided surface St3. If each of the first M3×T3 virtual divided surfaces St3 is a triangular surface, the center of the virtual divided surface St3 may be, for example, the center of gravity of the triangle or the incenter of the triangle. In FIG. 29 or 31, the third virtual camera position P13 is indicated by a black circle.

For example, for each of the plurality of third virtual camera positions P13 illustrated in FIG. 29 or 31, the second shape information generation unit 6123 generates reference shape information related to the two-dimensional shape of the 3D model 3dm of the target component in the virtual image that can be acquired by imaging the 3D model 3dm of the target component from the third virtual camera position P13. In this event, the imaging direction by the virtual camera imaging the 3D model 3dm of the target component from the third virtual camera position P13 is set to a direction from the third virtual camera position P13 toward the reference point Po of the 3D model 3dm of the target component. The roll angle γ that defines the posture of the virtual camera that images the 3D model 3dm of the target component from the third virtual camera position P13 is set to, for example, zero (0) degrees. Here, for each third virtual camera position P13, for example, the reference image Iv1 as the reference shape information as schematically illustrated in FIG. 10 is generated.

### <<First C Processing>>

The first C processing is processing in which the second calculation unit 6124 calculates, for each of the first M3×T3 third virtual camera positions P13, a numerical value indicating the matching degree between information (real shape information) related to the two-dimensional shape of the object captured in the real image capturing the target component and the reference shape information.

In the first C processing, for example, the second calculation unit 6124 calculates a numerical value indicating the matching degree of the two-dimensional shape of the contour between the reference image as the reference shape information generated by the second shape information generation unit 6123 in the first B processing and the collation target region Re2 (FIG. 25) set in the edge image as the real shape information by the collation target region setting unit 6121.

In the first C processing, when a numerical value indicating the matching degree between the edge image as the real shape information and the reference image as the reference shape information is calculated for each of the third virtual camera positions P13, the second calculation unit 6124 performs, for example, [processing 2a1] processing of detecting a deviation amount of the orientation of the two-dimensional shape of the contour corresponding to the deviation of the roll angle γ between the edge image and the reference image, [processing 2b1] processing of rotating the edge image according to the deviation of the roll angle γ, and [processing 2c1] processing of detecting a position of a region having the maximum matching degree with the reference image for the rotated edge image in this order.

In the processing 2a1, similarly to the processing 2a, for example, the second calculation unit 6124 detects the deviation amount in the direction of the two-dimensional shape of the contour using the RIPOC method between the edge image as the real shape information and the reference image as the reference shape information. The deviation amount in the direction of the two-dimensional shape of the contour is the deviation amount in the rotation direction of the contour on the image. Here, the second calculation unit 6124 calculates the deviation amount γ21 in the rotation direction in which the matching degree of the contour can become the highest between the collation target region Re2 (FIG. 25) set in the edge image as the real shape information by the collation target region setting unit 6121 and the reference image as the reference shape information using, for example, the RIPOC method. The deviation amount γ21 corresponds to the roll angle γ at which the matching degree between the reference image as the reference shape information and the edge image as the real shape information can be further increased.

In the processing 2b1, similarly to the processing 2b, for example, the second calculation unit 6124 rotates the edge image as the real shape information so as to correct the deviation amount γ21 detected in the processing 2a1. As a result, the rotated edge image is generated, and the orientation is matched between the two-dimensional shape of the contour in the edge image as the real shape information and the two-dimensional shape of the contour in the reference image as the reference shape information. Here, for example, the second calculation unit 6124 rotates the edge image of the collation target region Re2 so as to correct the deviation amount γ21 detected in the processing 2a1. As a result, the rotated edge image is generated, and the orientation is matched between the two-dimensional shape of the contour in the collation target region Re2 constituting the real shape information and the two-dimensional shape of the contour in the reference image as the reference shape information.

In the processing 2c1, similarly to the processing 2c, for example, the second calculation unit 6124 performs template matching using the reference image as the reference shape information for the rotated edge image related to the real shape information generated in the processing 2b1. Here, for example, the second calculation unit 6124 scans the reference image in the rotated edge image, and detects a position of a region where the matching degree (similarity) between each partial region in the rotated edge image and the reference image becomes maximum. As a result, in the edge image as the real shape information, the position (matching candidate position) of the region having the maximum matching degree with the two-dimensional shape of the contour of the 3D model 3dm of the target component in the reference image can be detected. Furthermore, here, when the template matching is performed, a numerical value indicating the matching degree (similarity) in a case where the matching degree (similarity) between the partial region in the rotated edge image and the reference image becomes maximum is calculated as a numerical value indicating the matching degree between the edge image as the real shape information and the reference image as the reference shape information for the third virtual camera position P13. In other words, for each third virtual camera position P13, the matching degree in a case where the matching degree of the reference image with respect to the partial region in the rotated edge image becomes maximum is set as the matching degree between the edge image as the real shape information and the reference image as the reference shape information. Here, the numerical value indicating the matching degree may be, for example, a matching score indicating the matching degree.

### <<First D Processing>>

The first D processing is processing in which the second detection unit 6125 detects a second reference virtual camera position, which is a virtual camera position having the highest matching degree between the information (real shape information) related to the two-dimensional shape of the object captured in the real image obtained by capturing the target component and the reference shape information, among the first reference virtual camera position Ps1 and the first M3×T3 third virtual camera positions P13.

Here, for example, the matching score calculated for the first reference virtual camera position Ps1 and the matching score calculated for each of the first M3×T3 third virtual camera positions P13 by the second calculation unit 6124 in the first C processing are compared. Then, for example, among the first reference virtual camera position Ps1 and the first M3×T3 third virtual camera positions P13, the virtual camera position having the highest matching score calculated between the information (real shape information) related to the two-dimensional shape of the object captured in the real image obtained by capturing the target component and the reference shape information is detected as the second reference virtual camera position.

### <<n-th A Processing>>

The n-th A processing is processing in which the divided surface generation unit 6122 generates n-th M3×T3 virtual divided surfaces. In this processing, the divided surface generation unit 6122 divides each of T3 virtual divided surfaces (also referred to as n-th T3 virtual divided surfaces) generated by dividing each of the (n-1)-th T3 virtual divided surfaces according to the same rule. As a result, the divided surface generation unit 6122 generates M3 virtual divided surfaces (also referred to as the n-th M3 virtual divided surfaces) for each of the n-th T3 virtual divided surfaces, thereby generating n-th M3×T3 virtual divided surfaces. Here, the n-th T3 virtual divided surfaces include a virtual divided surface (also referred to as an n-th reference virtual divided surface) including an n-th reference virtual camera position that is a virtual camera position detected n-th by the second detection unit 6125, and having mutually different distances from the reference point Po of the 3D model 3dm of the target component. Furthermore, the n-th T3 virtual divided surfaces are a plurality of virtual divided surfaces intersecting a line passing through the reference point Po and the n-th reference virtual camera position on a side of the n-th reference virtual camera position with respect to the reference point Po of the 3D model 3dm of the target component.

Here, the same rule related to the division of the n-th T3 virtual divided surfaces may be a rule of dividing each of the n-th T3 virtual divided surfaces in the same shape when viewed from the reference point Po of the 3D model 3dm of the target component. In other words, the same rule related to the division of the n-th T3 virtual divided surfaces may be a rule of dividing each of the n-th T3 virtual divided surfaces by a line having a similar shape enlarged and reduced in the radial direction around the reference point Po when viewed from the reference point Po of the 3D model 3dm of the target component. In other words, the same rule related to the division of the n-th T3 virtual divided surfaces may be a rule of dividing the n-th T3 virtual divided surfaces such that T3 virtual divided surfaces having the same shape are generated for each of the M3 virtual divided surfaces between the n-th T3 virtual divided surfaces as viewed from the reference point Po of the 3D model 3dm of the target component. The same rule related to the division of the n-th T3 virtual divided surfaces may be, for example, a rule of dividing a division target surface to be divided into a plurality of surfaces by a plurality of line segments respectively connecting the center point of the division target surface and all vertices of the division target surface. As a result, the division target surface can be easily divided.

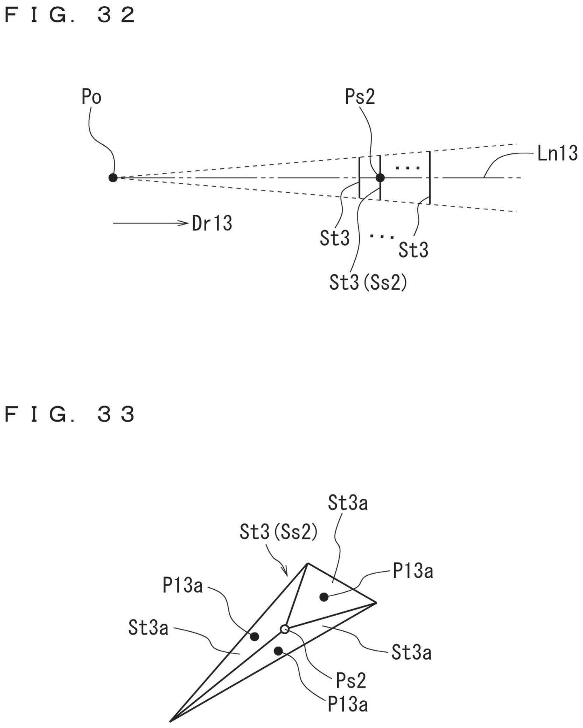

FIG. 32 is an image diagram schematically illustrating an example of second T3 virtual divided surfaces St3 as a specific example of the n-th T3 virtual divided surfaces St3. In FIG. 32, a direction (also referred to as a third direction) Dr13 from the reference point Po of the 3D model 3dm of the target component toward the second reference virtual camera position Ps2 is indicated by a thin arrow, and a line Ln13 passing through the reference point Po and the second reference virtual camera position Ps2 is indicated by a thin two-dot chain line. In FIG. 32, a line passing through the reference point Po and passing through the outer edge of each of the second T3 virtual divided surfaces St3 is indicated by a thin broken line. In FIG. 32, for convenience, three virtual divided surfaces St3 among the second T3 virtual divided surfaces St3 are illustrated, and illustration of the other virtual divided surfaces St3 is omitted. As illustrated in FIG. 32, each of the second T3 virtual divided surfaces St3 intersects with a portion of the line Ln13 located closer to the second reference virtual camera position Ps2 than the reference point Po. Here, the second T3 virtual divided surfaces St3 have similar shapes enlarged and reduced in the radial direction around the reference point Po of the 3D model 3dm of the component to be searched.

In this n-th A processing, the method of generating the n-th M3×T3 virtual divided surfaces is different according to the virtual camera position (n-th reference virtual camera position) detected n-th by the second detection unit 6125. More specifically, the method of generating the n-th M3×T3 virtual divided surfaces is different between a case where the n-th reference virtual camera position is any one of the (n-1)-th M3×T3 third virtual camera positions (also referred to as an n-th first case) and a case where the n-th reference virtual camera position is the (n-1)-th reference virtual camera position (also referred to as an n-th second case).

### <<<n-th First Case>>>

In a case where the third virtual camera position of any one of the (n-1)-th M3×T3 third virtual camera positions described above is detected as the n-th reference virtual camera position by the second detection unit 6125, for any one of the (n-1)-th M3×T3 third virtual camera positions described above, the matching degree between the information (real shape information) related to the two-dimensional shape of the object captured in the real image obtained by capturing the target component and the reference shape information is higher than that for the (n-1)-th reference virtual camera position.

For example, the matching score indicating the matching degree between the real shape information and the reference shape information for any one of the (n-1)-th M3×T3 third virtual camera positions is higher than the matching score indicating the matching degree between the real shape information and the reference shape information for the (n-1)-th reference virtual camera position.

Thus, among the (n-1)-th M3×T3 third virtual camera positions described above, the divided surface generation unit 6122 generates the n-th M3×T3 virtual divided surfaces, using the third virtual camera position having the highest matching degree between the information (real shape information) related to the two-dimensional shape of the object captured in the real image obtained by capturing the target component and the reference shape information, as the n-th reference virtual camera position that is a reference for next dividing the virtual surface. As a result, for example, in the secondary search processing, the virtual camera position at which the matching degree between the reference shape information and the real shape information is further increased can be searched.

Here, the divided surface generation unit 6122 divides each of the n-th T3 virtual divided surfaces including the n-th reference virtual divided surface that is a virtual divided surface including the n-th reference virtual camera position among the (n-1)-th M3×T3 virtual divided surfaces described above and having mutually different distances from the reference point Po of the 3D model 3dm of the target component according to the same rule. As a result, the divided surface generation unit 6122 generates the n-th M3×T3 virtual divided surfaces by generating the n-th M3 virtual divided surfaces as the M3 virtual divided surfaces for each of the n-th T3 virtual divided surfaces. The n-th T3 virtual divided surfaces are a plurality of virtual divided surfaces intersecting a line passing through the reference point Po and the n-th reference virtual camera position on a side of the n-th reference virtual camera position with respect to the reference point Po of the 3D model 3dm of the target component.

Here, the same rule related to the division of the n-th T3 virtual divided surfaces may be, for example, a rule of dividing a division target surface to be divided into a plurality of surfaces by a plurality of line segments respectively connecting the center point of the division target surface and all vertices of the division target surface as described above. For example, if each of the n-th T3 virtual divided surfaces is a triangle, each of the n-th T3 virtual divided surfaces may be divided into three virtual divided surfaces that are the n-th M3 virtual divided surfaces by three line segments connecting each of three vertices and an (n-1)-th third virtual camera position. As a result, each of the n-th T3 virtual divided surfaces can be divided into three triangular virtual divided surfaces. As a result, the n-th M3×T3 virtual divided surfaces as the M3×T3 virtual divided surfaces are generated.

Here, for example, a case is assumed where one third virtual camera position P13 on the lower side among the three third virtual camera positions P13 in FIG. 29 is detected as the second reference virtual camera position Ps2. In this case, as illustrated in FIG. 29, the virtual divided surface St3 including the second reference virtual camera position Ps2 among the three virtual divided surfaces St3 generated by dividing the virtual divided surface St2 is the second reference virtual divided surface Ss2.

FIG. 33 is a view for describing a first specific example in which the second M3×T3 virtual divided surfaces St3a as an example of the n-th M3×T3 virtual divided surfaces are generated by the divided surface generation unit 6122. FIG. 33 illustrates the division of the second reference virtual divided surface Ss2 among the second T3 virtual divided surfaces St3. The second T3 virtual divided surfaces St3 are T3 virtual divided surfaces St3 among the first M3×T3 virtual divided surfaces St3 generated by the divided surface generation unit 6122. The second T3 virtual divided surfaces St3 have similar shapes enlarged and reduced in the radial direction around the reference point Po of the 3D model 3dm of the target component. FIG. 33 illustrates a specific example of a case where each of the plurality of virtual surfaces St1 constituting the surface aggregation As1 is a triangular surface as illustrated in FIG. 17. In FIG. 33, the second reference virtual camera position Ps2 is indicated by a white circle. As illustrated in FIG. 33, the divided surface generation unit 6122 divides the second reference virtual divided surface Ss2 into three virtual divided surfaces St3a as the second M3 virtual divided surfaces, for example, by three line segments connecting each of three vertices of the second reference virtual divided surface Ss2 and the second reference virtual camera position Ps2.

Here, when viewed from the reference point Po of the 3D model 3dm of the target component, each of the second T3 virtual divided surfaces St3 is divided by lines having similar shapes enlarged and reduced in the radial direction around the reference point Po, whereby the second M3×T3 virtual divided surfaces St3a are generated. As a result, in the second T3 virtual divided surfaces St3, for each of the M3 virtual divided surfaces St3a, there are T3 virtual divided surfaces St3a having similar shapes enlarged and reduced in the radial direction around the reference point Po of the 3D model 3dm of the target component.

As illustrated in FIG. 17, if each of the plurality of virtual surfaces St1 constituting the surface aggregation As1 is a triangular surface, each of the second T3 virtual divided surfaces St3 may be divided into three virtual divided surfaces St3a by three line segments connecting each of three vertices and the third virtual camera position P13, similarly to the second reference virtual divided surface Ss2 illustrated in FIG. 33. As a result, each of the second T3 virtual divided surfaces St3 can be divided into three triangular virtual divided surfaces St3a. As a result, the second 3×T3 virtual divided surfaces St3a as the M3×T3 virtual divided surfaces are generated.

### <<<n-th Second Case>>>

In a case where the (n-1)-th reference virtual camera position is detected as the n-th reference virtual camera position by the second detection unit 6125, for the (n-1)-th reference virtual camera position, the matching degree between the information (real shape information) related to the two-dimensional shape of the object captured in the real image obtained by capturing the target component and the reference shape information is higher than the matching degree of any of the (n-1)-th M3×T3 third virtual camera positions described above.

In other words, the matching degree between the real shape information and the reference shape information for all of the (n-1)-th M3×T3 third virtual camera positions calculated by the second calculation unit 6124 in the unit processing of the (n-1)-th is lower than the matching degree between the real shape information and the reference shape information for the (n-1)-th reference virtual camera position calculated by the first calculation unit 6113 or the second calculation unit 6124. More specifically, for example, the matching score indicating the matching degree between the real shape information and the reference shape information for all of the (n-1)-th M3×T3 third virtual camera positions calculated by the second calculation unit 6124 in the (n-1)-th unit processing is lower than the matching score indicating the matching degree between the real shape information and the reference shape information for the (n-1)-th reference virtual camera position calculated by the first calculation unit 6113 or the second calculation unit 6124.

Thus, the divided surface generation unit 6122 sets the (n-1)-th reference virtual camera position as the n-th reference virtual camera position that is a reference for next dividing the virtual divided surface, and generates the n-th M3×T3 virtual divided surfaces. As a result, for example, in the secondary search processing, the virtual camera position at which the matching degree between the reference shape information and the real shape information is further increased can be searched.

Here, the divided surface generation unit 6122 divides, according to the same rule, each of n-th T3 virtual divided surfaces including a virtual divided surface (n-th reference virtual divided surface) including an n-th reference virtual camera position that is the same as the (n-1)-th reference virtual camera position and having mutually different distances from the reference point Po of the 3D model 3dm of the target component. As a result, the divided surface generation unit 6122 generates the n-th M3×T3 virtual divided surfaces by generating the n-th M3 virtual divided surfaces as the M3 virtual divided surfaces for each of the n-th T3 virtual divided surfaces. The n-th T3 virtual divided surfaces are a plurality of virtual divided surfaces intersecting a line passing through the reference point Po and the n-th reference virtual camera position on a side of the n-th reference virtual camera position with respect to the reference point Po of the 3D model 3dm of the target component.

Here, the n-th reference virtual divided surface is set according to a predetermined rule.

For example, in a case where the variable n is 2, if each of the M2×T2 virtual divided surfaces St2 is a triangular surface, a virtual divided surface including the second reference virtual camera position Ps2 among four triangular virtual divided surfaces generated by dividing the first reference virtual divided surface Ss1 among the M2×T2 virtual divided surfaces St2 by lines connecting the midpoints of the respective sides may be set as the second reference virtual divided surface. Here, the midpoint of each side may be, for example, a point slightly shifted from the midpoint of each side.

Furthermore, for example, in a case where the variable n is equal to or greater than 3, if each of (n-2)-th M3×T3 virtual divided surfaces is a triangular surface, a virtual divided surface including the n-th reference virtual camera position among four triangular virtual divided surfaces generated by dividing a (n-1)-th reference virtual divided surface among the (n-2)-th M3×T3 virtual divided surfaces by three line segments respectively connecting midpoints of respective sides may be set as the n-th reference virtual divided surface. Here, the midpoint of each side may be, for example, a point slightly shifted from the midpoint of each side.

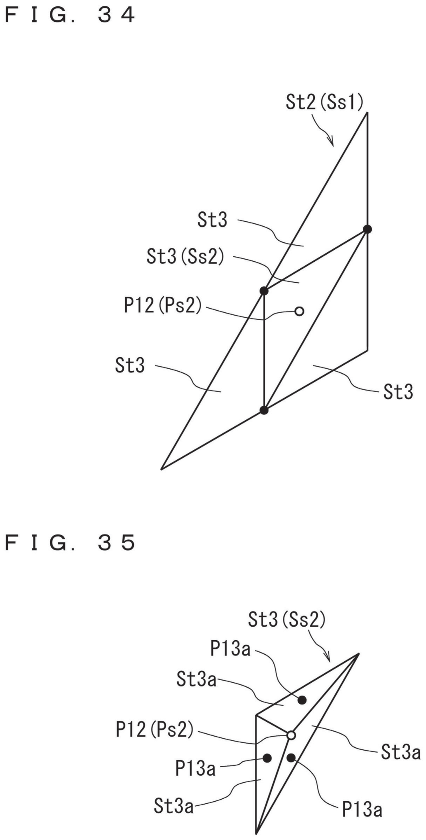

FIGS. 34 and 35 are views for describing a second specific example in which the second M3×T3 virtual divided surface St3a as an example of the n-th M3×T3 virtual divided surface is generated by the divided surface generation unit 6122. FIGS. 34 and 35 illustrate a specific example of a case where each of the M2×T2 virtual divided surfaces St2 described above is a triangular surface. In FIGS. 34 and 35, the second reference virtual camera position Ps2 is indicated by a white circle.

Here, among the M4 virtual divided surfaces generated by dividing the first reference virtual divided surface Ss1, the virtual divided surface including the second reference virtual camera position Ps2 becomes the second reference virtual divided surface Ss2. Here, each of the M4 virtual divided surfaces is a surface generated by dividing the virtual divided surface St2, and thus, each of the M4 virtual divided surfaces is a reset virtual divided surface St3. For example, as illustrated in FIG. 34, the first reference virtual divided surface Ss1 is divided by three line segments respectively connecting midpoints of respective sides of the first reference virtual divided surface Ss1, so that four triangular virtual divided surfaces St3 as M4 triangular virtual divided surfaces St3 are generated. Then, among the four triangular virtual divided surfaces St3, one virtual divided surface St3 including the second reference virtual camera position Ps2 becomes the second reference virtual divided surface Ss2.

Here, each of the above-described T3 virtual divided surfaces St2 is divided according to the same rule as the first reference virtual divided surface Ss1, so that each of the T3 virtual divided surfaces St2 is divided into M4 virtual divided surfaces St3. From another point of view, when viewed from the reference point Po of the 3D model 3dm of the target component, each of the T3 virtual divided surfaces St2 is divided by lines having similar shapes enlarged and reduced in the radial direction around the reference point Po, and thereby M4×T3 virtual divided surfaces St3 are generated. Then, the second T3 virtual divided surfaces St3 including the second reference virtual divided surface Ss2 are a portion of the M4×T3 virtual divided surfaces St3, and have shapes similar to each other enlarged and reduced in the radial direction around the reference point Po of the 3D model 3dm of the target component.

For example, each of the T3 virtual divided surfaces St2 may be divided by three line segments respectively connecting midpoints of respective sides, similarly to the first reference virtual divided surface Ss1 illustrated in FIG. 34. As a result, each of the T3 virtual divided surfaces St2 can be divided into four triangular virtual divided surfaces St3. From another point of view, when viewed from the reference point Po of the 3D model 3dm of the target component, each of the T3 virtual divided surfaces St2 is divided by lines having similar shapes enlarged and reduced in the radial direction around the reference point Po, and thereby 4×T3 virtual divided surfaces St3 are generated. Then, the second T3 virtual divided surfaces St3 including the second reference virtual divided surface Ss2 are a portion of the 4×T3 virtual divided surfaces St3, and have shapes similar to each other enlarged and reduced in the radial direction around the reference point Po of the 3D model 3dm of the target component.

Here, the same rule related to the division of the n-th T3 virtual divided surfaces may be, for example, a rule of dividing a division target surface to be divided into a plurality of surfaces by a plurality of line segments respectively connecting the center point of the division target surface and all vertices of the division target surface as described above. For example, in a case where the variable n is 2, if each of the second T3 virtual divided surfaces St3 is a triangle, each of the second T3 virtual divided surfaces St3 can be divided into three virtual divided surfaces which are M3 virtual divided surfaces by three line segments connecting each of three vertices and the center position (for example, the position of the center of gravity) as a predetermined position. As a result, each of the second T3 virtual divided surfaces St3 can be divided into three triangular virtual divided surfaces. As a result, the second M3×T3 virtual divided surfaces as the M3×T3 virtual divided surfaces are generated.

FIG. 35 illustrates the division of the second reference virtual divided surface Ss2 among the second T3 virtual divided surfaces St3. The second T3 virtual divided surfaces St3 have similar shapes enlarged and reduced in the radial direction around the reference point Po of the 3D model 3dm of the target component. As illustrated in FIG. 35, the divided surface generation unit 6122 divides the second reference virtual divided surface Ss2 into three virtual divided surfaces St3a as the second M3 virtual divided surfaces, for example, by three line segments connecting each of three vertices of the second reference virtual divided surface Ss2 and the second reference virtual camera position Ps2.

Here, when viewed from the reference point Po of the 3D model 3dm of the target component, each of the second T3 virtual divided surfaces St3 is divided by lines having similar shapes enlarged and reduced in the radial direction around the reference point Po, whereby the second M3×T3 virtual divided surfaces St3a are generated. As a result, in the second T3 virtual divided surfaces St3, for each of the M3 virtual divided surfaces St3a, there are T3 virtual divided surfaces St3a having similar shapes enlarged and reduced in the radial direction around the reference point Po of the 3D model 3dm of the target component.

As illustrated in FIG. 17, if each of the plurality of virtual surfaces St1 constituting the surface aggregation As1 is a triangular surface, each of the second T3 virtual divided surfaces St3 may be divided into three virtual divided surfaces St3a by three line segments connecting each of three vertices and the second virtual camera position P12, similarly to the second reference virtual divided surface Ss2 illustrated in FIG. 35. As a result, each of the second T3 virtual divided surfaces St3 can be divided into three triangular virtual divided surfaces St3a. As a result, the second M3×T3 virtual divided surfaces St3a as the M3×T3 virtual divided surfaces are generated.

Furthermore, for example, in a case where the variable n is equal to or greater than 3, if each of n-th T3 virtual divided surfaces is a triangle, each of the n-th T3 virtual divided surfaces can be divided into three virtual divided surfaces that are the n-th M3 virtual divided surfaces by three line segments connecting each of three vertices and the center position (for example, the position of the center of gravity) as the predetermined position. As a result, each of the n-th T3 virtual surfaces can be divided into three triangular virtual divided surfaces. As a result, the n-th M3×T3 virtual divided surfaces as the M3×T3 virtual divided surfaces are generated.

### <<n-th B Processing>>

The n-th B processing is processing in which the second shape information generation unit 6123 generates the reference shape information for each of n-th M3×T3 third virtual camera positions assuming a case where the 3D model 3dm of the target component is imaged from each of the n-th third virtual camera positions based on the three-dimensional design information regarding the target component stored in the storage unit 45b. The n-th M3×T3 third virtual camera positions are M3×T3 virtual camera positions set by virtually setting one virtual camera position for each of the n-th M3×T3 virtual divided surfaces. Here, the reference shape information is information generated based on the three-dimensional design information regarding the target component, and is information related to the two-dimensional shape of the 3D model 3dm of the target component in the virtual image that can be acquired by imaging the 3D model 3dm of the target component from the virtual camera position. The virtual image can be generated, for example, by projecting the 3D model 3dm onto a virtual plane by processing such as rendering.

For each of the n-th M3×T3 virtual divided surfaces, for example, a third virtual camera position (n-th third virtual camera position) is virtually set at a predetermined position on the virtual divided surface. For example, the position of the center of the virtual divided surface is adopted as the predetermined position. For example, the center of gravity of the virtual divided surface is adopted as the center of the virtual divided surface. For example, in a case where the variable n is 2, the third virtual camera position P13a is set on each virtual divided surface St3a as illustrated in FIG. 33 or 35. If each of the n-th M3×T3 virtual divided surfaces is a triangular surface, the center of the virtual divided surface may be, for example, the center of gravity of the triangle or the incenter of the triangle. In FIGS. 33 and 35, the third virtual camera position P13a is indicated by a black circle.

For example, for each of the n-th M3×T3 third virtual camera positions, the second shape information generation unit 6123 generates reference shape information related to the two-dimensional shape of the 3D model 3dm of the target component in the virtual image that can be acquired by imaging the 3D model 3dm of the target component from the third virtual camera position. In this event, the imaging direction by the virtual camera that images the 3D model 3dm of the target component from each third virtual camera position is set to a direction from the third virtual camera position toward the reference point Po of the 3D model 3dm of the target component. The roll angle γ that defines the posture of the virtual camera that images the 3D model 3dm of the target component from the third virtual camera position is set to, for example, zero (0) degrees. Also here, for each third virtual camera position, for example, a reference image Iv1 as the reference shape information as schematically illustrated in FIG. 10 is generated.

### <<n-th C Processing>>

The n-th C processing is processing in which the second calculation unit 6124 calculates, for each of the n-th M3×T3 third virtual camera positions, a numerical value indicating the matching degree between the information (real shape information) related to the two-dimensional shape of the object captured in the real image capturing the target component and the reference shape information.

In the n-th C processing, for example, the second calculation unit 6124 calculates a numerical value indicating the matching degree of the two-dimensional shape of the contour between the reference image as the reference shape information acquired by the second shape information generation unit 6123 in the n-th B processing and the collation target region Re2 (FIG. 25) set in the edge image as the real shape information by the collation target region setting unit 6121.

In the n-th C processing, when a numerical value indicating the matching degree between the edge image as the real shape information and the reference image as the reference shape information is calculated for each third virtual camera position, for example, the second calculation unit 6124 performs [processing 2an] processing of detecting a deviation amount in the direction of the two-dimensional shape of the contour corresponding to the deviation of the roll angle γ between the edge image and the reference image, [processing 2bn] processing of rotating the edge image according to the deviation of the roll angle γ, and [processing 2cn] processing of detecting a position of a region having the maximum matching degree with the reference image for the rotated edge image, in this order.

In the processing 2an, similarly to the processing 2a1, for example, the second calculation unit 6124 detects the deviation amount in the direction of the two-dimensional shape of the contour between the edge image as the real shape information and the reference image as the reference shape information using the RIPOC method. The deviation amount in the direction of the two-dimensional shape of the contour is the deviation amount in the rotation direction of the contour on the image. Here, the second calculation unit 6124 calculates the deviation amount γ2n in the rotation direction in which the matching degree of the contour can become the highest between the collation target region Re2 (FIG. 25) set in the edge image as the real shape information by the collation target region setting unit 6121 and the reference image as the reference shape information using, for example, the RIPOC method. The deviation amount γ2n corresponds to the roll angle γ at which the matching degree between the reference image as the reference shape information and the edge image as the real shape information can be further increased.

In the processing 2bn, similarly to the processing 2b1, for example, the second calculation unit 6124 rotates the edge image as the real shape information so as to correct the deviation amount γ2n detected in the processing 2an. As a result, the rotated edge image is generated, and the orientation is matched between the two-dimensional shape of the contour in the edge image as the real shape information and the two-dimensional shape of the contour in the reference image as the reference shape information. Here, for example, the second calculation unit 6124 rotates the edge image of the collation target region Re2 so as to correct the deviation amount γ2n detected in the processing 2an. As a result, the rotated edge image is generated, and the orientation is matched between the two-dimensional shape of the contour in the collation target region Re2 constituting the real shape information and the two-dimensional shape of the contour in the reference image as the reference shape information.

In the processing 2cn, similarly to the processing 2c1, for example, the second calculation unit 6124 performs template matching using the reference image as the reference shape information for the rotated edge image related to the real shape information generated in the processing 2bn. Here, for example, the second calculation unit 6124 scans the reference image in the rotated edge image, and detects a position of a region where the matching degree (similarity) between each partial region in the rotated edge image and the reference image becomes maximum. As a result, in the edge image as the real shape information, the position (matching candidate position) of the region having the maximum matching degree with the two-dimensional shape of the contour of the 3D model 3dm of the target component in the reference image can be detected. Furthermore, here, when the template matching is performed, a numerical value indicating the matching degree (similarity) in a case where the matching degree (similarity) between the partial region in the rotated edge image and the reference image becomes maximum is calculated as a numerical value indicating the matching degree between the edge image as the real shape information and the reference image as the reference shape information for the third virtual camera position. In other words, for each third virtual camera position, the matching degree in a case where the matching degree of the reference image with respect to the partial region in the rotated edge image becomes maximum is set as the matching degree between the edge image as the real shape information and the reference image as the reference shape information. Here, the numerical value indicating the matching degree may be, for example, a matching score indicating the matching degree.

### <<n-th D Processing>>

The n-th D processing is processing in which the second detection unit 6125 detects, from the n-th reference virtual camera position and the n-th M3×T3 third virtual camera positions, a virtual camera position having the highest matching degree between the information (real shape information) related to the two-dimensional shape of the object captured in the real image capturing the target component and the reference shape information.

Here, for example, the matching score calculated for the n-th reference virtual camera position and the matching score calculated for each of the n-th M3×T3 third virtual camera positions by the second calculation unit 6124 in the n-th C processing are compared. Then, for example, among the n-th reference virtual camera position and the n-th M3×T3 third virtual camera positions, the virtual camera position having the highest matching score calculated between the information (real shape information) on the two-dimensional shape of the object captured in the real image capturing the target component and the reference shape information is detected.

### <<Effects by Repetition of Unit Processing>>

As described above, when the unit processing is repeatedly executed, each of a plurality of virtual divided surfaces including a virtual divided surface including a virtual camera position at which the matching degree between the real shape information and the reference shape information becomes the highest and having mutually different distances from the reference point Po of the 3D model 3dm of the target component is divided according to the same rule to generate a plurality of virtual divided surfaces in which the next virtual camera position is to be set. As a result, the virtual divided surfaces before the division and the virtual divided surfaces after the division are not irrelevant, and increase in at least one of the number or the area can be reduced for the virtual divided surfaces after the division. As a result, the amount of calculation for recognizing the posture of the target component captured in the real image can be reduced. Thus, in the substrate processing apparatus 1, the posture of the target component can be efficiently recognized.

### <<End of One or More Times of n-th Unit Processing>>

For example, in response to one reference virtual camera position among from the first reference virtual camera position Ps1 to the n-th reference virtual camera position being continuously detected by the second detection unit 6125 as a virtual camera position having the highest matching degree between the real shape information and the reference shape information a predetermined number of times (also referred to as a first predetermined number of times) set in advance, the search processing unit 61 ends execution of the one or more times of the n-th unit processing. The first predetermined number of times may be set to any number of times, for example, two or more times. In this case, in the secondary search processing, even if the unit processing is repeatedly performed to some extent, if the virtual camera position at which the matching degree between the reference shape information and the real shape information becomes higher is not detected, the repetitive execution of the unit processing is ended. As a result, the posture of the target component can be efficiently recognized by the amount of calculation being reduced.

Furthermore, for example, the search processing unit 61 may end execution of one or more times of the n-th unit processing in response to the n-th unit processing being executed a predetermined number of times (also referred to as a second predetermined number of times) set in advance. In other words, the search processing unit 61 may end execution of one or more times of the n-th unit processing in response to the n-th unit processing in one or more times of the n-th unit processing being executed the second predetermined number of times set in advance. The second predetermined number of times may be set to any number of times, for example, one or more times. As a result, the posture of the target component can be efficiently recognized by the amount of calculation being reduced.

Here, for example, for the virtual camera position (also referred to as the virtual camera position with the highest matching degree) having the highest matching degree between the real shape information and the reference shape information detected by the second detection unit 6125 in the last n-th D processing in the executed one or more times of the n-th unit processing, the search processing unit 61 can acquire the latitude α, the longitude β, and the distance D that define the virtual camera position with the highest matching degree and the roll angle γ corresponding to the deviation amount γ2n calculated by the second calculation unit 6124 as a result of the search processing. As a result, the posture of the target component captured in the real image can be recognized. Here, for example, the search processing unit 61 may recognize the latitude α, the longitude β, and the distance D that define the virtual camera position with the highest matching degree, and the roll angle γ corresponding to the deviation amount γ2n calculated by the second calculation unit 6124 for the virtual camera position with the highest matching degree as the result of the search processing, as information (reality information) related to the posture of the target component. In this case, for example, the information (normal information) regarding the posture of the target component based on the three-dimensional design information in a case where a state of the target component is normal, which is used in the abnormality detection unit 63, may also be information regarding the latitude α, the longitude β, the distance D, and the roll angle γ.

In other words, for example, the search processing unit 61 may recognize the information (reality information) related to the posture of the target component to be used by the abnormality detection unit 63 based on the virtual camera position having the highest matching degree between the real shape information and the reference shape information, detected (n+1)-th by the second detection unit 6125 in the last n-th D processing in the executed one or more times of the n-th unit processing. As a result, the reality information related to the posture of the target component can be efficiently recognized, so that an abnormality of the target component can be efficiently detected.

Furthermore, for example, the search processing unit 61 may acquire, as a portion of the result of the search processing, a matching candidate position (also referred to as a final matching position) at which the matching degree (similarity) with the reference image as the reference shape information in the edge image as the real shape information becomes maximum, detected by the second calculation unit 6124 for the virtual camera position with the highest matching degree.

### <4. Specific Example of Processing in Substrate Processing Apparatus>

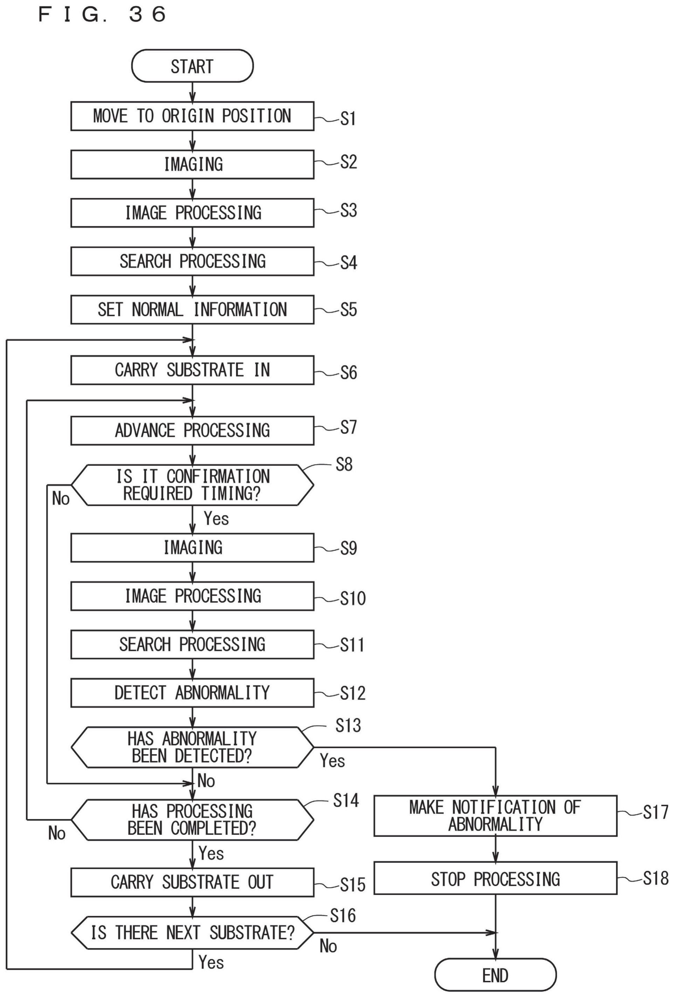

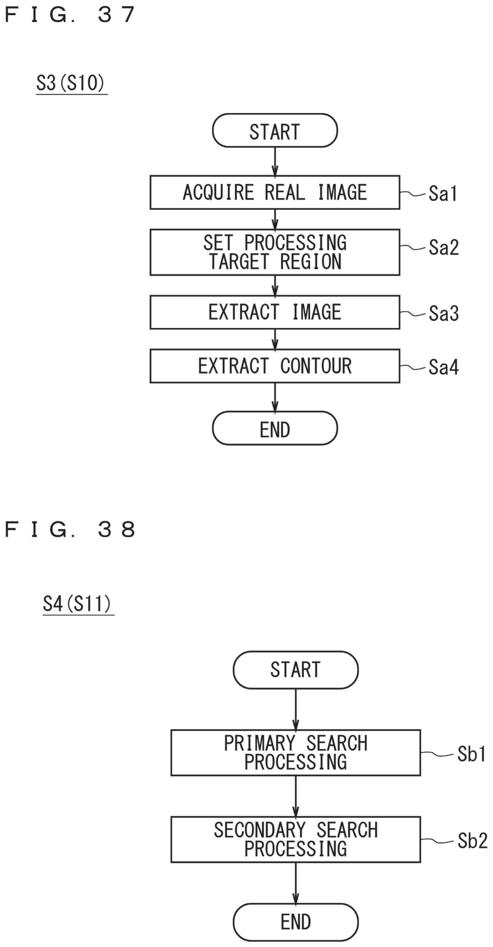

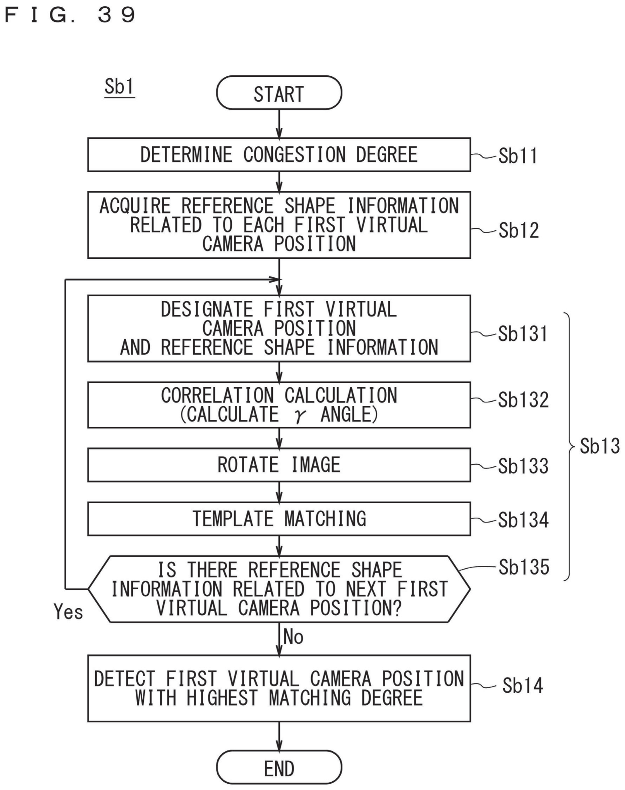

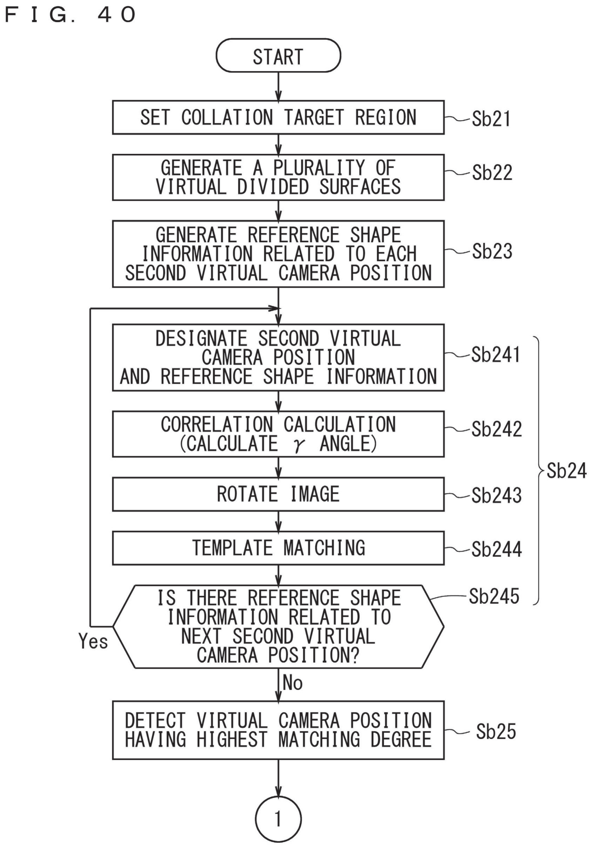

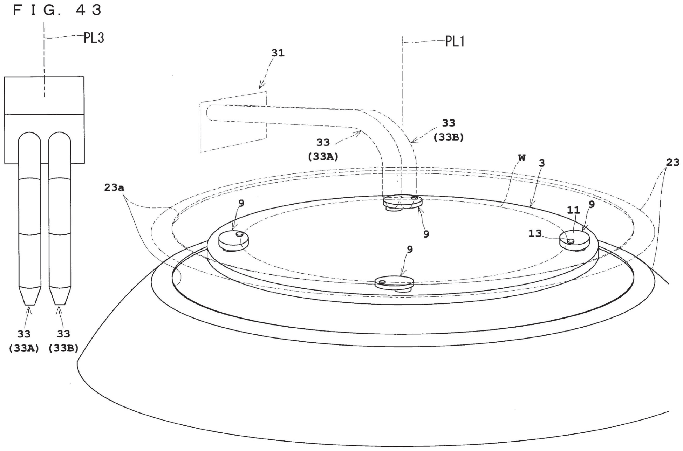

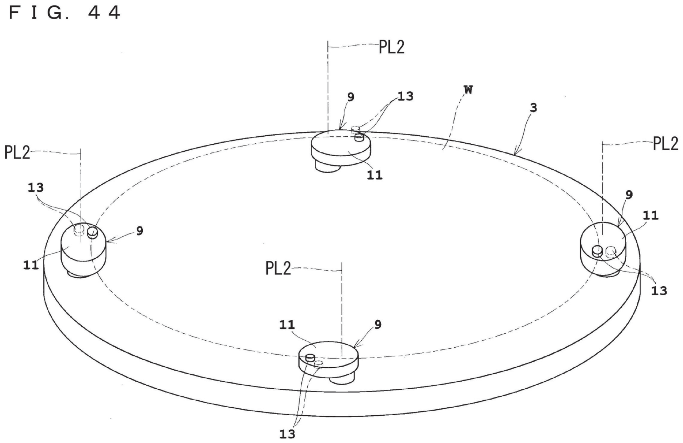

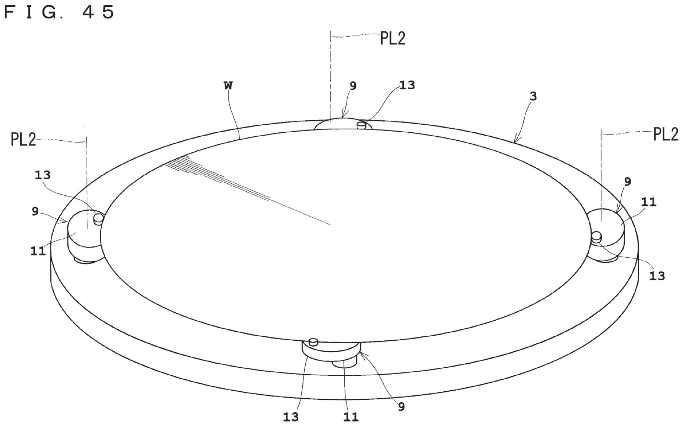

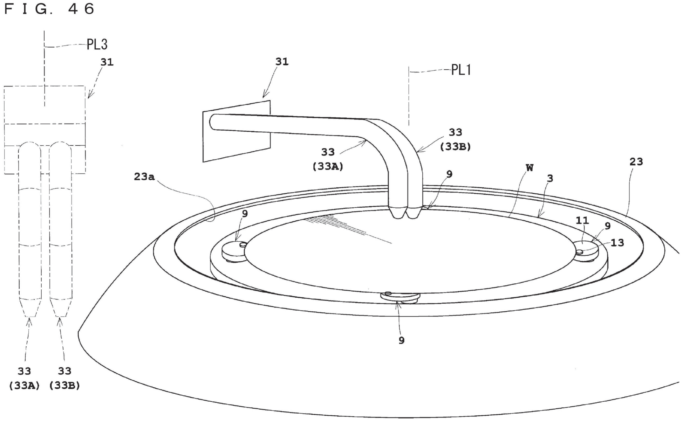

Next, a specific example of processing in the substrate processing apparatus 1 will be described with reference to FIGS. 36 to 46. FIG. 36 is a flowchart indicating a specific example of schematic flow of processing in the substrate processing apparatus 1. FIG. 37 is a flowchart indicating a specific example of flow of image processing in step S3 and step S10 in FIG. 36. FIG. 38 is a flowchart indicating a specific example of processing flow in the search processing in step S4 and step S11 in FIG. 36. FIG. 39 is a flowchart indicating a specific example of processing flow in the primary search processing in step Sb1 in FIG. 38. FIGS. 40 to 42 are flowcharts indicating a specific example of processing flow in the secondary search processing in step Sb2 in FIG. 38. FIG. 43 is a view schematically illustrating an example of a state in which the target component has moved to the origin position. FIGS. 44 and 45 are views for describing detection of an abnormality of the chuck 9. FIG. 46 is a view for describing detection of an abnormality of the nozzle 33 and the guard 23.

The operator gives an instruction to execute a recipe in the recipe information 53 by operating the instruction unit 47 in advance. The operation control unit 51 controls operation of each unit according to the recipe instructed to be executed to advance the processing on each substrate W. In this event, the processing from step S1 to step S18 in FIG. 36 is performed.

### <<Step S1>>

In step S1, the target component moves to the origin position. Here, the operation control unit 51 controls operation of the chuck driving mechanism 17, the guard moving mechanism 25, and the nozzle moving mechanism 35.

The operation control unit 51 operates the chuck driving mechanism 17 by the chuck operation command to move the chuck 9 to the origin position. Here, the chuck 9 rotates about the rotation center PL2 in response to the chuck operation command in a state where the substrate W is not placed on the lower surface support portion 11, and the peripheral edge support portion 13 moves to the origin position on the rotation center PL1 side of the spin chuck 3. In this event, the output signal of the origin sensor Z1 is turned on. The operation control unit 51 recognizes that the chuck 9 has moved to the origin position by the output signal of the origin sensor Z1. In FIG. 44, the state in which the chuck 9 is located at the origin position is indicated by a solid line, and the position of the outer edge of the substrate W in a case where the substrate W is placed on the lower surface support portion 11 is indicated by a thin two-dot chain line. Here, the peripheral edge support portion 13 of each chuck 9 moves to a position in contact with a circle slightly closer to the rotation center PL1 side than the outer edge of the substrate W in a case where the substrate W is placed on the lower surface support portion 11.

The operation control unit 51 operates the guard moving mechanism 25 in accordance with the guard operation command to move the guard 23 to the origin position. Here, the guard 23 moves to the lowered origin position. In this event, the output of the origin sensor Z2 is turned on. The operation control unit 51 recognizes that the guard 23 has moved to the origin position by the output signal of the origin sensor Z2. In FIG. 43, a state in which the guard 23 is located at the origin position is indicated by a solid line, and a state in which the guard 23 is located at the processing position is indicated by a thin two-dot chain line.

The operation control unit 51 operates the nozzle moving mechanism 35 according to the nozzle operation command to move the nozzle 33 to the origin position. Here, the nozzle 33 rotates about the rotation center PL3, and the distal end portion 33c moves to an origin position deviated laterally from the guard 23. In this event, the output of the origin sensor Z3 is turned on. The operation control unit 51 recognizes that the nozzle 33 has moved to the origin position by the output signal of the origin sensor Z3. In FIG. 43, a state in which the distal end portion 33c of the nozzle 33 is located at the origin position is indicated by a solid line, and a state in which the distal end portion 33c of the nozzle 33 is located at the discharge position is indicated by a thin two-dot chain line.

### <<Step S2>>

In step S2, imaging by the camera CM is performed. Here, the operation control unit 51 causes the camera CM to perform imaging by being triggered by movement of each of the nozzle 33, the chuck 9, and the guard 23 as the plurality of target components to the origin position. Specifically, the camera CM images the nozzle 33, the chuck 9, and the guard 23 as the plurality of target components.

### <<Step S3>>

In step S3, the image processing unit 59 performs image processing on the real image acquired by imaging by the camera CM in step S2. In step S3, the processing from step Sa1 to step Sa4 in FIG. 37 is sequentially performed.

In step Sa1, the image processing unit 59 acquires the real image obtained by imaging in step S2 from the camera CM. This step Sa1 corresponds to a step (also referred to as a real image acquisition step) of acquiring a real image capturing the target component obtained by imaging by the camera CM by the arithmetic unit 45a in the present invention.

In step Sa2, the processing target region extraction unit 591 of the image processing unit 59 sets the processing target region to the real image. Here, the processing target region is set for each target component.

In step Sa3, the processing target region extraction unit 591 of the image processing unit 59 extracts a portion related to the processing target region from the real image as an image (processing target real image).

In step Sa4, the contour extraction unit 592 of the image processing unit 59 performs processing of extracting contour for all components captured in the processing target real image. As a result, an edge image as the information (real shape information) related to the two-dimensional shape of the object captured in the real image is acquired. More specifically, an edge image as the information (real shape information) related to the two-dimensional shape of the object including the nozzle 33 is acquired. An edge image as the information (real shape information) related to the two-dimensional shape of the object including the chuck 9 is acquired. An edge image as the information (real shape information) related to the two-dimensional shape of the object including the guard 23 is acquired.

### <<Step S4>>

In step S4, the search processing unit 61 performs search processing on each target component. More specifically, search processing is performed for each of the nozzle 33, the chuck 9, and the guard 23.

Here, the search processing unit 61 performs search processing of searching for a virtual camera position having the highest matching degree between the reference shape information and the real shape information among the plurality of virtual camera positions based on the plurality of pieces of reference shape information and the real shape information. Here, the plurality of pieces of reference shape information is information generated based on the three-dimensional design information regarding the target component stored in the storage unit 45b, and is information regarding the two-dimensional shape of the 3D model 3dm of the target component in each of the plurality of virtual images that can be acquired by imaging the 3D model 3dm of the target component from the plurality of virtual camera positions. One piece of reference shape information is information generated based on the three-dimensional design information regarding one target component, and is information regarding the two-dimensional shape of the 3D model 3dm of the target component in a virtual image that can be acquired by imaging from one virtual camera position. Step S4 corresponds to a search step to be performed by the arithmetic unit 45a of the present invention.

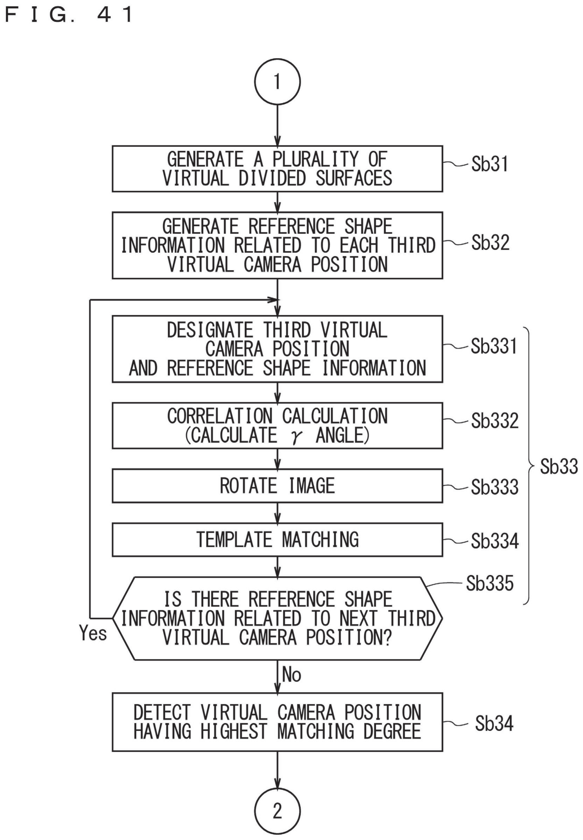

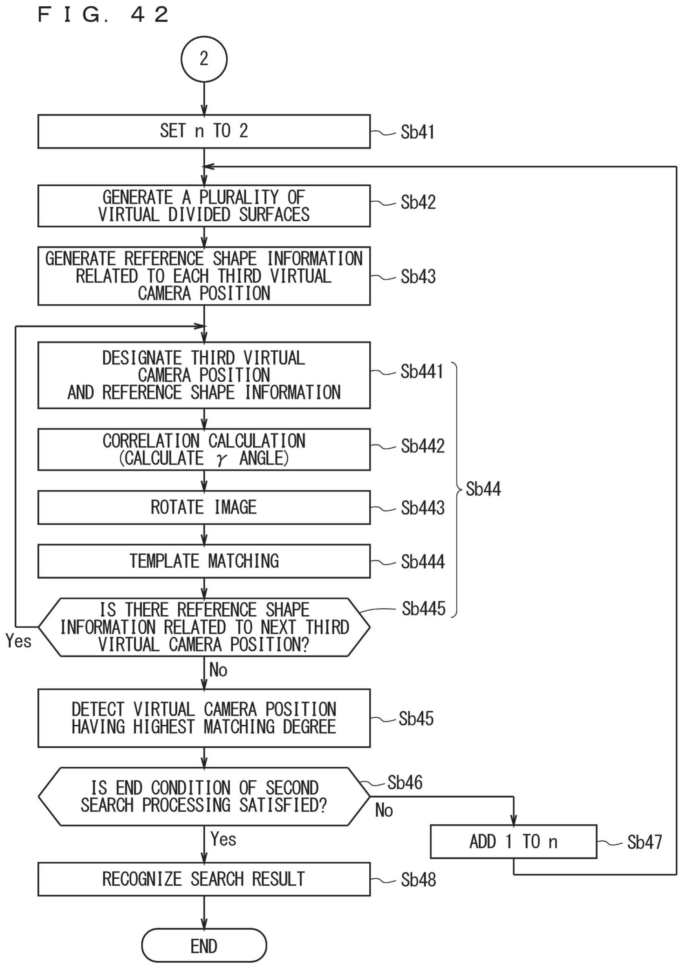

In step S4, the processing in step Sb1 and the processing in step Sb2 in FIG. 38 are sequentially performed on each target component. In step Sb1, the first search processing unit 611 performs the primary search processing. More specifically, in step Sb1, processing from step Sb11 to step Sb14 in FIG. 39 is performed. In step Sb2, the second search processing unit 612 performs the secondary search processing. More specifically, in step Sb2, the processing from step Sb21 to step Sb25 in FIG. 40, the processing from step Sb31 to step Sb34 in FIG. 41, and the processing from step Sb41 to step Sb48 in FIG. 42 are performed. Here, the processing from step Sb31 to step Sb34 in FIG. 41 corresponds to the first unit processing described above. The processing from step Sb42 to step Sb45 in FIG. 42 corresponds to the n-th unit processing described above.

### <<<Step Sb1>>>

### <<<<Step Sb11>>>>

In step Sb11, the congestion degree determination unit 6111 determines a region (low congestion degree region) in which the congestion degree of the contour of the component is low for the edge image as the real shape information acquired in step Sa4. The determination result in the congestion degree determination unit 6111 is used for processing in the first calculation unit 6113 and the second calculation unit 6124. For example, in the processing in the first calculation unit 6113 and the second calculation unit 6124, the low congestion degree region of the edge image as the real shape information is excluded from the calculation target for calculating the numerical value indicating the matching degree, so that the amount of calculation required for the search processing can be reduced.

### <<<<Step Sb12>>>>

In step Sb12, the first shape information acquisition unit 6112 acquires the reference shape information generated for each of the plurality of first virtual camera positions P11 assuming a case where the 3D model 3dm of the target component is imaged from each of the plurality of virtual camera positions (first virtual camera positions) P11 based on the three-dimensional design information regarding the target component stored in the storage unit 45b. The plurality of first virtual camera positions P11 is a plurality of virtual camera positions set by virtually setting one virtual camera position for each of the plurality of virtual surfaces St1 in a case where an aggregate (surface aggregation) As1 of surfaces including a plurality of virtual surfaces St1 located along a virtual spherical surface surrounding the 3D model 3dm of the target component centered around the reference point Po of the 3D model 3dm of the target component is virtually set. The reference shape information is information generated based on the three-dimensional design information regarding the target component, and is information regarding the two-dimensional shape of the 3D model 3dm of the target component in a virtual image that can be acquired by imaging the 3D model 3dm of the target component from the first virtual camera position P11. The virtual image can be generated, for example, by projecting the 3D model 3dm onto a virtual plane by processing such as rendering. Specifically, the reference shape information is a reference image. Here, step Sb12 corresponds to the first shape information acquisition step in the present invention.

More specifically, in step Sb12, the first shape information acquisition unit 6112 acquires the reference shape information generated for each of the M1×T1 first virtual camera positions P11 assuming a case where the 3D model 3dm of the target component is captured from each of the M1×T1 (both M1 and T1 are natural numbers equal to or greater than 2) first virtual camera positions P11 based on the three-dimensional design information regarding the target component stored in the storage unit 45b. The M1×T1 first virtual camera positions P11 are a plurality of virtual camera positions set by virtually setting one virtual camera position for each of the M1 virtual surfaces St1 in each of the T1 surface aggregations As1 in a case where the T1 surface aggregations As1 having mutually different distances from the reference point Po of the 3D model 3dm of the target component are virtually set. The reference shape information is information generated based on the three-dimensional design information regarding the target component, and is information regarding the two-dimensional shape of the 3D model 3dm of the target component in a virtual image that can be acquired by imaging the 3D model 3dm of the target component from the first virtual camera position P11.

Here, in each virtual surface St1, the first virtual camera position P11 is virtually set at a predetermined position of the virtual surface St1. The position of the center of the virtual surface St1 may be adopted as the predetermined position. The center of gravity of the virtual surface may be adopted as the center of the virtual surface. The surface aggregation As1 may be a polyhedron constituted with a large number of triangular virtual surfaces. Here, as illustrated in FIG. 13, the position and the posture of the plurality of virtual surfaces St1, and the like, are defined by setting the xyz coordinates of the right-handed coordinate system with the reference point Po of the 3D model 3dm of the target component virtually generated based on the three-dimensional design information regarding the target component as the origin. Furthermore, the position of each of the plurality of first virtual camera positions P11 is defined by an angle (latitude) α in the rotation direction around the x axis, an angle (longitude) β in the rotation direction around the z axis, and a distance D from the origin.

In step Sb12, the first shape information acquisition unit 6112 may acquire the reference shape information generated for each of the plurality of first virtual camera positions P11, for example, by setting the plurality of first virtual camera positions P11 and generating the reference shape information for each of the plurality of first virtual camera positions P11 based on the three-dimensional design information regarding the target component stored in the storage unit 45b.

### <<<<Step Sb13>>>>

In step Sb13, the first calculation unit 6113 calculates, for each of the plurality of first virtual camera positions P11, a numerical value indicating a matching degree between the edge image as the information (real shape information) related to the two-dimensional shape of the object captured in the real image obtained in step Sa4 and the reference image as the reference shape information obtained in step Sb12. Step Sbl3 corresponds to a first calculation step in the present invention.

More specifically, in step Sb13, the first calculation unit 6113 calculates, for each of the above-described M1×T1 first virtual camera positions, a numerical value indicating a matching degree between the edge image as the information (real shape information) related to the two-dimensional shape of the object captured in the real image obtained in step Sa4 and the reference image as the reference shape information obtained in step Sb12.

Here, when the numerical value indicating the matching degree between the edge image as the real shape information and the reference image as the reference shape information is calculated for each first virtual camera position P11, the first calculation unit 6113 performs, for example, the above-described processing 1a, processing 1b, and processing 1c in this order. Specifically, in step Sb13, the first calculation unit 6113 performs processing from step Sb131 to step Sb135. The processing in step Sb132 corresponds to the above-described processing 1a, the processing in step Sb133 corresponds to the above-described processing 1b, and the processing in step Sb134 corresponds to the above-described processing 1c.

In step Sb131, the first calculation unit 6113 designates one first virtual camera position P11 and a reference image as reference shape information related to the one first virtual camera position P11 among the reference images as reference shape information for each of the plurality of first virtual camera positions P11 acquired in step Sb12 as processing targets of steps Sb132 to Sb134.

In step Sb132, for example, the first calculation unit 6113 detects a deviation amount in the direction of the two-dimensional shape of the contour between the edge image as the real shape information and the reference image as the reference shape information using the RIPOC method. Here, for example, as illustrated in FIG. 21, the first calculation unit 6113 divides the edge image Ir3 as the real shape information input from the image processing unit 59 into a plurality of comparison target regions Re1, and calculates the deviation amount γ1 in the rotation direction in which the matching degree of the contour with the reference image can become the highest for each comparison target region Re1 using the RIPOC method. The deviation amount γ1 corresponds to the roll angle γ at which the matching degree between the reference image as the reference shape information and the edge image as the real shape information can be further increased. Here, among the plurality of comparison target regions Re1, one comparison target region Re1 in which the matching degree of the contour with the reference image can be the highest and the deviation amount γ1 in the rotation direction in which the matching degree of the contour can be the highest between the one comparison target region Re1 and the reference image are detected.

In step Sb133, for example, the first calculation unit 6113 rotates the edge image as the real shape information so as to correct the deviation amount γ1 detected in step Sb132. As a result, the rotated edge image is generated, and the orientation is matched between the two-dimensional shape of the contour in the edge image as the real shape information and the two-dimensional shape of the contour in the reference image as the reference shape information. Here, for example, the first calculation unit 6113 rotates the edge image of the comparison target region Re1 detected in step Sb132 so as to correct the deviation amount γ1 detected in step Sb132. As a result, the rotated edge image is generated, and the orientation is matched between the two-dimensional shape of the contour in the comparison target region Re1 constituting the real shape information and the two-dimensional shape of the contour in the reference image as the reference shape information.

In step Sb134, for example, the first calculation unit 6113 performs template matching using the reference image as the reference shape information on the rotated edge image related to the real shape information generated in step Sb133. Here, for example, the first calculation unit 6113 scans the reference image in the rotated edge image, and detects the position of the region where the matching degree (similarity) between each partial region in the rotated edge image and the reference image becomes maximum. As a result, in the edge image as the real shape information, the position (matching candidate position) of the region where the matching degree with the two-dimensional shape of the contour of the 3D model 3dm of the target component in the reference image becomes maximum is detected. Here, when the template matching is performed, a numerical value indicating the matching degree (similarity) in a case where the matching degree (similarity) between the partial region in the rotated edge image and the reference image becomes maximum is calculated as the numerical value indicating the matching degree between the edge image as the real shape information and the reference image as the reference shape information for the first virtual camera position P11. Here, the numerical value indicating the matching degree may be, for example, the known matching score indicating the matching degree described above.

In step Sb135, the first calculation unit 6113 determines whether or not there are the first virtual camera position P11 and reference shape information related to the first virtual camera position P11 that have not yet been designated as the processing targets of steps Sb132 to Sb134, among the reference shape information for each of the plurality of first virtual camera positions P11 acquired in step Sb12. Here, if there are the first virtual camera position P11 and reference shape information related to the first virtual camera position P11 that have not yet been designated as the processing targets of steps Sb132 to Sb134, the processing returns to step Sb131, and the first calculation unit 6113 designates, as the processing targets of steps Sb132 to Sb134, the next one first virtual camera position P11 and reference shape information related to the next one first virtual camera position P11 among the reference shape information for each of the plurality of first virtual camera positions P11 acquired in step Sb12. On the other hand, if there is no first virtual camera position P11 and reference shape information related to the first virtual camera position P11 that have not yet been designated as the processing targets of steps Sb132 to Sb134, the processing proceeds from step Sb135 to step S14.

In other words, the first calculation unit 6113 repeats the processing from steps Sb131 to Sb135 until there is no first virtual camera position P11 and reference shape information related to the first virtual camera position P11 that have not yet been designated as the processing targets of steps Sb132 to Sb134 in the reference shape information for each of the plurality of first virtual camera positions P11 acquired in step Sb12. As a result, the first calculation unit 6113 calculates, for each first virtual camera position P11, a numerical value indicating the matching degree between the edge image as the real shape information and the reference image as the reference shape information.

### <<<<Step Sb14>>>>

In step Sb14, the first detection unit 6114 detects the virtual camera position with high matching degree P11m, which is the first virtual camera position P11 having the highest matching degree between the edge image as the real shape information and the reference image as the reference shape information, among the plurality of first virtual camera positions P11 based on the calculation result in step Sb13. Here, for example, among the plurality of first virtual camera positions P11, the first virtual camera position P11 at which the matching score calculated between the edge image as the information (real shape information) related to the two-dimensional shape of the object captured in the real image and the reference image as the reference shape information in step Sb13 becomes the highest is detected as the virtual camera position with high matching degree P11m. Step Sb14 corresponds to a first detection step in the present invention.

More specifically, in step Sb14, the first detection unit 6114 detects the virtual camera position with high matching degree P11m, which is the first virtual camera position P11 having the highest matching degree between the edge image as the real shape information and the reference image as the reference shape information, among the M1×T1 first virtual camera positions P11 as the plurality of first virtual camera positions P11 based on the calculation result in step Sb13. Here, for example, among the M1×T1 first virtual camera positions P11, the virtual camera position with high matching degree P11m, which is the first virtual camera position P11 at which the matching score calculated between the edge image as the information (real shape information) related to the two-dimensional shape of the object captured in the real image and the reference image as the reference shape information in step Sb13 becomes the highest, is detected.

In step Sb14, when the virtual camera position with high matching degree P11m is detected, the first detection unit 6114 also detects the matching candidate position detected for the virtual camera position with high matching degree P11m in step Sb13 as the target component candidate position.

### <<<Step Sb2>>>

### <<<<Step Sb21>>>>

In step Sb21, the collation target region setting unit 6121 of the second search processing unit 612 sets a region (collation target region) to be used for the matching (collation) processing in step Sb24 in the edge image as the real shape information acquired in step Sa4 based on the target component candidate position detected in step Sb14. Here, with respect to the edge image, a region including the target component candidate position and having a size larger than the target component candidate position is set as the collation target region.

### <<<<Step Sb22>>>>

In step Sb22, the divided surface generation unit 6122 generates a plurality of virtual surfaces (virtual divided surfaces) St2 by dividing a virtual surface (virtual surface with high matching degree) St1m in which the virtual camera position with high matching degree P11m detected in step Sb14 is virtually set among a plurality of virtual surfaces St1 constituting the surface aggregation As1 and located along a virtual spherical surface surrounding the 3D model 3dm of the target component centered around the reference point Po of the 3D model 3dm of the target component. Here, the plurality of virtual surfaces St1 is the plurality of virtual surfaces St1 used in the processing in step Sb12. If each of the plurality of virtual surfaces St1 is a triangular surface, the virtual surface with high matching degree St1m is divided into three virtual divided surfaces St2 as a plurality of divided virtual surfaces (virtual divided surfaces) St2 by three line segments connecting each of three vertices of the virtual surface with high matching degree St1m and the virtual camera position with high matching degree P11m. This step Sb22 corresponds to the divided surface generation step of the present invention.

More specifically, in step Sb22, among the M1 virtual surfaces St1 in each of the T1 surface aggregations As1, the divided surface generation unit 6122 divides each of the T2 virtual surfaces St1 including the virtual surface with high matching degree St1m and having mutually different distances from the reference point Po of the 3D model 3dm of the target component according to the same rule. As a result, the divided surface generation unit 6122 generates M2×T2 virtual divided surfaces St2 by generating M2 virtual divided surfaces St2 for each of the T2 virtual surfaces St1. Here, each of the T2 virtual surfaces St1 is a virtual surface intersecting a line passing through the reference point Po and the virtual camera position with high matching degree P11m on a side of the virtual camera position with high matching degree P11m with respect to the reference point Po of the 3D model 3dm of the target component. Here, M1 virtual surfaces St1 in each of the T1 surface aggregations As1 are M1 virtual surfaces St1 in each of the T1 surface aggregations As1 used in the processing of step Sb12.

Here, the T2 virtual surfaces St1 have similar shapes enlarged and reduced in the radial direction with respect to the reference point Po of the 3D model 3dm of the target component. When viewed from the reference point Po of the 3D model 3dm of the target component, each of the T2 virtual surfaces St1 is divided by lines having similar shapes enlarged and reduced in the radial direction around the reference point Po, thereby generating M2×T2 virtual divided surfaces St2. As a result, in the T2 virtual surfaces St1, for each of the M2 virtual divided surfaces St2, there are T2 virtual divided surfaces St2 having similar shapes enlarged and reduced in the radial direction around the reference point Po of the 3D model 3dm of the target component. T2 may be equal to or less than T1. The same rule related to the division of the T2 virtual surfaces St1 described above may be, for example, a rule of dividing the division target surface into a plurality of surfaces by a plurality of line segments respectively connecting the center point of the division target surface to be divided and all vertices of the division target surface. If each of the plurality of virtual surfaces St1 is a triangular surface, each of the T2 virtual surfaces St1 may be divided into three virtual divided surfaces St2 by three line segments connecting each of three vertices and the first virtual camera position P11, similarly to the virtual surface with high matching degree St1m. As a result, each of the T2 virtual surfaces St1 is divided into three triangular virtual divided surfaces St2.

### <<<<Step Sb23>>>>

In step Sb23, the second shape information generation unit 6123 generates reference shape information for each of the plurality of second virtual camera positions P12 assuming a case where the 3D model 3dm of the target component is imaged from each of the plurality of virtual camera positions (second virtual camera positions) P12 set by virtually setting one virtual camera position for each of the plurality of virtual divided surfaces St2 based on the three-dimensional design information regarding the target component stored in the storage unit 45b. Here, the reference shape information is information generated based on the three-dimensional design information regarding the target component, and is information regarding the two-dimensional shape of the 3D model 3dm of the target component in the virtual image that can be acquired by imaging the 3D model 3dm of the target component from the second virtual camera position P12. The virtual image can be generated, for example, by projecting the 3D model 3dm onto a virtual plane by processing such as rendering. A specific example of the reference shape information is a reference image. Step Sb23 corresponds to the second shape information generation step of the present invention.

More specifically, in step Sb23, the second shape information generation unit 6123 generates the reference shape information for each of the M2×T2 second virtual camera positions P12 assuming a case where the 3D model 3dm of the target component is imaged from each of the M2×T2 second virtual camera positions P12 based on the three-dimensional design information regarding the target component stored in the storage unit 45b. The M2×T2 second virtual camera positions P12 are M2×T2 virtual camera positions set by virtually setting one virtual camera position for each of the M2×T2 virtual divided surfaces St2 generated in step Sb22. Here, the reference shape information is information generated based on the three-dimensional design information regarding the target component, and is information regarding the two-dimensional shape of the 3D model 3dm of the target component in the virtual image that can be acquired by imaging the 3D model 3dm of the target component from the second virtual camera position P12.

Here, in each virtual divided surface St2, the second virtual camera position P12 is virtually set at a predetermined position of the virtual divided surface St2. A position of the center of the virtual divided surface St2 may be adopted as the predetermined position. The center of gravity of the virtual divided surface St2 may be adopted as the center of the virtual divided surface St2. The plurality of virtual divided surfaces St2 may be triangular surfaces.

### <<<<Step Sb24>>>>

In step Sb24, the second calculation unit 6124 calculates, for each of the plurality of second virtual camera positions P12, a numerical value indicating a matching degree between the edge image as the information (real shape information) related to the two-dimensional shape of the object captured in the real image obtained in step Sa4 and the reference image as the reference shape information obtained in step Sb23. This step Sb24 corresponds to the second calculation step of the present invention.

As described above, the second virtual camera position P12 is set for each of the plurality of virtual surfaces (virtual divided surfaces) St2 generated by dividing the virtual surface (virtual surface with high matching degree) St1m in which the virtual camera position with high matching degree P11m detected in step Sb14 among the plurality of virtual surfaces St1 is set, and a numerical value indicating a matching degree between the real shape information and the reference shape information is calculated for each second virtual camera position P12. Thus, the virtual surface with high matching degree St1m is not irrelevant to the plurality of virtual divided surfaces St2, and increase in at least one of the number or the area can be reduced for the plurality of virtual divided surfaces St2. As a result, an amount of calculation for recognizing the posture of the target component captured in the real image can be reduced. As a result, the substrate processing apparatus 1 can efficiently recognize the posture of the target component.

More specifically, in step Sb24, the second calculation unit 6124 calculates, for each of the M2×T2 second virtual camera positions P12 virtually set in step Sb23, a numerical value indicating a matching degree between the edge image as the information (real shape information) related to the two-dimensional shape of the object captured in the real image and the reference image as the reference shape information generated in step Sb23.

Here, when a numerical value indicating a matching degree between the edge image as the real shape information and the reference image as the reference shape information is calculated for each second virtual camera position P12, the second calculation unit 6124 performs, for example, the processing 2a, the processing 2b, and the processing 2c described above in this order. Specifically, in step Sb24, the second calculation unit 6124 performs processing from step Sb241 to step Sb245. The processing in step Sb242 corresponds to the above-described processing 2a, the processing in step Sb243 corresponds to the above-described processing 2b, and the processing in step Sb244 corresponds to the above-described processing 2c.

In step Sb241, the second calculation unit 6124 designates one second virtual camera position P12 and a reference image as reference shape information related to the one second virtual camera position P12 among the reference images as reference shape information for each of the plurality of second virtual camera positions P12 generated in step Sb23 as the processing targets of steps Sb242 to Sb244.

In step Sb242, for example, the second calculation unit 6124 detects a deviation amount in the direction of the two-dimensional shape of the contour between the edge image as the real shape information and the reference image as the reference shape information using the RIPOC method. Here, for example, the second calculation unit 6124 detects the deviation amount γ2 in the rotation direction in which the matching degree of the contour can be the highest between the collation target region set in step Sb21 in the edge image as the real shape information and the reference image. The deviation amount γ2 corresponds to the roll angle γ at which the matching degree between the reference image as the reference shape information and the edge image as the real shape information can be further increased.

In step Sb243, for example, the second calculation unit 6124 rotates the edge image as the real shape information so as to correct the deviation amount γ2 detected in step Sb242. As a result, the rotated edge image is generated, and the orientation is matched between the two-dimensional shape of the contour in the edge image as the real shape information and the two-dimensional shape of the contour in the reference image as the reference shape information. Here, for example, the second calculation unit 6124 rotates the edge image of the collation target region set in step Sb21 so as to correct the deviation amount γ2 detected in step Sb242. As a result, the rotated edge image is generated, and the orientation is matched between the two-dimensional shape of the contour in the collation target region constituting the real shape information and the two-dimensional shape of the contour in the reference image as the reference shape information.

In step Sb244, for example, the second calculation unit 6124 performs template matching using the reference image as the reference shape information on the rotated edge image related to the real shape information generated in step Sb243. Here, for example, the second calculation unit 6124 scans the reference image in the rotated edge image, and detects the position of the region where the matching degree (similarity) between each partial region in the rotated edge image and the reference image becomes maximum. As a result, in the edge image as the real shape information, the position (matching candidate position) of the region where the matching degree with the two-dimensional shape of the contour of the 3D model 3dm of the target component in the reference image becomes maximum is detected. Here, when the template matching is performed, a numerical value indicating the matching degree (similarity) in a case where the matching degree (similarity) between the partial region in the rotated edge image and the reference image becomes maximum is calculated as the numerical value indicating the matching degree between the edge image as the real shape information and the reference image as the reference shape information for the second virtual camera position P12. Here, the numerical value indicating the matching degree may be, for example, the known matching score indicating the matching degree described above.

In step Sb245, the second calculation unit 6124 determines whether or not there are the second virtual camera position P12 and reference shape information related to the second virtual camera position P12 that have not yet been designated as the processing targets of steps Sb242 to Sb244, among the reference shape information for each of the plurality of second virtual camera positions P12 acquired in step Sb23. Here, if there are the second virtual camera position P12 and reference shape information related to the second virtual camera position P12 that have not yet been designated as the processing targets of steps Sb242 to Sb244, the processing returns to step Sb241, and the second calculation unit 6124 designates, as the processing targets of steps Sb242 to Sb244, the next one second virtual camera position P12 and reference shape information related to the next one second virtual camera position P12 among the reference shape information for each of the plurality of second virtual camera positions P12 generated in step Sb23. On the other hand, if there is no second virtual camera position P12 and reference shape information related to the second virtual camera position P12 that have not yet been designated as the processing targets of step Sb242 to step Sb244, the processing proceeds from step Sb245 to step Sb25.

In other words, the second calculation unit 6124 repeats the processing from steps Sb241 to Sb245 until there is no second virtual camera position P12 and reference shape information related to the second virtual camera position P12 that have not yet been designated as the processing targets of steps Sb242 to Sb244, in the reference shape information for each of the plurality of second virtual camera positions P12 acquired in step Sb23. As a result, the second calculation unit 6124 calculates, for each second virtual camera position P12, the numerical value indicating the matching degree between the edge image as the real shape information and the reference image as the reference shape information.

### <<<<Step Sb25>>>>

In step Sb25, the second detection unit 6125 detects the virtual camera position having the highest matching degree between the edge image as the information (real shape information) related to the two-dimensional shape of the object captured in the real image obtained in step Sa4 and the reference image as the reference shape information generated in steps Sb12 and Sb23, among the virtual camera position with high matching degree P11m detected in step Sb14 and the above-described M2×T2 second virtual camera positions P12. The virtual camera position detected here is the first reference virtual camera position Ps1, which is a virtual camera position detected first by the second detection unit 6125.

Here, for example, the matching score calculated for the virtual camera position with high matching degree P11m in step Sb13 and the matching score calculated for each of the M2×T2 second virtual camera positions P12 in step Sb24 are compared. Then, for example, among the virtual camera position with high matching degree P11m and the M2×T2 second virtual camera positions P12, the virtual camera position at which the matching score calculated between the edge image as the information (real shape information) related to the two-dimensional shape of the object captured in the real image obtained in step Sa4 and the reference image as the reference shape information becomes the highest is detected.

### <<<<Step Sb31>>>>

In step Sb31, the search processing unit 61 performs the above-described first A processing. Here, the divided surface generation unit 6122 generates the first M3×T3 virtual divided surfaces St3.

### <<<<Step Sb32>>>>

In step Sb32, the search processing unit 61 performs the above-described first B processing. Here, the second shape information generation unit 6123 generates a reference image as the reference shape information for each of the first M3×T3 third virtual camera positions P13 set by virtually setting one virtual camera position for each of the first M3×T3 virtual divided surfaces St3 generated in step Sb31. Here, the reference shape information is information generated based on the three-dimensional design information regarding the target component, and is information related to the two-dimensional shape of the 3D model 3dm of the target component in the virtual image that can be acquired by imaging the 3D model 3dm of the target component from the third virtual camera position P13.

### <<<<Step Sb33>>>>

In step Sb33, the search processing unit 61 performs the above-described first C processing. Here, for each of the first M3×T3 third virtual camera positions P13 virtually set in step Sb32, the second calculation unit 6124 calculates a numerical value indicating a matching degree between the edge image as the information (real shape information) related to the two-dimensional shape of the object captured in the real image obtained in step Sa4 and the reference image as the reference shape information generated in step Sb32.

Here, when the numerical value indicating the matching degree between the edge image as the real shape information and the reference image as the reference shape information is calculated for each of the third virtual camera positions P13, the second calculation unit 6124 performs, for example, the processing 2al, the processing 2bl, and the processing 2c1 described above in this order. Specifically, in step Sb33, the second calculation unit 6124 performs the processing from step Sb331 to step Sb335. The processing in step Sb332 corresponds to the above-described processing 2al, the processing in step Sb333 corresponds to the above-described processing 2b1, and the processing in step Sb334 corresponds to the above-described processing 2c1.

In step Sb331, the second calculation unit 6124 designates one third virtual camera position P13 and a reference image as reference shape information related to the one third virtual camera position P13 among the reference images as the reference shape information for each of the first M3×T3 third virtual camera positions P13 generated in step Sb32 as the processing targets of steps Sb332 to Sb334.

In step Sb332, for example, the second calculation unit 6124 detects a deviation amount in the direction of the two-dimensional shape of the contour between the edge image as the real shape information and the reference image as the reference shape information using the RIPOC method. Here, the second calculation unit 6124 detects the deviation amount y21 in the rotation direction in which the matching degree of the contour can be the highest between the collation target region set in step Sb21 in the edge image as the real shape information and the reference image. The deviation amount γ21 corresponds to the roll angle γ at which the matching degree between the reference image as the reference shape information and the edge image as the real shape information can be further increased.

In step Sb333, for example, the second calculation unit 6124 rotates the edge image as the real shape information so as to correct the deviation amount γ21 detected in step Sb332. As a result, the rotated edge image is generated, and the orientation is matched between the two-dimensional shape of the contour in the edge image as the real shape information and the two-dimensional shape of the contour in the reference image as the reference shape information. Here, for example, the second calculation unit 6124 rotates the edge image of the collation target region set in step Sb21 in the edge image as the real shape information so as to correct the deviation amount γ21 detected in step Sb332. As a result, the rotated edge image is generated, and the orientation is matched between the two-dimensional shape of the contour in the collation target region constituting the real shape information and the two-dimensional shape of the contour in the reference image as the reference shape information.

In step Sb334, for example, the second calculation unit 6124 performs template matching using the reference image as the reference shape information on the rotated edge image related to the real shape information generated in step Sb333. Here, for example, the second calculation unit 6124 scans the reference image in the rotated edge image, and detects the position of the region where the matching degree (similarity) between each partial region in the rotated edge image and the reference image becomes maximum. As a result, in the edge image as the real shape information, the position (matching candidate position) of the region where the matching degree with the two-dimensional shape of the contour of the 3D model 3dm of the target component in the reference image becomes maximum is detected. Here, when the template matching is performed, the numerical value indicating the matching degree (similarity) in a case where the matching degree (similarity) between the partial region in the rotated edge image and the reference image becomes maximum is calculated as the numerical value indicating the matching degree between the edge image as the real shape information and the reference image as the reference shape information for the third virtual camera position P13. Here, the numerical value indicating the matching degree may be, for example, the known matching score indicating the matching degree described above.

In step Sb335, the second calculation unit 6124 determines whether or not there are the third virtual camera position P13 and reference shape information related to the third virtual camera position P13 that have not yet been designated as the processing targets of steps Sb332 to Sb334 among the reference shape information for each of the first M3×T3 third virtual camera positions P13 generated in step Sb32. Here, if there are the third virtual camera position P13 and reference shape information related to the third virtual camera position P13 that have not yet been designated as the processing targets of steps Sb332 to Sb334, the processing returns to step Sb331, and the second calculation unit 6124 designates, as the processing targets of steps Sb332 to Sb334, the next one third virtual camera position P13 and reference shape information related to the next one third virtual camera position P13 among the reference shape information for each of the first M3×T3 third virtual camera positions P13 generated in step Sb32. On the other hand, if there is no third virtual camera position P13 and reference shape information related to the third virtual camera position P13 that have not yet been designated as the processing targets of step Sb332 to step Sb334, the processing proceeds from step Sb335 to step Sb34.

In other words, the second calculation unit 6124 repeats the processing from steps Sb331 to Sb335 until there is no third virtual camera position P13 and reference shape information related to the third virtual camera position P13 that have not yet been designated as the processing targets of steps Sb332 to Sb334 in the reference shape information for each of the first M3×T3 third virtual camera positions P13 generated in step Sb32. As a result, the second calculation unit 6124 calculates the numerical value indicating the matching degree between the edge image as the real shape information and the reference image as the reference shape information for each of the first M3×T3 third virtual camera positions P13.

### <<<<Step Sb34>>>>

In step Sb34, the search processing unit 61 performs the above-described first D processing. Here, the second detection unit 6125 detects a second reference virtual camera position Ps2, which is a virtual camera position having the highest matching degree between the edge image as the information (real shape information) related to the two-dimensional shape of the object captured in the real image obtained in step Sa4 and the reference image as the reference shape information generated in step Sb12 or step Sb23 and step Sb32, among the first reference virtual camera position Ps1, which is the virtual camera position detected in step Sb25, and the first M3×T3 third virtual camera positions P13 virtually set in step Sb32.

Here, for example, the matching score calculated for the first reference virtual camera position Ps1 in step Sb13 or step Sb24 and the matching score calculated for each of the first M3×T3 third virtual camera positions P13 in step Sb33 are compared. Then, for example, among the first reference virtual camera position Ps1 and the first M3×T3 third virtual camera positions P13, the virtual camera position at which the matching score calculated between the edge image as the information (real shape information) related to the two-dimensional shape of the object captured in the real image obtained in step Sa4 and the reference image as the reference shape information becomes the highest is detected.

### <<<<Step Sb41>>>>

In step Sb41, the search processing unit 61 sets the variable n to 2, which is an initial value.

### <<<<Step Sb42>>>>

In step Sb42, the search processing unit 61 performs the above-described n-th A processing. Here, the divided surface generation unit 6122 generates n-th M3×T3 virtual divided surfaces.

### <<<<Step Sb43>>>>

In step Sb43, the search processing unit 61 performs the above-described n-th B processing. Here, the second shape information generation unit 6123 generates a reference image as reference shape information for each of the n-th M3×T3 third virtual camera positions set by setting one virtual camera position on each of the n-th M3×T3 virtual divided surfaces generated in step Sb42. Here, the reference shape information is information generated based on the three-dimensional design information regarding the target component, and is information regarding the two-dimensional shape of the 3D model 3dm of the target component in the virtual image that can be acquired by imaging the 3D model 3dm of the target component from the third virtual camera position.

### <<<<Step Sb44>>>>

In step Sb44, the search processing unit 61 performs the above-described n-th C processing. Here, the second calculation unit 6124 calculates, for each of the n-th M3×T3 third virtual camera positions virtually set in step Sb43, a numerical value indicating the matching degree between the edge image as the information (real shape information) related to the two-dimensional shape of the object captured in the real image obtained in step Sa4 and the reference image as the reference shape information generated in step Sb43.

Here, when the numerical value indicating the matching degree between the edge image as the real shape information and the reference image as the reference shape information is calculated for each third virtual camera position, the second calculation unit 6124 performs, for example, the processing 2an, the processing 2bn, and the processing 2cn described above in this order. Specifically, in step Sb44, the second calculation unit 6124 performs the processing from step Sb441 to step Sb445. The processing in step Sb442 corresponds to the above-described processing 2an, the processing in step Sb443 corresponds to the above-described processing 2bn, and the processing in step Sb444 corresponds to the above-described processing 2cn.

In step Sb441, the second calculation unit 6124 designates one third virtual camera position and a reference image as reference shape information related to the one third virtual camera position among the reference images as reference shape information for each of the n-th M3×T3 third virtual camera positions generated in step Sb43 as the processing targets of steps Sb442 to Sb444.

In step Sb442, for example, the second calculation unit 6124 detects a deviation amount in the direction of the two-dimensional shape of the contour between the edge image as the real shape information and the reference image as the reference shape information using the RIPOC method. Here, the second calculation unit 6124 detects the deviation amount γ2n in the rotation direction in which the matching degree of the contour can be the highest between the collation target region set in step Sb21 in the edge image as the real shape information and the reference image. The deviation amount γ2n corresponds to the roll angle γ at which the matching degree between the reference image as the reference shape information and the edge image as the real shape information can be further increased.

In step Sb443, for example, the second calculation unit 6124 rotates the edge image as the real shape information so as to correct the deviation amount γ2n detected in step Sb442. As a result, the rotated edge image is generated, and the orientation is matched between the two-dimensional shape of the contour in the edge image as the real shape information and the two-dimensional shape of the contour in the reference image as the reference shape information. Here, for example, the second calculation unit 6124 rotates the edge image of the collation target region set in step Sb21 in the edge image as the real shape information so as to correct the deviation amount γ2n detected in step Sb442. As a result, the rotated edge image is generated, and the orientation is matched between the two-dimensional shape of the contour in the collation target region constituting the real shape information and the two-dimensional shape of the contour in the reference image as the reference shape information.

In step Sb444, for example, the second calculation unit 6124 performs template matching using the reference image as the reference shape information on the rotated edge image related to the real shape information generated in step Sb443. Here, for example, the second calculation unit 6124 scans the reference image in the rotated edge image, and detects the position of the region where the matching degree (similarity) between each partial region in the rotated edge image and the reference image becomes maximum. As a result, in the edge image as the real shape information, the position (matching candidate position) of the region where the matching degree with the two-dimensional shape of the contour of the 3D model 3dm of the target component in the reference image becomes maximum is detected. Here, when the template matching is performed, a numerical value indicating the matching degree (similarity) in a case where the matching degree (similarity) between the partial region in the rotated edge image and the reference image becomes maximum is calculated as the numerical value indicating the matching degree between the edge image as the real shape information and the reference image as the reference shape information for the third virtual camera position. Here, the numerical value indicating the matching degree may be, for example, the known matching score indicating the matching degree described above.

In step Sb445, the second calculation unit 6124 determines whether or not there are the third virtual camera position and reference shape information related to the third virtual camera position that have not yet been designated as the processing targets of steps Sb442 to Sb444 among the reference shape information for each of the n-th M3×T3 third virtual camera positions generated in step Sb43. Here, if there are the third virtual camera position and reference shape information related to the third virtual camera position that have not yet been designated as the processing targets of steps Sb442 to Sb444, the processing returns to step Sb441, and the second calculation unit 6124 designates the next one third virtual camera position and the reference shape information related to the next one third virtual camera position among the reference shape information for each of the n-th M3×T3 third virtual camera positions generated in step Sb43 as the processing targets of steps Sb442 to Sb444. On the other hand, if there is no third virtual camera position and reference shape information related to the third virtual camera position that have not yet been designated as the processing targets of step Sb442 to step Sb444, the processing proceeds from step Sb445 to step Sb45.

In other words, the second calculation unit 6124 repeats the processing from steps Sb441 to Sb445 until there is no third virtual camera position and reference shape information related to the third virtual camera position that have not yet been designated as the processing targets of steps Sb442 to Sb444 in the reference shape information for each of the n-th M3×T3 third virtual camera positions generated in step Sb43. As a result, the second calculation unit 6124 calculates, for each of the n-th M3×T3 third virtual camera positions, the numerical value indicating the matching degree between the edge image as the real shape information and the reference image as the reference shape information.

### <<<<Step Sb45>>>>

In step Sb45, the search processing unit 61 performs the above-described n-th D processing. Here, the second detection unit 6125 detects a virtual camera position having the highest matching degree between the edge image as the information (real shape information) related to the two-dimensional shape of the object captured in the real image and the reference image as the reference shape information, among the n-th reference virtual camera position which is the virtual camera position detected in step Sb34 or (n-1)-th step Sb45, and the n-th M3×T3 third virtual camera positions virtually set in step Sb43.

Here, for example, the matching score calculated for the n-th reference virtual camera position in step Sb13, step Sb24, step Sb33, or (n-1)-th step Sb44 is compared with the matching score calculated for each of the n-th M3×T3 third virtual camera positions calculated in step Sb44. Then, for example, among the n-th reference virtual camera position and the n-th M3×T3 third virtual camera positions, the virtual camera position at which the matching score calculated between the edge image as the information (real shape information) related to the two-dimensional shape of the object captured in the real image obtained in step Sa4 and the reference image as the reference shape information becomes the highest is detected.

### <<<<Steps Sb46, Sb47>>>>

In step Sb46, the search processing unit 61 determines whether or not a condition for ending the second search processing (also referred to as an end condition) is satisfied. Here, if the end condition is not satisfied, in step Sb47, the search processing unit 61 adds 1 to the variable n, and the processing returns from step Sb47 to step Sb42. On the other hand, if the end condition is satisfied, the processing proceeds from step Sb46 to step Sb48. In other words, the processing from step Sb42 to step Sb46 is repeatedly performed until the end condition is satisfied.

Here, the end condition may be, for example, that one reference virtual camera position among from the first reference virtual camera position Ps1 to the n-th reference virtual camera position has been continuously detected by the second detection unit 6125 a first predetermined number of times set in advance as a virtual camera position having the highest matching degree between the real shape information and the reference shape information. Furthermore, the end condition may be, for example, that the n-th unit processing has been executed a second predetermined number of times set in advance in the second search processing. In other words, the end condition may be, for example, that n-1 times, which is the number of times the n-th unit processing has been performed in the second search processing, have reached the second predetermined number of times.

### <<<<Step Sb48>>>>

In step Sb48, the search processing unit 61 recognizes the result of the search processing. Specifically, the search processing unit 61 detects, as the virtual camera position with the highest matching degree, a virtual camera position having the highest matching degree between the real shape information and the reference shape information detected by the second detection unit 6125 in the last step Sb45 in the second search processing. In other words, the virtual camera position having the highest matching degree between the real shape information and the reference shape information detected by the second detection unit 6125 in the last step Sb45 in the second search processing is the virtual camera position with the highest matching degree. Then, the search processing unit 61 acquires, as a result of the search processing, the latitude α, the longitude β, and the distance D that define the virtual camera position with the highest matching degree, and the roll angle γ corresponding to the deviation amount (deviation amount γ1, deviation amount γ2, deviation amount γ21 or deviation amount γ2n) calculated by the first calculation unit 6113 or the second calculation unit 6124 for the virtual camera position with the highest matching degree. As a result, the posture of the target component captured in the real image can be recognized. Here, the search processing unit 61 may recognize, for example, the latitude α, the longitude β, and the distance D that define the virtual camera position with the highest matching degree, and the roll angle γ corresponding to the deviation amount (deviation amount γ1, deviation amount y2, deviation amount γ21 or deviation amount y2n) calculated by the first calculation unit 6113 or the second calculation unit 6124 for the virtual camera position with the highest matching degree which are a result of the search processing as the information regarding the posture of the target component.

Furthermore, here, the search processing unit 61 may acquire, as a portion of the result of the search processing, a matching candidate position (final matching position) at which the matching degree (similarity) with the reference image as the reference shape information becomes maximum in the edge image as the real shape information, detected in step Sb13, step Sb24, step Sb33, or step Sb44 for the virtual camera position with the highest matching degree.

Here, the search processing unit 61 acquires the reality information regarding the posture of the target component recognized using the real image based on the result of the search processing.

### <<Step S5>>

In step S5, the control unit 45 sets normal information for each target component based on the result of the search processing acquired for each target component in step S4.

For example, for the nozzles 33, the control unit 45 sets normal information at the confirmation required timing when each nozzle 33 is located at a position other than the origin position according to the result of the search processing acquired for each nozzle 33 in step S4. More specifically, the control unit 45 associates three-dimensional information of the posture of each nozzle 33 obtained based on the result of the search processing acquired for the state in which each nozzle 33 is located at the origin position with the origin position of each nozzle 33. Then, the control unit 45 sets normal information at the discharge position of each nozzle 33 based on the number of pulse signals output from the position detection unit 43 when the nozzle moving mechanism 35 moves each nozzle 33 from the origin position to the discharge position and the design information of each nozzle 33.

For example, for the chucks 9, the control unit 45 sets normal information at the confirmation required timing when each chuck 9 is located at a position other than the origin position based on the result of the search processing acquired for each chuck 9 in step S4 and the design information of each chuck 9.

For example, for the guard 23, the control unit 45 sets normal information at the confirmation required timing when the guard 23 is located at a position other than the origin position based on the result of the search processing acquired for the guard 23 in step S4 and the design information of the guard 23.

### <<Step S6>>

In step S6, the substrate W to be processed is carried into the substrate processing apparatus 1. The substrate W is carried into the substrate processing apparatus 1 by, for example, a transportation robot (not illustrated), or the like. In this event, each chuck 9 is arranged at the open position.

### <<Step S7>>

In step S7, the processing on the substrate W proceeds according to the recipe. Specifically, first, the substrate W is placed on the plurality of chucks 9. For example, the operation control unit 51 operates the chuck driving mechanism 17 by the chuck operation command to move each chuck 9 from the open position to the closed position. This state is, for example, as illustrated in FIG. 45. In other words, each chuck 9 rotates about the rotation center PL2 in a state where the substrate W is placed thereon, and the peripheral edge support portion 13 moves to the rotation center PL1 side of the spin chuck 3. As a result, the peripheral edge support portion 13 of each chuck 9 abuts on the outer diameter of the substrate W, and the substrate W is clamped by the plurality of chucks 9. The peripheral edge support portion 13 at this time is located slightly closer to the outer peripheral side than the peripheral edge support portion 13 in FIG. 44 in plan view. The outer peripheral side may be the outer peripheral side of the spin chuck 3.

### <<Step S8>>

In step S8, the operation control unit 51 confirms whether or not the target component is at the confirmation required timing. Specifically, the operation control unit 51 refers to the target component and the confirmation required timing in the parameter information 55. Here, if the target component is not at the confirmation required timing, the processing proceeds from step S8 to step S14, and if the target component is at the confirmation required timing, the processing proceeds from step S8 to step S9. In step S8, for example, if the chuck 9 as the target component is at the confirmation required timing set so as to be located at the closed position, the processing proceeds from step S8 to step S9.

### <<Step S9>>

In step S9, the operation control unit 51 causes the camera CM to perform imaging. Specifically, for example, the operation control unit 51 operates the camera CM according to the timing at which each chuck 9 is moved to the closed position by the chuck operation command. In this event, the camera CM acquires a real image including each chuck 9 by imaging.

### <<Step S10>>

In step S10, the image processing unit 59 performs image processing on the real image acquired by imaging by the camera CM in step S9 by the processing similar to step S3 described above. In step S10, similarly to step S3 described above, the processing from step Sa1 to step Sa4 in FIG. 37 is sequentially performed.

Specifically, in step Sa1, the image processing unit 59 acquires the real image obtained by imaging in step S9 from the camera CM. This step Sa1 corresponds to the real image acquisition step of the present invention. In step Sa2, the processing target region extraction unit 591 of the image processing unit 59 sets the processing target region to the real image. Here, for example, a processing target region is set for each chuck 9 as each target component. In step Sa3, the processing target region extraction unit 591 of the image processing unit 59 extracts a portion related to the processing target region from the real image as an image (processing target real image). In step Sa4, the contour extraction unit 592 of the image processing unit 59 performs processing of extracting contour for all components captured in the processing target real image. As a result, an edge image as the information (real shape information) related to the two-dimensional shape of the object captured in the real image is acquired. More specifically, an edge image as the information (real shape information) related to the two-dimensional shape of the object including the chuck 9 is acquired. Here, for example, an edge image is acquired for each chuck 9 as each target component.

### <<Step S11>>

In step S11, the search processing unit 61 performs search processing for each chuck 9 that is each target component by processing similar to the above-described step S4. Here, the edge image as the real shape information for each chuck 9 as the target component acquired in step S10 is used. Similarly to step S4 described above, step S11 corresponds to a search step to be performed by the arithmetic unit 45a of the present invention. Furthermore, here, the search processing unit 61 acquires the reality information regarding the posture of each chuck 9 as each target component based on the result of the search processing.

### <<Step S12>>

In step S12, the abnormality detection unit 63 detects an abnormality of each chuck 9 as each target component according to the reality information acquired in step S11. Here, the abnormality detection unit 63 compares the reality information with the normal information for each chuck 9 which is each target component. The abnormality detection unit 63 detects an abnormality in a case where the reality information does not match the normal information as a result of comparison between the reality information and the normal information for each chuck 9 which is each target component.

### <<Step S13>>

In step S13, the control unit 45 determines whether or not an abnormality has been detected for each chuck 9 as each target component in step S12. Here, if an abnormality has not been detected for each chuck 9 as each target component in step S12, the processing proceeds from step S13 to step S14. On the other hand, if the abnormality has been detected for the chuck 9 as the target component in step S12, the processing proceeds from step S13 to step S17.

### <<Step S14>>

In step S14, the control unit 45 determines whether or not the processing on the substrate W has been completed. Here, if the processing on the substrate W has been completed, the processing proceeds from step S14 to step S15. On the other hand, if the processing on the substrate W has not been completed, the processing returns from step S14 to step S7. For example, if the substrate W is merely placed on the plurality of chucks 9, and the substrate W is clamped by the plurality of chucks 9, the processing on the substrate W has not been completed, and the processing returns from step S14 to step S7.

### <<Step S7>>

In step S7, the processing on the substrate W proceeds according to the recipe. Specifically, for example, the operation control unit 51 operates the guard moving mechanism 25 by the guard operation command to move the guard 23 located at the origin position as illustrated in FIG. 43 to the processing position as illustrated in FIG. 46. At this time point, the nozzle 33 located above the substrate W in FIG. 46 is located at the origin position.

### <<Step S8>>

In step S8, as described above, the operation control unit 51 confirms whether or not the target component is at the confirmation required timing. Specifically, the operation control unit 51 refers to the target component and the confirmation required timing in the parameter information 55. Here, if the target component is not at the confirmation required timing, the processing proceeds from step S8 to step S14, and if the target component is at the confirmation required timing, the processing proceeds from step S8 to step S9. In step S8, for example, if it is the confirmation required timing set such that the guard 23 as the target component is located at the processing position, the processing proceeds from step S8 to step S9.

### <<Step S9>>

In the second step S9, the operation control unit 51 causes the camera CM to perform imaging. Specifically, for example, the operation control unit 51 operates the camera CM according to the timing at which the guard moving mechanism 25 raises the guard 23 by the guard operation command and the movement of the guard 23 to the processing position is completed. In this event, the camera CM acquires a real image including the guard 23 by imaging.

### <<Step S10>>

In the second step S10, the image processing unit 59 performs image processing on the real image acquired by imaging by the camera CM in the second step S9 by the processing similar to that in the first step S10. In the second step S10, the processing from steps Sa1 to Sa4 in FIG. 37 is sequentially performed similarly to the first step S10.

Specifically, in step Sa1, the image processing unit 59 acquires the real image obtained by the imaging in the second step S9 from the camera CM. This step Sa1 corresponds to the real image acquisition step of the present invention. In step Sa2, the processing target region extraction unit 591 of the image processing unit 59 sets the processing target region to the real image. Here, the processing target region is set for the guard 23 as the target component. In step Sa3, the processing target region extraction unit 591 of the image processing unit 59 extracts a portion related to the processing target region from the real image as an image (processing target real image). In step Sa4, the contour extraction unit 592 of the image processing unit 59 performs processing of extracting contour for all components captured in the processing target real image. As a result, an edge image as the information (real shape information) related to the two-dimensional shape of the object captured in the real image is acquired. More specifically, an edge image as the information (real shape information) related to the two-dimensional shape of the object including the guard 23 is acquired.

### <<Step S11>>

In the second step S11, the search processing unit 61 performs search processing for the guard 23 that is the target component by processing similar to the above-described step S4. Here, the edge image as the real shape information about the guard 23 as the target component acquired in the second step S10 is used. Similarly to step S4 described above, step S11 corresponds to a search step to be performed by the arithmetic unit 45a of the present invention. Furthermore, here, the search processing unit 61 acquires the reality information regarding the posture of the guard 23 as the target component based on the result of the search processing.

### <<Step S12>>

In the second step S12, the abnormality detection unit 63 detects an abnormality of the guard 23 as the target component according to the reality information acquired in the second step S11. Here, the abnormality detection unit 63 compares the reality information with the normal information for the guard 23 which is the target component. The abnormality detection unit 63 detects an abnormality in a case where the reality information does not match the normal information as a result of comparison between the reality information and the normal information, for the guard 23 that is the target component.

### <<Step S13>>

In the second step S13, the control unit 45 determines whether or not an abnormality has been detected for the guard 23 as the target component in the second step S12. Here, if no abnormality has been detected for the guard 23 as the target component in the second step S12, the processing proceeds from step S13 to step S14. On the other hand, if an abnormality has been detected for the chuck 9 as the target component in the second step S12, the processing proceeds from step S13 to step S17.

### <<Step S14>>

In step S14, the control unit 45 determines whether or not the processing on the substrate W has been completed. Here, if the processing on the substrate W has been completed, the processing proceeds from step S14 to step S15. On the other hand, if the processing on the substrate W has not been completed, the processing returns from step S14 to step S7. For example, if the substrate W is clamped by the plurality of chucks 9 and the guard 23 is only moved to the processing position, the processing on the substrate W is not completed, and the processing returns from step S14 to step S7.

### <<Step S7>>

In step S7, the processing on the substrate W proceeds according to the recipe. Specifically, for example, the operation control unit 51 operates the nozzle moving mechanism 35 by the nozzle operation command to move the nozzle 33B of the nozzles 33A, 33B from the state of being located at the origin position illustrated in FIG. 43 to the state of being located at the discharge position illustrated in FIG. 46. The discharge position is, for example, a position on the rotation center PL1.

### <<Step S8>>

In step S8, as described above, the operation control unit 51 confirms whether or not the target component is at the confirmation required timing. Specifically, the operation control unit 51 refers to the target component and the confirmation required timing in the parameter information 55. Here, if the target component is not at the confirmation required timing, the processing proceeds from step S8 to step S14, and if the target component is at the confirmation required timing, the processing proceeds from step S8 to step S9. In step S8, for example, if it is the confirmation required timing set such that the nozzle 33 (nozzle 33B), which is the target component, is located at the discharge position, the processing proceeds from step S8 to step S9.

### <<Step S9>>

In the third step S9, the operation control unit 51 causes the camera CM to perform imaging. Specifically, for example, the operation control unit 51 operates the camera CM according to the timing at which the nozzle moving mechanism 35 moves the nozzle 33 (nozzle 33B) by the nozzle operation command and the movement of the nozzle 33 (nozzle 33B) to the discharge position is completed. In this event, the camera CM acquires a real image including the nozzle 33 by imaging.

### <<Step S10>>

In the third step S10, the image processing unit 59 performs image processing on the real image acquired by imaging by the camera CM in the third step S9 by the processing similar to the second step S10. In the third step S10, the processing from step Sa1 to step Sa4 in FIG. 37 is sequentially performed similarly to the second step S10.

Specifically, in step Sa1, the image processing unit 59 acquires the real image obtained by the imaging in the third step S9 from the camera CM. This step Sa1 corresponds to the real image acquisition step of the present invention. In step Sa2, the processing target region extraction unit 591 of the image processing unit 59 sets the processing target region to the real image. Here, a processing target region is set for the nozzle 33B as the target component. In step Sa3, the processing target region extraction unit 591 of the image processing unit 59 extracts a portion related to the processing target region from the real image as an image (processing target real image). In step Sa4, the contour extraction unit 592 of the image processing unit 59 performs processing of extracting contour for all components captured in the processing target real image. As a result, an edge image as the information (real shape information) related to the two-dimensional shape of the object captured in the real image is acquired. More specifically, an edge image as the information (real shape information) related to the two-dimensional shape of the object including the nozzle 33B is acquired.

### <<Step S11>>

In the third step S11, the search processing unit 61 performs search processing for the nozzle 33B that is the target component by processing similar to the above-described step S4. Here, the edge image as the real shape information of the nozzle 33B as the target component acquired in the third step S10 is used. Similarly to step S4 described above, step S11 corresponds to a search step to be performed by the arithmetic unit 45a of the present invention. Furthermore, here, the search processing unit 61 acquires the reality information regarding the posture of the nozzle 33B as the target component based on the result of the search processing.

### <<Step S12>>

In the third step S12, the abnormality detection unit 63 detects the abnormality of the nozzle 33B as the target component according to the reality information acquired in the third step S11. Here, the abnormality detection unit 63 compares the reality information with the normal information for the nozzle 33B that is the target component. The abnormality detection unit 63 detects an abnormality in a case where the reality information does not match the normal information as a result of comparison between the reality information and the normal information for the nozzle 33B that is the target component.

### <<Step S13>>

In the third step S13, the control unit 45 determines whether or not an abnormality has been detected for the nozzle 33B as the target component in the third step S12. Here, if no abnormality has been detected for the nozzle 33B as the target component in the third step S12, the processing proceeds from step S13 to step S14. On the other hand, if an abnormality has been detected for the nozzle 33B as the target component in the third step S12, the processing proceeds from step S13 to step S17.

### <<Step S14>>

In step S14, the control unit 45 determines whether or not the processing on the substrate W has been completed. Here, if the processing on the substrate W has been completed, the processing proceeds from step S14 to step S15. On the other hand, if the processing on the substrate W has not been completed, the processing returns from step S14 to step S7. For example, if the substrate W is clamped by the plurality of chucks 9, the guard 23 moves to the processing position, and the nozzle 33B only moves to the discharge position, the processing on the substrate W is not completed, and the processing returns from step S14 to step S7.

### <<Step S7, S8, S14>>

Hereinafter, it is assumed that the confirmation required timing for the target component is not reached. Thus, the processing in step S7, the processing in step S8, and the processing in step S14 are repeated. In this event, in step S7, the operation control unit 51 controls the operation of each unit according to the recipe instructed to be executed to advance the processing on the substrate W. Specifically, for example, the rotation of the spin chuck 3 by being driven by the motor 7 according to the recipe, the supply of the processing liquid from the nozzle 33B onto the substrate W, and the like, are sequentially performed, so that the processing on the substrate W by the operation of each unit according to the recipe instructed to be executed is completed. Then, at the time point at which the processing on the substrate W has been completed, the processing proceeds from step S14 to step S15.

### <<Step S15>>

In step S15, the operation control unit 51 controls the operation of the chuck driving mechanism 17, the guard moving mechanism 25, and the nozzle moving mechanism 35 to move each chuck 9 to the open position and to move each of the guard 23 and the nozzle 33 to the origin position. Then, the substrate W placed on the plurality of chucks 9 is carried out of the substrate processing apparatus 1. The substrate W is carried out to the outside of the substrate processing apparatus 1 by, for example, a transportation robot (not illustrated), or the like.

### <<Step S16>>

In step S16, the operation control unit 51 determines whether or not there is a next substrate W to be processed according to the recipe instructed to be executed. Here, if there is a next substrate W, the processing proceeds from step S16 to step S6. Thus, in a case where no abnormality has been detected in step S12, the processing from step S6 to step S16 is repeatedly performed as long as there is a next substrate W to be processed. Then, in step S16, if there is no next substrate W to be processed, the processing in the substrate processing apparatus 1 illustrated in FIG. 36 is ended.

### <<Step S17>>

In a case where an abnormality is detected in the target component in step S12, or the like, the processing in step S17 is performed.

In step S17, the abnormality detection unit 63 causes the notification unit 49 to perform notification operation. As a result, the abnormality detection unit 63 causes the notification unit 49 to perform the notification operation in response to detection of the abnormality with respect to the target component. Here, for example, the notification unit 49 may make a notification of not only occurrence of the abnormality but also one or more pieces of information among information for specifying the target component in which the abnormality has been detected, position information of the target component in which the abnormality has been detected, and information indicating the content of the detected abnormality.

### <<Step S18>>

In step S18, for example, the operator stops operation of the substrate processing apparatus 1 in response to the notification by the notification unit 49. As a result, in the substrate processing apparatus 1, it is possible to avoid a problem that processing is sequentially performed on the plurality of substrates W in a state where an abnormality exists. As a result, occurrence of defective processing on the substrate W can be avoided.

Note that, in the substrate processing apparatus 1, for example, information processing such as image processing is performed in the processing in steps S3, S10 including the real image acquisition step and the processing in steps S4, S11 corresponding to the search step. Thus, in the first embodiment, it can be said that the information processing method in the substrate processing apparatus 1 that processes the substrates W includes the real image acquisition step and the search step. Each of steps S4, S11 corresponding to the search step includes step Sb12 corresponding to the first shape information acquisition step, step Sb13 corresponding to the first calculation step, step Sb14 corresponding to the first detection step, step Sb22 corresponding to the divided surface generation step, step Sb23 corresponding to the second shape information generation step, and step Sb24 corresponding to the second calculation step.

### <5. Conclusion>

As described above, in the substrate processing apparatus 1 according to the first embodiment, for example, the virtual camera position having the highest matching degree between the reference shape information and the real shape information is searched for among the plurality of virtual camera positions, based on the reference shape information related to the two-dimensional shape of the 3D model 3dm of the target component in each of the plurality of virtual images that can be acquired by imaging the 3D model 3dm of the target component from the plurality of virtual camera positions and the real shape information related to the two-dimensional shape of the object captured in the real image, the reference shape information being generated based on the three-dimensional design information related to the target component. When the virtual camera position is searched for, the reference shape information related to the two-dimensional shape of the 3D model 3dm of the target component generated for each of the plurality of first virtual camera positions P11 is acquired assuming a case where the 3D model 3dm of the target component is imaged from each of the plurality of first virtual camera positions P11 virtually set for the plurality of virtual surfaces St1, respectively, along the virtual spherical surface surrounding the 3D model 3dm of the target component centered around the reference point Po of the 3D model 3dm of the target component based on the three-dimensional design information related to the target component. Next, for each of the plurality of first virtual camera positions P11, a numerical value indicating a matching degree between the real shape information related to the two-dimensional shape of the object in the real image capturing the target component and the reference shape information is calculated. Next, the virtual camera position with high matching degree P11m, which is the first virtual camera position P11 having the highest matching degree between the real shape information and the reference shape information among the plurality of first virtual camera positions P11, is detected. Next, the virtual surface with high matching degree St1m, which is a virtual surface in which the virtual camera position with high matching degree P11m is virtually set among the plurality of virtual surfaces St1, is divided to generate a plurality of virtual divided surfaces St2. Next, the reference shape information related to the two-dimensional shape of the 3D model 3dm of the target component is generated for each of the plurality of second virtual camera positions P12 assuming a case where the 3D model 3dm of the target component is imaged from each of the plurality of second virtual camera positions P12 virtually set for the plurality of virtual divided surfaces St2, respectively, based on the three-dimensional design information related to the target component. Then, for each of the plurality of second virtual camera positions P12, a numerical value indicating a matching degree between the real shape information related to the two-dimensional shape of the object in the real image capturing the target component and the reference shape information is calculated. Here, the virtual surface with high matching degree St1m is not irrelevant to the plurality of virtual divided surfaces St2, and thus, increase in at least one of the number or the area of the plurality of virtual divided surfaces St2 can be reduced. As a result, an amount of calculation for recognizing the posture of the target component captured in the real image can be reduced. As a result, the substrate processing apparatus 1 can efficiently recognize the posture of the target component.

### <6. Modification>

The present invention is not limited to the above-described first embodiment, and various modifications and improvements can be made without departing from the gist of the present invention.

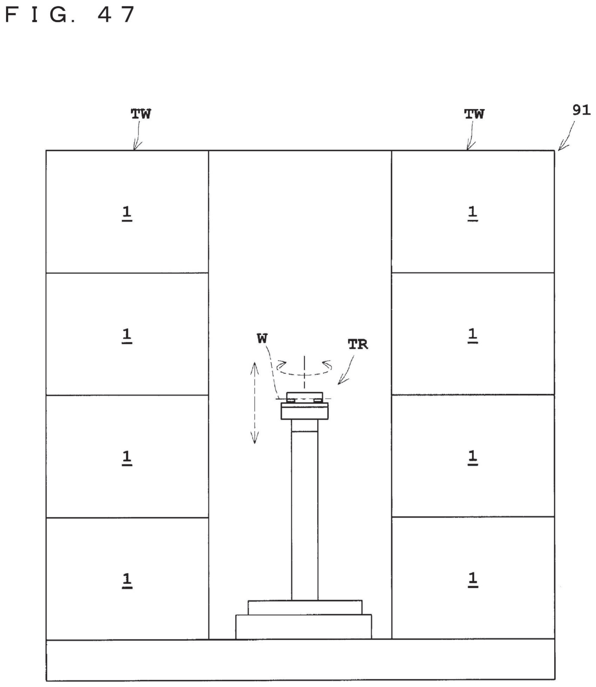

For example, in the first embodiment, a single substrate processing apparatus 1 has been described, but a substrate processing system 91 including a plurality of substrate processing apparatuses 1 may be employed. FIG. 47 is a view schematically illustrating an example of a schematic configuration of the substrate processing system 91. The substrate processing system 91 includes, for example, a plurality of stacked substrate processing apparatuses 1. The substrate processing system 91 includes, for example, a plurality of towers TW respectively formed by stacking four substrate processing apparatuses 1. In the substrate processing system 91, the plurality of towers TW is located in a state of being separated from each other and facing each other. The substrate processing system 91 includes a transportation robot TR located between the plurality of towers TW. The transportation robot TR is configured to be movable up and down in a height direction. The transportation robot TR has a configuration capable of advancing and retracting an arm (not illustrated) with respect to the substrate processing apparatus 1. The transportation robot TR can carry in and out the substrate W to and from each of the plurality of substrate processing apparatuses 1. Also in the substrate processing system 91 having the above-described configuration, the above-described effects are exhibited in each substrate processing apparatus 1.

In the first embodiment, the edge image extracted from the real image has been described as an example of the real shape information related to the two-dimensional shape of the object captured in the real image. Further, as an example of the reference shape information related to the two-dimensional shape of the 3D model 3dm of the target component, the reference image indicating the contour as the two-dimensional shape of the 3D model 3dm of the target component in the virtual image that can be acquired by imaging the 3D model 3dm of the target component from the virtual camera position has been described. However, the present invention is not limited thereto. The real shape information related to the two-dimensional shape of the object captured in the real image may be, for example, an image (also referred to as a real feature point image) including a plurality of feature points obtained by extracting a plurality of feature points such as a plurality of corners characterizing the two-dimensional shape of the object captured in the real image from the real image. For example, in a case where the real shape information is the above-described real feature point image, the reference shape information may be an image (also referred to as a reference feature point image) that specifies positions of a plurality of feature points such as a plurality of corners characterizing the two-dimensional shape of the 3D model 3dm of the target component in the virtual image that can be acquired by imaging the 3D model 3dm of the target component from the virtual camera position. Here, for example, in a case where the real shape information is a real feature point image and the reference shape information is a reference feature point image, the matching score as a numerical value indicating a matching degree (similarity) between the real feature point image as the real shape information and the reference feature point image as the reference shape information may be, for example, the number of matching feature points in a case where the number of matching feature points is the largest when the reference feature point image is scanned in the rotated real feature point image.

Further, in the first embodiment, if each virtual surface St1 is a triangle, the virtual surface with high matching degree St1m is divided into the three virtual divided surfaces St2 by the three line segments connecting each of the three vertices and the virtual camera position with high matching degree P11m, but the present invention is not limited thereto. The virtual surface with high matching degree St1m may be divided into a plurality of virtual divided surfaces St2 by other rules, for example. For example, the virtual surface with high matching degree St1m may be divided into four virtual divided surfaces St2 by three line segments respectively connecting midpoints of respective sides. Here, the midpoint of each side may be, for example, a point slightly shifted from the midpoint of each side.

Further, in the first embodiment, if each virtual surface St1 is a triangle, each of the T2 virtual surfaces St1 is divided into the three virtual divided surfaces St2 by the three line segments connecting each of the three vertices and the first virtual camera position P11 as the center point of the triangle, similarly to the virtual surface with high matching degree St1m, but the present invention is not limited thereto. For example, in a case where the virtual surface with high matching degree St1m is divided into a plurality of virtual divided surfaces St2 according to other rules, each of the T2 virtual surfaces St1 may be divided into a plurality of virtual divided surfaces St2 according to other rules, similarly to the virtual surface with high matching degree St1m.

Further, in the first embodiment, in the first A processing, if each of the first T3 virtual divided surfaces is a triangle, each of the first T3 virtual divided surfaces is divided into the three virtual divided surfaces which are the M3 virtual divided surfaces by the three line segments connecting each of the three vertices and the center point of the triangle, but the present invention is not limited thereto. Each of the first T3 virtual divided surfaces may be divided into a plurality of M3 virtual divided surfaces according to another rule, for example. For example, each of the first T3 virtual divided surfaces may be divided into four virtual divided surfaces which are M3 virtual divided surfaces by three line segments respectively connecting midpoints of respective sides. As a result, the first M3×T3 virtual divided surfaces as the M3×T3 virtual divided surfaces may be generated. Here, the midpoint of each side may be, for example, a point slightly shifted from the midpoint of each side.

Further, in the first embodiment described above, if each of the n-th T3 virtual divided surfaces is a triangle in the n-th A processing, each of the n-th T3 virtual divided surfaces is divided into three virtual divided surfaces that are the n-th M3 virtual divided surfaces by three line segments connecting each of three vertices and the center point of the triangle, but the present invention is not limited thereto. Each of the n-th T3 virtual divided surfaces may be divided into a plurality of M3 virtual divided surfaces according to another rule, for example. For example, each of the n-th T3 virtual divided surfaces may be divided into four virtual divided surfaces which are the n-th M3 virtual divided surfaces by three line segments respectively connecting midpoints of respective sides. As a result, the n-th M3×T3 virtual divided surfaces as the M3×T3 virtual divided surfaces may be generated. Here, the midpoint of each side may be, for example, a point slightly shifted from the midpoint of each side.

Further, in the first embodiment described above, each of the plurality of virtual surfaces St1 constituting the surface aggregation As1 may be, for example, a curved surface. In this case, for example, the surface aggregation As1 may be a spherical body. If the surface aggregation As1 is a spherical body, the plurality of virtual surfaces St1 may be curved surfaces constituting part of the spherical surface. In this case, the plurality of virtual surfaces St1 may be, for example, a plurality of virtual surfaces generated by dividing the spherical surface for each first predetermined angle in a latitude direction and for each second predetermined angle in a longitude direction. For example, an angle of about 10 degrees to 20 degrees may be adopted as the first predetermined angle and the second predetermined angle. Then, the virtual surface with high matching degree St1m may be divided into a plurality of virtual divided surfaces St2, for example, by being divided into two in each of the longitude direction and the latitude direction. Furthermore, the rule for dividing the virtual divided surface may be defined by an angle in each of the longitude direction and the latitude direction.

Further, in the first embodiment described above, the search processing unit 61 does not have to perform the n-th unit processing. In this case, the search processing unit 61 may detect, as the virtual camera position with the highest matching degree, a virtual camera position having the highest matching degree between the real shape information and the reference shape information detected by the second detection unit 6125 in the first D processing in the first unit processing. In other words, the virtual camera position having the highest matching degree between the real shape information and the reference shape information detected by the second detection unit 6125 in the first D processing in the first unit processing may be the virtual camera position with the highest matching degree. Then, for example, the search processing unit 61 may acquire, as a result of the search processing, the latitude α, the longitude β, and the distance D that define the virtual camera position with the highest matching degree, and the roll angle γ corresponding to the deviation amount (deviation amount γ1, deviation amount γ2, or deviation amount γ21) calculated by the first calculation unit 6113 or the second calculation unit 6124 for the virtual camera position with the highest matching degree.

Further, in the first embodiment described above, the first shape information acquisition unit 6112 acquires the reference shape information by generating the reference shape information for each of the plurality of first virtual camera positions P11 based on the three-dimensional design information regarding the target component stored in the storage unit 45b, but the present invention is not limited thereto. For example, the first shape information acquisition unit 6112 may acquire the reference shape information by reading the reference shape information for each of the plurality of first virtual camera positions P11 generated in advance and stored in the storage unit 45b, or the like.

Further, in the embodiment described above, for example, the first search processing unit 611 includes the congestion degree determination unit 6111, but the present invention is not limited thereto. For example, the first search processing unit 611 does not have to include the congestion degree determination unit 6111. In this case, for example, in the first calculation unit 6113 and the second calculation unit 6124, the entire edge image as the real shape information may be a calculation target for calculating the numerical value indicating the matching degree.

Further, in the embodiment described above, for example, the second search processing unit 612 includes the collation target region setting unit 6121, but the present invention is not limited thereto. For example, the second search processing unit 612 does not have to include the collation target region setting unit 6121. In this case, for example, the comparison target region Re1 detected in the processing 1a may be set as the collation target region Re2.

Further, in the first embodiment, the divided surface generation unit 6122 divides each of T2 (T2 is a natural number equal to or greater than 2) virtual surfaces St1 including the virtual surface with high matching degree St1m and intersecting the line Ln11 passing through the reference point Po and the virtual camera position with high matching degree P11m on a side of the virtual camera position with high matching degree P11m with respect to the reference point Po of the 3D model 3dm of the target component and having mutually different distances from the reference point Po among the M1 virtual surfaces St1 in each of the T1 surface aggregations As1, but is not limited thereto. For example, the divided surface generation unit 6122 may generate a plurality of virtual surfaces (virtual divided surfaces) St2 after division by dividing a virtual surface (virtual surface with high matching degree) St1m in which the virtual camera position with high matching degree P11m detected by the first detection unit 6114 is virtually set, among a plurality of virtual surfaces St1 constituting only one surface aggregation As1 of the T1 surface aggregations As1 and located along a virtual spherical surface surrounding the 3D model 3dm of the target component centered around the reference point Po of the 3D model 3dm of the target component. Even if such a configuration is adopted, the virtual surface with high matching degree St1m is not irrelevant to the plurality of virtual divided surfaces St2, and increase in at least one of the number or the area can be reduced for the plurality of virtual divided surfaces St2. As a result, an amount of calculation for recognizing the posture of the target component captured in the real image can be reduced. As a result, the substrate processing apparatus 1 can efficiently recognize the posture of the target component.

Further, in the first embodiment described above, the normal information on the target component does not have to include information regarding the posture of the target component in a case where the normal information is within the allowable range. In other words, the normal information on the target component may be set based on one piece of three-dimensional design information indicating that the target component is normal.

Further, in the first embodiment described above, the chuck 9, the guard 23, and the nozzle 33 have been described as examples of the target component. However, the present invention is not limited to such a configuration. For example, as in the first embodiment described above, a plurality of components may be set as the target components, but a single component may be set as the target component. In other words, the target component that is a component to be subjected to the search processing may be one or more components of the chuck 9, the guard 23, and the nozzle 33, or may be another one or more components that perform various kinds of movement such as rotational movement or parallel movement among the components constituting the substrate processing apparatus 1.

Further, in the first embodiment described above, the search processing is performed only once at one confirmation required timing other than the timing at which each target component is located at the origin position. However, the present invention is not limited thereto. For example, the nozzle 33 may be set such that the search processing is performed at a plurality of confirmation required timings between the timing at which the nozzle 33 is located at the origin position and the timing at which the nozzle 33 is set to be located at the discharge position. As a result, in a case where an abnormality is detected at a plurality of confirmation required timings set such that the nozzle 33 is located between the origin position and the discharge position, for example, an abnormality related to a moving speed of the nozzle 33 by the nozzle moving mechanism 35 can be detected. Furthermore, for the guard 23, a plurality of timings set such that the guard 23 is located between the origin position and the processing position may be set as the plurality of confirmation required timings. In this case, for example, an abnormality related to a moving speed of the guard 23 by the guard moving mechanism 25 can also be detected. Further, in the first embodiment described above, the search processing and the abnormality detection are performed at the confirmation required timing. However, setting of the confirmation required timing does not have to be essential. For example, a command to operate the target component such as a chuck operation command may be issued, and the search processing and the abnormality detection may be performed at each timing when the target component has moved.

Further, in the first embodiment described above, the search processing at the timing when the target component is located at the origin position does not necessarily have to be performed for each target component. In this case, for example, the normal information related to the target component does not have to be set based on the result of the search processing at the origin position, and may be set based on the three-dimensional design information in a case where the state of the target component is normal.

Further, in the first embodiment described above, the virtual camera position is defined by the latitude α, the longitude β, and the distance D, but the present invention is not limited thereto. For example, the virtual camera position may be defined by a plurality of parameters according to other rules, such as a spherical coordinate system.

Further, in the first embodiment, the substrate processing apparatus 1 includes one camera CM, but the present invention is not limited thereto. For example, the substrate processing apparatus 1 may include two or more cameras CM. For example, the substrate processing apparatus 1 may include a dedicated camera CM for each target component.

Further, in the first embodiment described above, some or all of the functional processing units implemented by the control unit 45 (more specifically, the arithmetic unit 45a) may be constituted with hardware such as a dedicated electronic circuit, for example.

Further, in the first embodiment described above, the substrate processing apparatus 1 is not limited to a substrate cleaning apparatus, and may be a substrate processing apparatus that processes the substrate, such as a heat treatment apparatus, an exposure apparatus, an application and development apparatus, a measurement apparatus, or an inspection apparatus. In a case where the substrate processing apparatus 1 is a substrate cleaning apparatus, the substrate processing apparatus 1 may be a batch type substrate cleaning apparatus that collectively cleans a plurality of substrates W.

Note that it goes without saying that all or some of the components of the first embodiment and the various modifications can be combined as appropriate within a consistent range.

### EXPLANATION OF REFERENCE SIGNS

1: substrate processing apparatus
23: guard
33, 33A, 33B: nozzle
3dm: three-dimensional model (3D model)
45b: storage unit
57: design information
61: search processing unit
6112: first shape information acquisition unit
6113: first calculation unit
6114: first detection unit
6122: divided surface generation unit
6123: second shape information generation unit
6124: second calculation unit
6125: second detection unit
63: abnormality detection unit
9: chuck
As1: surface aggregation
CM: camera
Ir1 : real image
Ir3, Ir4: edge image
Iv1: reference image
Ln1, Ln11, Ln12, Ln13: line
P1: virtual camera position
P11: first virtual camera position
P11m: virtual camera position with high matching degree
P12: second virtual camera position
P13, P13a: third virtual camera position
Po: reference point
Ps1: first reference virtual camera position
Ps2: second reference virtual camera position
Ss1: first reference virtual divided surface
Ss2: second reference virtual divided surface
St1, St1a, Stlb, Stlc: virtual surface
St1m: virtual surface with high matching degree
St2, St3, St3a: virtual divided surface
Sv1, Sv2, SvT1: spherical surface
W: substrate

## Claims

1. A substrate processing apparatus that processes a substrate, the substrate processing apparatus comprising:
a storage unit that stores three-dimensional design information regarding a target component;
an imaging unit that obtains a real image capturing said target component by imaging; and
a search processing unit that, based on reference shape information regarding a two-dimensional shape of a three-dimensional model in each of a plurality of virtual images that can be obtained by imaging said three-dimensional model of said target component from a plurality of virtual camera positions, and real shape information regarding a two-dimensional shape of an object in said real image, the reference shape information being generated based on said three-dimensional design information, searches for a virtual camera position having a highest matching degree between said reference shape information and said real shape information among said plurality of virtual camera positions,
wherein said search processing unit includes:
a first shape information acquisition unit that acquires said reference shape information generated for each of a plurality of first virtual camera positions assuming a case where said three-dimensional model is imaged from each of said plurality of first virtual camera positions that is a plurality of virtual camera positions set by virtually setting a surface aggregation including a plurality of virtual surfaces located along a virtual spherical surface surrounding the three-dimensional model centered around a reference point of said three-dimensional model and virtually setting one virtual camera position for each of said plurality of virtual surfaces based on said three-dimensional design information;
a first calculation unit that calculates a numerical value indicating a matching degree between said real shape information and said reference shape information for each of said plurality of first virtual camera positions;
a first detection unit that detects a virtual camera position with high matching degree that is a first virtual camera position having a highest matching degree between said real shape information and said reference shape information among said plurality of first virtual camera positions based on a calculation result by said first calculation unit;
a divided surface generation unit that generates a plurality of virtual divided surfaces by dividing a virtual surface with high matching degree that is a virtual surface in which said virtual camera position with high matching degree is virtually set, among said plurality of virtual surfaces;
a second shape information generation unit that generates said reference shape information for each of a plurality of second virtual camera positions assuming a case where said three-dimensional model is imaged from each of said plurality of second virtual camera positions that is a plurality of virtual camera positions set by virtually setting one virtual camera position for each of said plurality of virtual divided surfaces based on said three-dimensional design information; and
a second calculation unit that calculates a numerical value indicating a matching degree between said real shape information and said reference shape information for each of said plurality of second virtual camera positions.

2. The substrate processing apparatus according to claim 1, wherein
assuming a case where said three-dimensional model is imaged from each of M1×T1 first virtual camera positions that are M1×T1 virtual camera positions set by virtually setting T1 (T1 is a natural number equal to or greater than 2) surface aggregations having mutually different distances from said reference point and virtually setting one virtual camera position for each of M1 (M1 is a natural number equal to or greater than 2) virtual surfaces in each of said T1 surface aggregations based on said three-dimensional design information, said first shape information acquisition unit acquires said reference shape information generated for each of said M1×T1 first virtual camera positions,
said first calculation unit calculates a numerical value indicating a matching degree between said real shape information and said reference shape information for each of said M1×T1 first virtual camera positions,
said first detection unit detects said virtual camera position with high matching degree which is a virtual camera position having a highest matching degree between said real shape information and said reference shape information among said M1×T1 first virtual camera positions based on a calculation result by said first calculation unit,
said divided surface generation unit divides, according to a same rule, each of T2 (T2 is a natural number equal to or greater than 2) virtual surfaces including said virtual surface with high matching degree, intersecting a line passing through said reference point and said virtual camera position with high matching degree on a side of said virtual camera position with high matching degree with respect to said reference point and having mutually different distances from said reference point among said M1 virtual surfaces in each of said T1 surface aggregations to generate M2 (M2 is a natural number equal to or greater than 2) virtual divided surfaces for each of the T2 virtual surfaces, thereby generating M2×T2 virtual divided surfaces,
said second shape information generation unit generates, assuming a case where said three-dimensional model is imaged from each of M2×T2 second virtual camera positions that are M2×T2 virtual camera positions set by virtually setting one virtual camera position for each of said M2×T2 virtual divided surfaces, said reference shape information for each of said M2×T2 second virtual camera positions based on said three-dimensional design information, and
said second calculation unit calculates a numerical value indicating a matching degree between said real shape information and said reference shape information for each of said M2×T2 second virtual camera positions.

3. The substrate processing apparatus according to claim 2, wherein said search processing unit includes a second detection unit that detects a virtual camera position having a highest matching degree between said real shape information and said reference shape information among said virtual camera position with high matching degree and said M2×T2 second virtual camera positions.

4. The substrate processing apparatus according to claim 3, wherein
said search processing unit executes one or more times of n-th unit processing (n is a natural number equal to or greater than 2) after executing first unit processing for said target component,
said search processing unit sequentially performs first A processing, first B processing, first C processing, and first D processing in said first unit processing,
said first A processing is processing in which said divided surface generation unit divides, according to a same rule, each of first T3 virtual divided surfaces which are a plurality of virtual divided surfaces generated by dividing each of said T2 virtual surfaces and which are T3 (T3 is a natural number equal to or greater than 2) virtual divided surfaces including a virtual divided surface including a first reference virtual camera position which is a virtual camera position detected first by said second detection unit, intersecting a line passing through said reference point and said first reference virtual camera position on a side of said first reference virtual camera position with respect to said reference point and having mutually different distances from said reference point to generate first M3 virtual divided surfaces which are M3 (M3 is a natural number equal to or greater than 2) virtual divided surfaces for each of the first T3 virtual divided surfaces, thereby generating first M3×T3 virtual divided surfaces which are M3×T3 virtual divided surfaces,
said first B processing is processing in which said second shape information generation unit generates, assuming a case where said three-dimensional model is imaged from each of first M3×T3 third virtual camera positions that are M3×T3 virtual camera positions set by virtually setting one virtual camera position for each of said first M3×T3 virtual divided surfaces, said reference shape information for each of said first M3×T3 third virtual camera positions based on said three-dimensional design information,
said first C processing is processing in which said second calculation unit calculates a numerical value indicating a matching degree between said real shape information and said reference shape information for each of said first M3×T3 third virtual camera positions,
said first D processing is processing in which said second detection unit detects a second reference virtual camera position that is a virtual camera position having a highest matching degree between said real shape information and said reference shape information among said first reference virtual camera position and said first M3×T3 third virtual camera positions,
said search processing unit sequentially performs n-th A processing, n-th B processing, n-th C processing, and n-th D processing in each of said one or more times of n-th unit processing,
said n-th A processing is processing in which said divided surface generation unit divides, according to a same rule, each of n-th T3 virtual divided surfaces which are a plurality of virtual divided surfaces generated by dividing each of (n-1)-th T3 virtual divided surfaces and which are T3 virtual divided surfaces including a virtual divided surface including an n-th reference virtual camera position that is a virtual camera position detected n-th by said second detection unit, intersecting a line passing through said reference point and said n-th reference virtual camera position on a side of said n-th reference virtual camera position with respect to said reference point, and having mutually different distances from said reference point to generate n-th M3 virtual divided surfaces that are M3 virtual divided surfaces for each of the n-th T3 virtual divided surfaces, thereby generating n-th M3×T3 virtual divided surfaces that are M3×T3 virtual divided surfaces,
said n-th B processing is processing in which said second shape information generation unit generates, assuming a case where said three-dimensional model is imaged from each of n-th M3×T3 third virtual camera positions that are M3×T3 virtual camera positions set by virtually setting one virtual camera position for each of said n-th M3×T3 virtual divided surfaces, said reference shape information for each of said n-th M3×T3 third virtual camera positions based on said three-dimensional design information,
said n-th C processing is processing in which said second calculation unit calculates a numerical value indicating a matching degree between said real shape information and said reference shape information for each of said n-th M3×T3 third virtual camera positions, and
said n-th D processing is processing in which said second detection unit detects a virtual camera position having a highest matching degree between said real shape information and said reference shape information among said n-th reference virtual camera position and said n-th M3×T3 third virtual camera positions.

5. The substrate processing apparatus according to claim 4, wherein said search processing unit ends execution of said one or more times of n-th unit processing in response to one reference virtual camera position among from said first reference virtual camera position to said n-th reference virtual camera position being continuously detected by said second detection unit as a virtual camera position having a highest matching degree between said real shape information and said reference shape information a first predetermined number of times set in advance.

6. The substrate processing apparatus according to claim 4, wherein said search processing unit ends execution of said one or more times of n-th unit processing in response to the n-th unit processing in said one or more times of n-th unit processing being executed a second predetermined number of times set in advance.

7. The substrate processing apparatus according to any one of claims 4 to 6, further comprising an abnormality detection unit that detects an abnormality of said target component by comparing reality information related to a posture of said target component recognized based on a virtual camera position having a highest matching degree between said real shape information and said reference shape information detected (n+1)-th by said second detection unit in the last n-th D processing in said one or more times of n-th unit processing, with normal information related to a posture of said target component based on said three-dimensional design information in a case where a state of said target component is normal.

8. The substrate processing apparatus according to any one of claims 2 to 6, wherein said same rule includes a rule of dividing a division target surface to be divided into a plurality of surfaces by a plurality of line segments respectively connecting a center point of the division target surface and all vertices of the division target surface.

9. The substrate processing apparatus according to any one of claims 1 to 6, wherein
each of said plurality of virtual surfaces is a triangular surface, and
said surface aggregation is a polyhedron constituted with a large number of triangular surfaces.

10. The substrate processing apparatus according to claim 9, wherein said divided surface generation unit divides said virtual surface with high matching degree into three virtual divided surfaces as said plurality of virtual divided surfaces by three line segments connecting each of three vertices of said virtual surface with high matching degree and said virtual camera position with high matching degree.

11. An information processing method in a substrate processing apparatus that processes a substrate, the information processing method comprising:
a real image acquisition step of acquiring, by an arithmetic unit, a real image capturing a target component obtained by imaging by an imaging unit; and
a search step of searching for, by the arithmetic unit, based on reference shape information regarding a two-dimensional shape of a three-dimensional model in each of a plurality of virtual images that can be acquired by imaging a three-dimensional model of said target component from a plurality of virtual camera positions, and real shape information regarding a two-dimensional shape of an object in said real image, the reference shape information being generated based on three-dimensional design information regarding said target component stored in a storage unit, a virtual camera position having a highest matching degree between said reference shape information and said real shape information among said plurality of virtual camera positions,
wherein said search step includes:
a first shape information acquisition step of acquiring, assuming a case where said three-dimensional model is imaged from each of a plurality of first virtual camera positions that is a plurality of virtual camera positions set by virtually setting a surface aggregation including a plurality of virtual surfaces located along a virtual spherical surface surrounding the three-dimensional model centered around a reference point of said three-dimensional model and virtually setting one virtual camera position for each of said plurality of virtual surfaces based on said three-dimensional design information, said reference shape information generated for each of said plurality of first virtual camera positions;
a first calculation step of calculating a numerical value indicating a matching degree between said real shape information and said reference shape information for each of said plurality of first virtual camera positions;
a first detection step of detecting a virtual camera position with high matching degree that is a first virtual camera position having a highest matching degree between said real shape information and said reference shape information among said plurality of first virtual camera positions based on a calculation result in said first calculation step;
a divided surface generation step of generating a plurality of virtual divided surfaces by dividing a virtual surface with high matching degree that is a virtual surface in which said virtual camera position with high matching degree is virtually set, among said plurality of virtual surfaces;
a second shape information generation step of generating said reference shape information for each of a plurality of second virtual camera positions, assuming a case where said three-dimensional model is imaged from each of said plurality of second virtual camera positions that is a plurality of virtual camera positions set by virtually setting one virtual camera position for each of said plurality of virtual divided surfaces based on said three-dimensional design information; and
a second calculation step of calculating a numerical value indicating a matching degree between said real shape information and said reference shape information for each of said plurality of second virtual camera positions.
